(19) Europäisches Patentamt
European Patent Office
Office européen des brevets

(11) EP 2 078 984 A1

(12) EUROPEAN PATENT APPLICATION

(43) Date of publication:
**15.07.2009 Bulletin 2009/29**

(51) Int Cl.:
***G03F 7/11*** *(2006.01)* ***B41C 1/10*** *(2006.01)*

(21) Application number: **09000224.7**

(22) Date of filing: **09.01.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **11.01.2008 JP 2008004767**

(71) Applicant: **Fujifilm Corporation**
**Tokyo 106-0031 (JP)**

(72) Inventors:
- **Oohashi, Hidekazu**
  **Shizouka (JP)**
- **Sasaki, Tomoya**
  **Shizouka (JP)**

(74) Representative: **HOFFMANN EITLE**
**Patent- und Rechtsanwälte**
**Arabellastraße 4**
**81925 München (DE)**

(54) **Lithographic printing plate precursor, method of preparing lithographic printing plate and lithographic printing method**

(57) A lithographic printing plate precursor includes, in the folloiwng order: a support; an undercoat layer; and an image-forming layer, the undercoat layer contains a polymer compound having a support-adsorbing group and an acid group, and at least a part of the acid groups is neutralized with a radical polymerizable compound having at least one member selected from the group consisting of a secondary amino group, a tertiary amino group and a hetero ring having a basic nitrogen atom.

EP 2 078 984 A1

**Description**

FIELD OF THE INVENTION

The present invention relates to a lithographic printing plate precursor, a method of preparing a lithographic printing plate and a lithographic printing method.

BACKGROUND OF THE INVENTION

In general, a lithographic printing plate has a surface composed of an oleophilic image area and a hydrophilic non-image area. Lithographic printing is a printing method comprising supplying alternately dampening water and oily ink on the surface of lithographic printing plate, making the hydrophilic non-image area a dampening water-receptive area (ink unreceptive area) and depositing the oily ink only to the oleophilic image area by utilizing the nature of the dampening water and oily ink to repel with each other, and then transferring the ink to a printing material, for example, paper.

In order to produce the lithographic printing plate, a lithographic printing plate precursor (PS plate) comprising a hydrophilic support having provided thereon an oleophilic photosensitive layer (also referred to as an image-recording layer or an image-forming layer) has heretofore been broadly used. Ordinarily, a lithographic printing plate is obtained by conducting plate making by a method of exposing the lithographic printing plate precursor through an original, for example, a lith film, and then removing the image-recording layer in the unnecessary non-image area by dissolving it with a an alkaline developer or an organic solvent thereby revealing a hydrophilic surface of the support to form the non-image area while leaving the image-recording layer to form the image area.

In the hitherto known plate making process of lithographic printing plate precursor, after the exposure, the step of removing the unnecessary image-recording layer by dissolving, for example, with a developer is required. However, it is one of the subjects to simplify such an additional wet treatment described above. As one means for the simplification, it has been desired to conduct the development with a nearly neutral aqueous solution or simply with water.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate technique of carrying the digitalized image information on highly converging radiation, for example, laser light and conducting scanning exposure of a lithographic printing plate precursor with the laser light thereby directly preparing a lithographic printing plate without using a lith film. Thus, it is one of the important technical subjects to obtain a lithographic printing plate precursor adaptable to the technique described above.

Based on the background described above, adaptation of plate making operation to both simplification and digitalization has been demanded strongly more and more than ever before.

In response to such a demand, for instance, it is described in JP-A-2002-365789 (the term "JP-A" as used herein means an "unexamined published Japanese patent application") that by incorporating a compound having an ethylene oxide chain into an image-forming layer of a lithographic printing plate precursor comprising a hydrophilic support and the image-forming layer containing a hydrophobic precursor, a hydrophilic resin and a light-to-heat converting agent, the lithographic printing plate precursor enables printing after conducting exposure and wet development processing using as a developer, water or an appropriate aqueous solution, besides conducting on-press development.

Also, a processing method of lithographic printing plate precursor is described in U. S. Patent Publication No. 2004/0013968 which comprises preparing a lithographic printing plate precursor comprising (i) a hydrophilic support and (ii) an oleophilic heat-sensitive layer which contains a radical-polymerizable ethylenically unsaturated monomer, a radical polymerization initiator and an infrared absorbing dye, is hardenable with infrared laser exposure and is developable with an aqueous developer containing 60% by weight or more of water and having pH of 2.0 to 10.0, exposing imagewise the lithographic printing plate precursor with an infrared laser, and removing the unhardened region of the heat-sensitive layer with the aqueous developer.

Also, it is described in JP-A-2006-78999 that a lithographic printing plate precursor which has high sensitivity and good printing durability and is excellent in stain resistance in the non-image area is obtained by incorporating a binder having an ethylenically unsaturated bond and a functional group capable of interacting with a surface of support into an image-recording layer containing a polymerization initiator, a polymerizable compound and a binder which is soluble or swellable in water or an aqueous alkali solution or other layer, under conditions using an alkali developer. Further, in JP-A-2006-39468, a method for preparation of a lithographic printing plate is described which comprises imagewise exposure of a lithographic printing plate precursor having an image-recording layer on a support, and a development step wherein the image-recording layer of the exposed lithographic printing plate precursor is rubbed with a rubbing member in the presence of a developer having pH of 2 to 10 in a development processing part equipped with the rubbing member to remove the unexposed area of the image-recording layer. Moreover, in WO 2005/111727, a

method for preparation of a printing plate is described which comprises steps of providing a photopolymerizable layer on a hydrophilic support, exposing the photopolymerizable layer and then removing the unexposed area of the photopolymerizable layer with a gum solution.

## SUMMARY OF THE INVENTION

In order to maintain the developing property in an aqueous developer having pH of 2 to 10, however, although it is necessary for the photosensitive layer to be hydrophilic or highly water-permeable, the photosensitive layer cured with the imagewise exposure is insufficient in the water-resistance and film strength and has a low adhesion property to a support and consequently, printing durability is still insufficient. When the hydrophilicity of the unexposed photosensitive layer is lowered or the adhesion property to a support is increases in order to improve the printing durability, problems occur in that the developing property decreases or stain resistance in the non-image area is degraded. The present invention is intended to solve these problems.

Specifically, an object of the invention is to provide a lithographic printing plate precursor which is especially developable with an aqueous developer having pH of 2 to 10, is excellent in preservation stability, is prevented from the occurrence of stain in the non-image area and provides a lithographic printing plate excellent in printing durability, a method of preparing a lithographic printing plate using the lithographic printing plate precursor, and a lithographic printing method using the lithographic printing plate precursor.

The inventors have found that the above-described objects can be achieved by providing a layer containing a specific polymer compound (copolymer) on a support. Specifically, the invention includes the following items.

(1) A lithographic printing plate precursor comprising: a support; an undercoat layer; and an image-forming layer in this order, wherein the undercoat layer contains a polymer compound having (A1) a support-adsorbing group and (A2) an acid group, and at least a part of the acid groups is neutralized with a radical polymerizable compound having at least one member selected from the group consisting of a secondary amino group, a tertiary amino group and a heterocyclic group having a basic nitrogen atom.

(2) The lithographic printing plate precursor as described in (1) above, wherein the acid group is a group selected from a sulfonic acid group, a carboxylic acid group, a phosphoric acid group, a phosphonic acid group and a sulfuric acid group.

(3) The lithographic printing plate precursor as described in (1) above, wherein the support-adsorbing group is a group selected from a phosphoric acid group, a phosphate group, a phosphonic acid group, a phosphonate group, an ammonium group, a siloxane group, a β-dicarbonyl group, a carboxylic acid group and a carboxylate group.

(4) The lithographic printing plate precursor as described in any one of (1) to (3) above, wherein the radical polymerizable compound is a compound having at least one functional group selected from radical polymerizable functional groups represented by the following formulae (1) to (3):

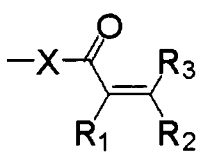 (1) 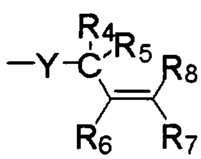 (2) 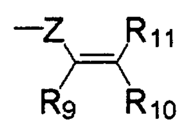 (3)

In formulae (1) to (3), $R_1$ to $R_{11}$ each independently represents a hydrogen atom, a halogen atom, an alkyl group, an aryl group, an alkynyl group, an alkenyl group, a cyano group, a nitro group, $-OR_{12}$, $-OCOR_{12}$, $-OCOOR_{12}$, $-OCONR_{12}R_{13}$, $-OSO_2R_{12}$, $-OSO_3R_{12}$, $-OSO_2NR_{12}R_{13}$, $-OPO(OR_{12})(OR_{13})$, $-OPO(OR_{12})(R_{13})$, $-OSiR_{12}R_{13}R_{14}$, $-SR_{12}$, $-SOR_{12}$, $-SO_2R_{12}$, $-SO_3R_{12}$, $-SO_2NR_{12}R_{13}$, $-NR_{12}R_{13}$, $-NR_{12}COR_{13}$, $-NR_{12}COOR_{13}$, $-NR_{12}CONR_{13}R_{14}$, $-N(COR_{12})COR_{13}$, $-NR_{12}SO_2R_{13}$, $-N(SO_2R_{12})(SO_2R_{13})$, $-COR_{12}$, $-COOR_{12}$, $-CONR_{12}R_{13}$ or $-PO(OR_{12})(OR_{13})$, X represents an oxygen atom, a sulfur atom or an $-N(R_{12})$- group, Y represents an oxygen atom, a sulfur atom or an $N(R_{12})$- group, Z represents an oxygen atom, a sulfur atom, an $-N(R_{12})$- group or a phenylene group, and $R_{12}$ to $R_{14}$ each independently represents a hydrogen atom, an alkyl group, an aryl group, an alkynyl group or an alkyeyl group.

(5) The lithographic printing plate precursor as described in any one of (1) to (4) above, wherein the image-forming layer contains a radical polymerizable compound, a binder, a sensitizing dye and a radical polymerization initiator.

(6) The lithographic printing plate precursor as described in (5) above, wherein the sensitizing dye is a compound which absorbs light of 350 to 1,200 nm.

(7) The lithographic printing plate precursor as described in (5) above, wherein the binder is a binder having a hydrophilic functional group.

(8) The lithographic printing plate precursor as described in (7) above, wherein the hydrophilic functional group is selected from an alkylene oxide group, a carboxylate group, a sulfonic acid group, a sulfonate group, an amino group, an ammonium group, a hydroxy group, a sulfuric acid group, a sulfate group, an amido group and a sulfonamido group.
(9) A method of preparing a lithographic printing plate comprising exposing imagewise the lithographic printing plate precursor as described in any one of (1) to (8) above and developing the exposed lithographic printing plate precursor with an aqueous solution having pH of 2 to 10 to remove an unexposed area of the image-forming layer, thereby forming a non-image area.
(10) The method of preparing a lithographic printing plate as described in (9) above, wherein the exposed lithographic printing plate precursor is subjected to heat treatment between the imagewise exposure and the development.
(11) A lithographic printing method comprising exposing imagewise the lithographic printing plate precursor as described in any one of (1) to (8) above, mounting the exposed lithographic printing plate precursor on a printing machine without undergoing any treatment, and performing printing using printing ink and dampening water (fountain solution).

According to the present invention, a lithographic printing plate precursor which is especially developable with an aqueous developer having pH of 2 to 10, is prevented from the occurrence of stain in the non-image area, is excellent in preservation stability, and provides a lithographic printing plate excellent in printing durability, a method of preparing a lithographic printing plate using the lithographic printing plate precursor, and a lithographic printing method using the lithographic printing plate precursor can be provided.

## BRIEF DESCRIPTION OF THE DRAWINGS

Fig. 1 is an illustration for showing a structure of an automatic development processor.

[Description of reference numerals and signs]

1: Rotating brush roller
2: Backing roller
3: Transport roller
4: Transport guide plate
5: Spray pipe
6: Pipe line
7: Filter
8: Plate supply table
9: Plate discharge table
10: Developer tank
11: Circulating pump
12: Plate

## DETAILED DESCRIPTION OF THE INVENTION

In the specification, with respect to the description of a group in a compound represented by a formula, when the group is not indicated whether substituted or unsubstituted, unless otherwise indicated specifically, the group includes not only the unsubstituted group but also the substituted group, if the group is able to have a substituent. For example, the description "R represents an alkyl group, an aryl group or a heterocyclic group" in a formula means that "R represents an unsubstituted alkyl group, a substituted alkyl group, an unsubstituted aryl group, a substituted aryl group, an unsubstituted heterocyclic group or a substituted heterocyclic group".

[Lithographic printing plate precursor]

The lithographic printing plate precursor according to the invention comprises a support, an undercoat layer and an image-forming layer in this order, the undercoat layer contains a polymer compound (hereinafter also referred to as a "neutralized polymer compound") having (A1) a support-adsorbing group and (A2) an acid group, and at least

a part of the acid groups is neutralized with a radical polymerizable compound (hereinafter also referred to as a "basic radical polymerizable compound") having at least one member selected from the group consisting of a secondary amino group, a tertiary amino group and a heterocyclic group having a basic nitrogen atom. The constituting components described in detail below.

[Undercoat layer]

The neutralized polymer compound for use in the undercoat layer of the lithographic printing plate precursor according to the invention is characterized in that it has (A1) a support-adsorbing group and (A2) an acid group, and at least a part of the acid groups is neutralized with the basic radical polymerizable compound.

[(A1) Support-adsorbing group]

The support-adsorbing group for use in the invention may be variously selected depending on the support used. For instance, in the case of an aluminum support which is conventionally used in a lithographic printing plate precursor, a functional group, for example, a phosphoric acid group or its salt group, a phosphonic acid group or its salt group, an ammonium group, a siloxane group, a β-dicarbonyl group or a carboxylic acid group or its salt group is exemplified, although the functional group may be varied depending on the surface treatment of the support. The functional group preferably includes a phosphate group, a phosphonate group, an ammonium group, a siloxane group, a β-dicarbonyl group and a carboxylate group. The functional groups may be used in combination of two or more thereof.
The amount of the support-adsorbing group introduced into the neutralized polymer compound for use in the invention is preferably from 0.01 to 10 mmol/g, more preferably from 0.05 to 5 mmol/g, particularly preferably from 0.1 to 3 mmol/g.

[(A2) Acid group]

As the acid group for use in the invention, any functional group ordinarily known as an acidic functional group may be suitably used and an acidic functional group having pKa of 5 or less is preferably used. The acidic functional group includes preferably a sulfonic acid group, a carboxylic acid group, a phosphoric acid group, a phosphonic acid group and a sulfuric acid group, more preferably a sulfonic acid group, a phosphoric acid group, a phosphonic acid group and a sulfuric acid group, and particularly preferably a sulfonic acid group. The functional groups may be used in combination of two or more thereof.
The amount of the acid group (including the acid group neutralized with the basic radical polymerizable compound) introduced into the neutralized polymer compound for use in the invention is preferably from 0.01 to 10 mmol/g, more preferably from 0.05 to 5 mmol/g, particularly preferably from 0.1 to 3 mmol/g.
Among the above-described groups exemplified as the support-adsorbing group and the acid group for the neutralized polymer compound used in the invention, a carboxylic acid group, a phosphoric acid group and a phosphonic acid group each are a functional group having both functions. Therefore, in case one kind of functional group selected from a carboxylic acid group, a phosphoric acid group and a phosphonic acid group is used, it is possible that the one kind of functional group acts as both of the support-adsorbing group and the acid group. In the invention, the support-adsorbing group and the acid group may be same functional group or different functional groups, but, it is preferable that those are different functional groups.

[Basic radical polymerizable compound]

As the basic radical polymerizable compound for use in the invention, any compound having at least one basic functional group selected from a secondary amino group, a tertiary amino group and a heterocyclic group having a basic nitrogen atom (for example, a pyridine group, a quinoline group, an imidazole group and an adenine group) and at least one radical polymerizable functional group may be suitably used.
The basic functional group includes preferably a tertiary amino group and a heterocyclic group having a basic nitrogen atom, and particularly preferably a tertiary amino group. The basic functional groups may be used in combination of two or more thereof.
As the radical polymerizable functional group, functional groups represented by formulae (1) to (3) shown below are suitably used.

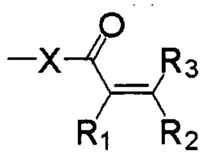 (1) 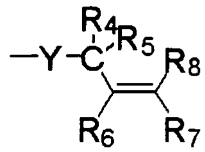 (2) 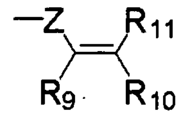 (3)

In formulae (1) to (3), $R_1$ to $R_{11}$ each independently represents a hydrogen atom, a halogen atom, an alkyl group, an aryl group, an alkynyl group, an alkenyl group, a cyano group, a nitro group, $-OR_{12}$, $-OCOR_{12}$, $-OCOOR_{12}$, $-OCONR_{12}R_{13}$, $-OSO_2R_{12}$, $-OSO_3R_{12}$, $-OSO_2NR_{12}R_{13}$, $-OPO(OR_{12})(OR_{13})$, $-OPO(OR_{12})(R_{13})$, $-OSiR_{12}R_{13}R_{14}$, $-SR_{12}$, $-SOR_{12}$, $-SO_2R_{12}$, $-SO_3R_{12}$, $-SO_2NR_{12}R_{13}$, $-NR_{12}R_{13}$, $-NR_{12}COR_{13}$, $-NR_{12}COOR_{13}$, $-NR_{12}CONR_{13}R_{14}$, $-N(COR_{12})COR_{13}$, $-NR_{12}SO_2R_{13}$, $-N(SO_2R_{12})(SO_2R_{13})$, $-COR_{12}$, $-COOR_{12}$, $-CONR_{12}R_{13}$ or $-PO(OR_{12})(OR_{13})$, X represents an oxygen atom, a sulfur atom or an $N(R_{12})$- group, Y represents an oxygen atom, a sulfur atom or an $-N(R_{12})$- group, Z represents an oxygen atom, a sulfur atom, an $-N(R_{12})$- group or a phenylene group, and $R_{12}$ to $R_{14}$ each independently represents a hydrogen atom, an alkyl group, an aryl group, an alkynyl group or an alkenyl group.

In formulae (1) to (3), the alkyl group, aryl group, alkynyl group and alkenyl group represented by any one of $R_1$ to $R_{11}$ and the phenylene group represented by Z include those having a substituent, respectively. Examples of the substituent capable of being introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

In formula (1), $R_1$ preferably represents a hydrogen atom or an alkyl group. Among them, a hydrogen atom, a methyl group or a $-CH_2Q$ group is more preferable because of high radical reactivity. Q represents a halogen atom, a cyano group, $-OR_{12}$, $-OCOR_{12}$, $-OCONR_{12}R_{13}$, $-OCOOR_{12}$, $-OSO_2R_{12}$, $-OPO(OR_{12})(OR_{13})$, $-OPOR_{12}(OR_{13})$, $-NR_{12}R_{13}$, $-NR_{12}COR_{13}$, $-NR_{12}COOR_{13}$, $-NR_{12}CONR_{13}R_{14}$, $-NR_{12}SO_2R_{13}$, $-N(SO_2R_{12})(SO_2R_{13})$, $-N(COR_{12})(COR_{13})$, $-SR_{12}$, $-SOR_{12}$, $-SO_2R_{12}$, $-SO_3R_{12}$, $-SO_2NR_{12}R_{13}$ or $-PO(OR_{12})(OR_{13})$, and is preferably a halogen atom, a cyano group, $-OR_{12}$, $-OCOR_{12}$, $-OCONR_{12}R_{13}$, $-OCOOR_{12}$, $-NR_{12}R_{13}$, $-NR_{12}COR_{13}$, $-NR_{12}COOR_{13}$, $-NR_{12}CONR_{13}R_{14}$ or $-SR_{12}$. $R_{12}$ to $R_{14}$ have the same meanings as defined above.

$R_2$ and $R_3$ each independently preferably represents a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group or an arylsulfonyl group. Among them, a hydrogen atom, a carboxyl group, an alkoxycarbonyl group, an alkyl group or an aryl group is more preferable because of high radical reactivity.

When X represents $-N(R_{12})$-, $R_{12}$ is preferably a hydrogen atom, a methyl group, an ethyl group or an isopropyl group because of high radical reactivity.

In formula (2), $R_4$ to $R_8$ each independently preferably represents a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group or an arylsulfonyl group. Among them, a hydrogen atom, a carboxyl group, an alkoxycarbonyl group, an alkyl group or an aryl group is more preferable.

When Y represents $-N(R_{12})$-, $R_{12}$ is preferably a hydrogen atom, a methyl group, an ethyl group or an isopropyl group because of high radical reactivity.

In formula (3), $R_9$ preferably represents a hydrogen atom or a methyl group because of high radical reactivity. $R_{10}$ and $R_{11}$ each independently preferably represents a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group or an arylsulfonyl group. Among them, a hydrogen atom, a carboxyl group, an alkoxycarbonyl group, an alkyl group or an aryl group is more preferable because of high radical reactivity.

When Z represents $-N(R_{12})$-, $R_{12}$ is preferably a hydrogen atom, a methyl group, an ethyl group or an isopropyl group because of high radical reactivity.

Specific examples of the basic radical polymerizable compound for use in the invention are set forth below, but the invention should not be construed as being limited thereto.

(A) 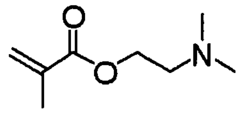 (B) 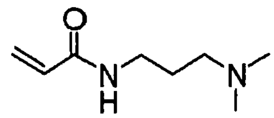

(C) 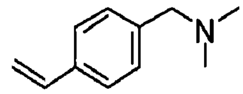 (D) 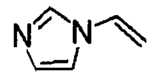

(E) 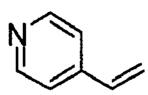 (F) 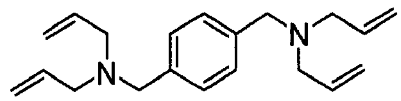

(G) 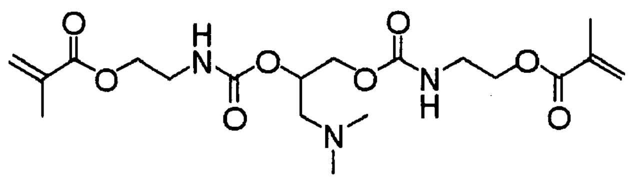

(H) 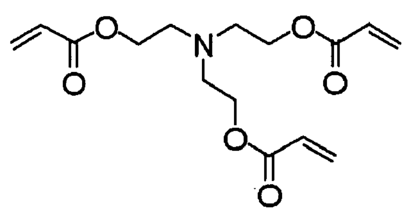

[Neutralized polymer compound]

As the neutralized polymer compound for use in the invention, any polymer compound which has (A1) a support-adsorbing group and (A2) an acid group, and in which at least a part of the acid groups is neutralized with the basic radical polymerizable compound may be suitably used. As a polymer compound forming the skeleton of the neutralized polymer compound, a polymer compound selected from an acrylic resin, a methacrylic resin, a styrene resin, a vinyl acetal resin, a urethane resin, a urea resin, an amide resin, an ester resin, a carbonate resin and an epoxy resin is preferable, and a polymer compound selected from an acrylic resin, a methacrylic resin, a styrene resin and a urethane resin is more preferable. The weight average molecular weight of the neutralized polymer compound is preferably from 5,000 to 1,000,000, more preferably from 10,000 to 500,000, particularly preferably from 20,000 to 250,000.

The neutralized polymer compound can be prepared by neutralizing a polymer compound (hereinafter also referred to as an "unneutralized polymer compound") having (A1) a support-adsorbing group and (A2) an acid group with the basic radical polymerizable compound. For instance, it can be easily prepared by adding the basic radical polymerizable compound in an amount necessary for obtaining the desired neutralization degree to a solution containing the unneutralized polymer compound.

The neutralization degree with the basic radical polymerizable compound is preferably from 20 to 100% by mole, more preferably from 30 to 90% by mole, particularly preferably from 40 to 80% by mole, based on the total acid groups present in the polymer compound.

Specific examples of the unneutralized polymer compound for use in the invention are set forth below, but the invention should not be construed as being limited thereto.

(1) 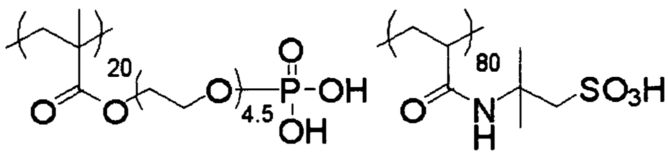

(2) 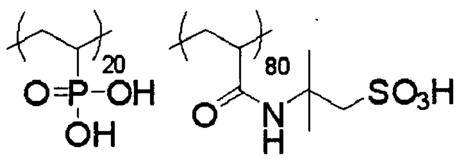

(3) 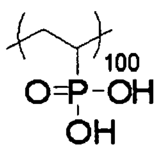 (4) 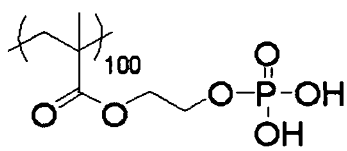 (5) 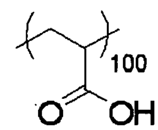

(6) 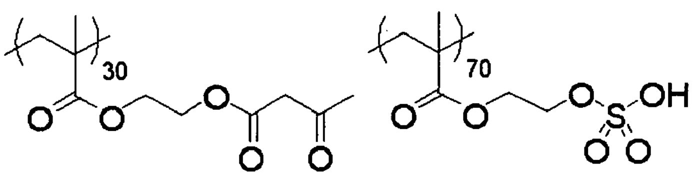 (7) 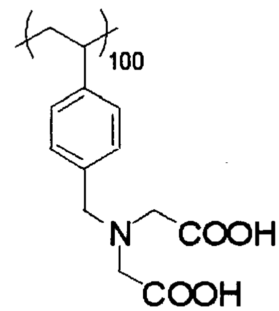

(8) 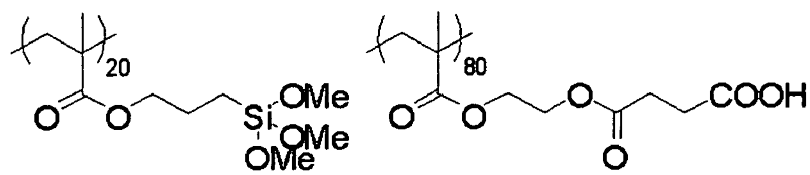

(9) 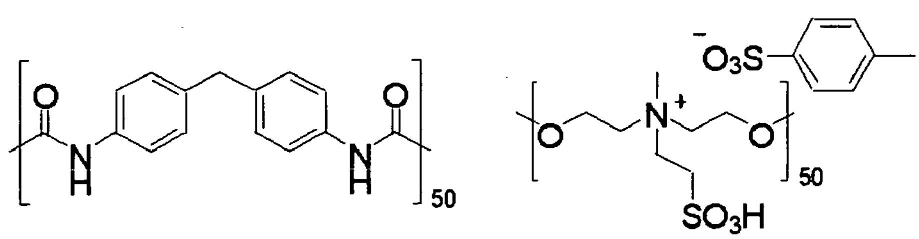

Specific examples (A-1) to (H-9) of the neutralized polymer compound for use in the invention are set forth in Table 1 below, but the invention should not be construed as being limited thereto.

| Unneutralized Polymer Compound | Basic Radical Polymerizable Compound | | | | | | | |
|---|---|---|---|---|---|---|---|---|
| | (A) | (B) | (C) | (D) | (E) | (F) | (G) | (H) |
| (1) | (A-1) | (B-1) | (C-1) | (D-1) | (E-1) | (F-1) | (G-1) | (H-1) |
| (2) | (A-2) | (B-2) | (C-2) | (D-2) | (E-2) | (F-2) | (G-2) | (H-2) |
| (3) | (A-3) | (B-3) | (C-3) | (D-3) | (E-3) | (F-3) | (G-3) | (H-3) |
| (4) | (A-4) | (B-4) | (C-4) | (D-4) | (E-4) | (F-4) | (G-4) | (H-4) |
| (5) | (A-5) | (B-5) | (C-5) | (D-5) | (E-5) | (F-5) | (G-5) | (H-5) |
| (6) | (A-6) | (B-6) | (C-6) | (D-6) | (E-6) | (F-6) | (G-6) | (H-6) |
| (7) | (A-7) | (B-7) | (C-7) | (D-7) | (E-7) | (F-7) | (G-7) | (H-7) |
| (8) | (A-8) | (B-8) | (C-8) | (D-8) | (E-8) | (F-8) | (G-8) | (H-8) |
| (9) | (A-9) | (B-9) | (C-9) | (D-9) | (E-9) | (F-9) | (G-9) | (H-9) |

A synthesis example of the neutralized polymer compound is set forth below, but the invention should not be construed as being limited thereto.

<Synthesis of Neutralized Polymer Compound (A-1)>

In a 300-ml three-necked flask were put 11.93 g of Phosmer PE (produced by Uni-Chemical Co., Ltd.) and 112.77 g of N-methyl-2-pyrrolidinone (NMP), and the mixture was stirred at 50˚C. To the solution was added little by little 28.19 g of 2-acrylamido-2-methylpropanesulfonic acid to be completely dissolved. The temperature of reaction mixture was raised to 74˚C and then the mixture was continued to stir for 30 minutes while introducing nitrogen gas. To the reaction mixture was added a mixed solution of 0.137 g of dimethyl 2, 2'-azobisisobutyrate and 5.05 g of NMP and the mixture was stirred at 74˚C for 2 hours while introducing nitrogen gas. After 2 hours, a mixed solution of 0.039 g of dimethyl 2, 2'-azobisisobutyrate and 2.53 g of NMP was further added and the mixture was stirred for 2 hours as it was. The reaction mixture was cooled to room temperature to obtain an NMP solution of Unneutralized Polymer Compound (1). A sulfonic acid value and a phosphoric acid value of Unneutralized Polymer Compound (1) were 3.4 mmol/g and 0.8 mmol/g, respectively.

In a 100-ml three-necked flask was put 50 g of the NMP solution of Unneutralized Polymer Compound (1) and stirred at room temperature. To the solution was added 3.96 g of 2-diethylaminoethyl methacrylate and the mixture was stirred at room temperature for 30 minutes to obtain an NMP solution of Neutralized Polymer Compound (A-1) represented by the structural formula shown below.

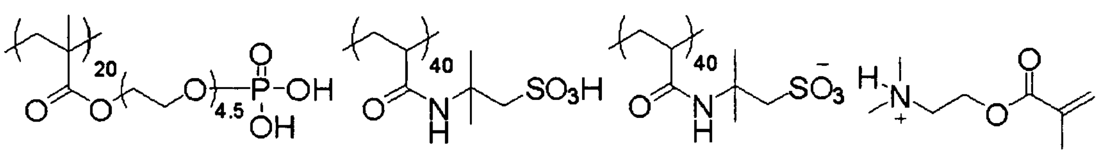

Into the undercoat layer of the lithographic printing plate precursor according to the invention, as a component other than the neutralized polymer compound, a surfactant, a sensitizing dye, a radical polymerization initiator, a co-sensitizer, a radical polymerizable compound or the like may be incorporated. With respect to these components, those described in the image-forming layer hereinafter are preferably used.

The content of the neutralized polymer compound in the undercoat layer according to the invention is preferably 50% by weight or more, more preferably 60% by weight or more, still more preferably 70% by weight or more, based on the total solid content constituting the undercoat layer.

The undercoat layer can be provided on a support in a conventional manner, for example, by a method of dissolving the neutralized polymer compound and other components in an appropriate solvent and coating the resulting solution on the support or immersing the support in the solution. Examples of the appropriate solvent for dissolving the constituting components of the undercoat layer include toluene, xylene, benzene, hexane, heptane, cyclohexane, diethyl ether, diisopropyl ether, dimethoxyethane, anisol, tetrahydrofuran, methylene chloride, chloroform, ethylene dichloride, chlorobenzene, ethyl acetate, butyl acetate, methyl lactate, ethyl lactate, acetone, methyl ethyl ketone, cyclohexanone,

methanol, ethanol, propanol, ethylene glycol monomethyl ether, 1-methoxy-2-propanol, 2-methoxyethyl acetate, 1-methoxy-2-propyl acetate, N,N-dimethylacetamide, N,N-dimethylformamide, tetramethylurea, N-methylpyrrolidone, dimethylsulfoxide, sulfolane, γ-butyrolactone and water. The preparation method of the coating solution or immersing solution, coating method, immersing method, drying method and the like can be appropriately determined by the person skilled in the art.

The amount of the undercoat layer containing the neutralized polymer compound for use in the invention on the support is preferably from 1 to 100 mg/$m^2$, more preferably from 2 to 80 mg/$m^2$, still more preferably from 3 to 50 mg/$m^2$, from the standpoint of printing durability and stain resistance.

[Image-forming layer]

Now, the image-forming layer (hereinafter also referred to as a photosensitive layer) of the lithographic printing plate precursor according to the invention is described below.

As the image-forming layer for use in the invention, any radical polymerizable image-forming layer may be suitably used. In particular, when the image-forming layer which can be developed with an aqueous solution having pH of 2 to 10 or the image-forming layer which can be developed with printing ink and dampening water on a printing machine is used, the effects of the invention are remarkably achieved. The image-forming layer for use in the invention contains a radical polymerizable compound, a binder, a sensitizing dye and a radical polymerization initiator. The image-forming layer may further contain various components, if desired. The constituting components of the image-forming layer are described in detail below.

(Radical polymerizable compound)

The radical polymerizable compound (hereinafter also simply referred to as a polymerizable compound) for use in the photosensitive layer according to the invention is an addition-polymerizable compound having at least one ethylenically unsaturated double bond, and it is selected from compounds having at least one, preferably two or more, terminal ethylenically unsaturated double bonds. Such compounds are widely known in the art and they can be used in the invention without any particular limitation. The polymerizable compound has a chemical form, for example, a monomer, a prepolymer, specifically, a dimer, a trimer or an oligomer, or a copolymer thereof, or a mixture thereof. Examples of the polymerizable compound include compounds represented by formulae (1) to (5) shown below.

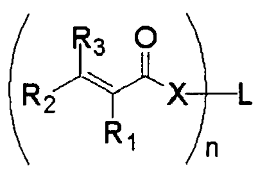
(1)

In formula (1), $R_1$ to $R_3$ each independently represents a monovalent organic group. $R_1$ preferably includes, for example, a hydrogen atom or an alkyl group. Among them, a hydrogen atom, a methyl group or a group formed by substituting one hydrogen atom of methyl group with a hydroxy group, an alkoxy group, an acyloxy group, an amino group, an acylamino group, a thiol group, an alkylthio group, an acylthio group, a sulfonic acid group or a carboxyl group is more preferable because of high radical reactivity. $R_2$ and $R_3$ each independently preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable because of high radical reactivity.

X represents an oxygen atom, a sulfur atom, $-N(R_{12})-$ or $-C(R_{12}R_{13})-$, and $R_{12}$ and $R_{13}$ each represents a monovalent organic group. The monovalent organic group represented by $R_{12}$ or $R_{13}$ includes, for example, an alkyl group. $R_{12}$ or $R_{13}$ is preferably a hydrogen atom, a methyl group, an ethyl group or an isopropyl group because of high radical reactivity. $R_{12}$ or $R_{13}$ may be combined with an atom constituting L to from a ring.

Examples of the substituent capable of being introduced into the organic group include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

L represents an n-valent organic residue constituted from any of hydrogen, fluorine, chlorine, bromine, iodine, carbon, nitrogen, oxygen, boron, sulfur, phosphorus, silicon, lithium, sodium, potassium, magnesium, calcium, aluminum,

scandium, titanium, vanadium, chromium, manganese, iron, cobalt, nickel, zinc, gallium, germanium, silver, palladium, lead, zirconium, rhodium, tin, platinum and tungsten. L is preferably an n-valent organic residue constituted from any of hydrogen, fluorine, chlorine, bromine, iodine, carbon, nitrogen, oxygen, boron, sulfur, phosphorus, silicon, lithium, sodium, potassium, magnesium and calcium, more preferably an n-valent organic residue constituted from any of hydrogen, fluorine, chlorine, bromine, iodine, carbon, nitrogen, oxygen, boron, sulfur, phosphorus and silicon.

n represents a natural number and is preferably from 1 to 100, more preferably from 2 to 80, still more preferably from 3 to 60.

Specific examples of the polymerizable compound represented by formula (1) include (a) an unsaturated carboxylic acid (for example, acrylic acid, methacrylic acid, itaconic acid, crotonic acid, isocrotonic acid, 2-hydroxymethylacrylic acid, $\alpha$-bromoacrylic acid, fumaric acid, mesaconic acid or maleic acid), (b) an ester thereof and (c) an amide thereof, and (d) an ester of an unsaturated carboxylic acid with an aliphatic polyhydric alcohol compound and (e) an amide of an unsaturated carboxylic acid with an aliphatic polyvalent amine compound are preferably used. Further, (f) an addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Moreover, (g) an addition reaction product of an unsaturated carboxylic acid ester or amide having an electrophilic substituent, for example, an isocyanate group or an epoxy group with a monofunctional or polyfunctional alcohol, amine or thiol, or (h) a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated ketone (for example, vinyl methyl ketone or vinyl ethyl ketone) can also be used.

Specific examples of the monomer, which is an ester of an aliphatic polyhydric alcohol compound with an unsaturated carboxylic acid, include, as an acrylic acid ester, for example, ethylene glycol diacrylate, triethylene glycol diacrylate, propylene glycol diacrylate, trimethylolpropane triacrylate, hexanediol diacrylate, 1,4-cyclohexanediol diacrylate, pentaerythritol triacrylate, pentaerythritol tetraacrylate, dipentaerythritol hexaacrylate, sorbitol tetraacrylate, sorbitol hexaacrylate, tri(acryloyloxyethyl) isocyanurate, isocyanuric acid ethylene oxide (EO) modified triacrylate and polyester acrylate oligomer.

As an methacrylic acid ester, for example, tetramethylene glycol dimethacrylate, triethylene glycol dimethacrylate, trimethylolpropane trimethacrylate, pentaerythritol trimethacrylate, pentaerythritol tetramethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane is exemplified.

As an itaconic acid ester, for example, ethylene glycol diitaconate, tetramethylene glycol diitaconate, pentaerythritol diitaconate or sorbitol tetraitaconate is exemplified. As a crotonic acid ester, for example, ethylene glycol dicrotonate, tetramethylene glycol dicrotonate, pentaerythritol dicrotonate or sorbitol tetracrotonate is exemplified. As an isocrotonic acid ester, for example, ethylene glycol diisocrotonate, pentaerythritol diisocrotonate or sorbitol tetraisocrotonate is exemplified. As a maleic acid ester, for example, ethylene glycol dimaleate, pentaerythritol dimaleate or sorbitol tetramaleate is exemplified.

Other examples of the ester, which can be preferably used, include aliphatic alcohol esters described in JP-B-51-47334 (the term "JP-B" as used herein means an "examined Japanese patent publication") and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferable examples of the amide monomer include amides having a cyclohexylene structure described in JP-B-54-21726.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

$$CH_2=C(R_4)COOCH_2CH(R_5)OH \text{ (A)} \qquad \text{(A)}$$

wherein $R_4$ and $R_5$ each independently represents H or $CH_3$.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Further, a photosensitive layer having remarkably excellent photo-speed can be obtained by using an addition polymerizable compound having an amino structure or a sulfide structure in its molecule described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

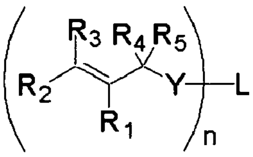
(2)

In formula (2), $R_1$ to $R_5$ each independently represents a monovalent organic group. $R_1$ to $R_5$ each independently preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. Alternatively, appropriate two of $R_1$ to $R_5$ may be combined with each other to form a ring, or any one of $R_1$ to $R_5$ may be combined with an atom constituting L to from a ring.

Examples of the substituent capable of being introduced into the organic group include those described in formula (1). Y represents an oxygen atom, a sulfur atom, $-N(R_{12})-$ or $-C(R_{12}R_{13})-$. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defmed in formula (1), respectively. Preferable examples of L and n are also same as those described in formula (1), respectively.

Specific examples of the polymerizable compound represented by formula (2) include an ester compound of an alcohol having an unsaturated double bond (for example, ally alcohol, ethylene glycol monoallyl ether, 3-butene-1-ol, 2-cyclohexene-1-ol or retinol) with a monofunctional or polyfunctional carboxylic acid (for example, acetic acid, benzoic acid, maleic acid, tricarbaric acid, 1,3,5-cyclohexanetricarboxylic acid or 1,2,4-benzenetricarboxylic acid), a urethane compound of the alcohol having an unsaturated double bond with a monofunctional or polyfunctional iso(thio)cyanate (for example, butyl isocyanate, 1,3-bis(isocyanatomethyl)cyclohexane, 4,4'-methylenebis(cyclohexylisocyanate), isohoron diisocyanate, allyl isothiocyanate, phenyl isothiocyanate, phenyl isocyanate or 4,4'-methylenebis(phenyl isocyanate), an ether compound of the alcohol having an unsaturated double bond with a monofunctional or polyfunctional alcohol (for example, ethanol, ethylene glycol, polyethylene glycol, propylene glycol, cyclohexane diol, inositol, glycerol, trimethylol propane, pentaerythritol, xylitol, dextrin, phenol or bisphenol A), an addition reaction product of the alcohol having an unsaturated double bond with a monofunctional or polyfunctional epoxy compound (for example, ethylene glycol diglycidyl ether, cyclohexene oxide, neopentyl glycol diglycidyl ether or tris(2,3-epoxypropyl)isocyanurate), a substitution reaction product of the alcohol having an unsaturated double bond with a monofunctional or polyfunctional halogenated alkyl (for example, 1,4-dibromobutane or bis(2-bromoethyl) maleate) or a sulfonic acid (for example, methanesulfonic acid, camphorsulfonic acid or toluenesulfonic acid) ester of a monofunctional or polyfunctional alcohol, a substitution reaction product of a halogenated alkyl having an unsaturated double bond (for example, allyl bromide, 4-bromo-1-butene or 3-chloro-2-methylpropene) or a sulfonic acid ester of an alcohol having an unsaturated double bond with a nucleophilic compound, for example, a monofunctional or polyfunctional alcohol, a monofunctional or polyfunctional amine (for example, butylamine, ethylenediamine, triethylamine, pentaethylenehexamine, 2,2'-oxybis(ethylamine), morpholine, piperazine, pyridine, proline or 4,4'-methylenedianiline), a monofunctional or polyfunctional phosphine, a monofunctional or polyfunctional thiol, a monofunctional or polyfunctional carbonyl compound or a monofunctional or polyfunctional carboxylate, an amide of an amine having an unsaturated double bond (for example, allylamine, triallylamine, geranylamine or N-ethyl-2-methylallylamine) with a monofunctional or polyfunctional carboxylic acid, a urea of the amine having an unsaturated double bond with a monofunctional or polyfunctional isocyanate, a substitution reaction product of the amine having an unsaturated double bond with a monofunctional or polyfunctional halogenated alkyl or a sulfonic acid ester of a monofunctional or polyfunctional alcohol, an imine of the amine having an unsaturated double bond with

a monofunctional or polyfunctional carbonyl compound, a sulfonamide of the amine having an unsaturated double bond with a monofunctional or polyfunctional sulfonic acid, a urethane of an iso(thio)cyanate having an unsaturated double bond (for example, allyl isocyanate or allyl isothiocyanate) with a monofunctional or polyfunctional alcohol, a urea of the iso(thio)cyanate having an unsaturated double bond with a monofunctional or polyfunctional amine, an amide of the iso (thio)cyanate having an unsaturated double bond with a monofunctional or polyfunctional carboxylic acid, an addition reaction product of the iso(thio)cyanate having an unsaturated double bond with a monofunctional or polyfunctional thiol, and an addition reaction product of the iso(thio)cyanate having an unsaturated double bond with a monofunctional or polyfunctional iso(thio)cyanate.

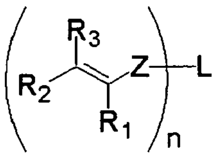

(3)

In formula (3), $R_1$ to $R_3$ each independently represents a monovalent organic group. $R_1$ to $R_3$ each independently preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. Alternatively, appropriate two of $R_1$ to $R_3$ may be combined with each other to form a ring, or any one of $R_1$ to $R_3$ may be combined with an atom constituting L to from a ring.

Examples of the substituent capable of being introduced into the organic group include those described in formula (1). Z represents an oxygen atom, a sulfur atom, $N(R_{12})$- or $-C(R_{12}R_{13})$-. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defined in formula (1), respectively. Preferable examples of L and n are also same as those described in formula (1), respectively.

Specific examples of the polymerizable compound represented by formula (3) include a monofunctional or polyfunctional carboxylic acid vinyl ester (for example, vinyl acetate, isopropenyl acetate or trivinyl 1,3,5-cyclohexanetricarboxylate), a vinyl ether (for example, 1,4-cyclohexanedimethanol divinyl ether or trimethylolpropane trivinyl ether), an ester of a vinyl ether alcohol (for example, ethylene glycol monovinyl ether or diethylene glycol monovinyl ether) with a monofunctional or polyfunctional carboxylic acid, a urethane of the vinyl ether alcohol with a monofunctional or polyfunctional iso(thio)cyanate, a substitution product of the vinyl ether alcohol with a monofunctional or polyfunctional halogenated alkyl or a sulfonic acid ester of a monofunctional or polyfunctional alcohol, an addition product of the vinyl ether alcohol with a monofunctional or polyfunctional epoxy, a substitution reaction product of a vinyl ether of halogenated alkyl (for example, 2-chloromethyl vinyl ether) or a vinyl ether sulfonic acid ester (for example, vinyloxyethyl p-toluenesulfonate) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate, an amide of a vinyl ether amine (for example, 3-amino-1-propanol vinyl ether or 2-(diethylamino)ethanol vinyl ether) with a monofunctional or polyfunctional carboxylic acid, a urea of the vinyl ether amine with a monofunctional or polyfunctional iso(thio)cyanate, a substitution product of the vinyl ether amine with a monofunctional or polyfunctional halogenated alkyl, a sulfonamide of the vinyl ether amine with a monofunctional or polyfunctional sulfonic acid, and a monofunctional or polyfunctional vinyl amide (for example, N-vinyl carbazole, N-vinyl pyrrolidinone or N-vinyl phthalimide).

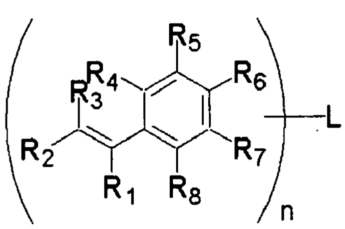

(4)

In formula (4), $R_1$ to $R_3$ each independently represents a monovalent organic group. $R_1$ to $R_3$ each independently

preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. $R_4$ to $R_8$ each independently represents a monovalent organic group or a divalent organic group connecting to L. The monovalent organic group for any one of $R_4$ to $R_8$ preferably includes those described for the monovalent organic group for any one of $R_1$ to $R_3$ above. The divalent organic group for any one of $R_4$ to $R_8$ preferably includes divalent organic groups constituted from any of hydrogen, carbon, oxygen, nitrogen, sulfur, halogen, silicon and phosphorus. Alternatively, appropriate two of $R_4$ to $R_8$ may be combined with each other to form a ring, or any one of $R_4$ to $R_8$ may be combined with an atom constituting L to from a ring.

Examples of the substituent capable of being introduced into the organic group include those described in formula (1).

L and n have the same meanings as L and n defined in formula (1), respectively. Preferable examples of L and n are also same as those described in formula (1), respectively.

Specific examples of the polymerizable compound represented by formula (4) include an ester of a styrene containing a carboxylic acid (for example, p-styrenecarboxylic acid) or a styrene containing a sulfonic acid (for example, p-styrenesulfonic acid) with a monofunctional or polyfunctional alcohol, an amide of the styrene containing a carboxylic acid or sulfonic acid with a monofunctional or polyfunctional amine, an ester of a styrene containing a hydroxy group (for example, p-hydroxymethylstyrene, 2-hydroxyethyl p-styrenecarboxylate or 2-hydroxyethyl p-styrenesulfonate) with a monofunctional or polyfunctional carboxylic acid, a urethane of the styrene containing a hydroxy group with a monofunctional or polyfunctional iso(thio)cyanate, a substitution product of the styrene containing a hydroxy group with a monofunctional or polyfunctional halogenated alkyl or a sulfonic acid ester of a monofunctional or polyfunctional alcohol, an addition product of the styrene containing a hydroxy group with a monofunctional or polyfunctional epoxy, a substitution reaction product of a styrene containing a halogenated alkyl group (for example, p-chloromethylstyrene or 2-chloroethyl p-styrenecarboxylate) or a styrene containing a sulfonic acid ester group (for example, p-tosyloxymethylstyrene) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate, an amide of a styrene containing an amino group (for example, p-aminomethylstyrene) with a monofunctional or polyfunctional carboxylic acid, a urea of the styrene containing an amino group with a monofunctional or polyfunctional iso(thio)cyanate, a substitution product of the styrene containing an amino group with a monofunctional or polyfunctional halogenated alkyl, and a sulfonamide of the styrene containing an amino group with a monofunctional or polyfunctional sulfonic acid.

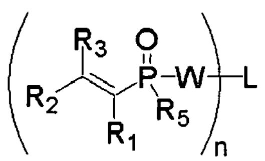

(5)

In formula (5), $R_1$ to $R_3$ each independently represents a monovalent organic group. $R_1$ to $R_3$ each independently preferably includes, for example, a hydrogen atom, a halogen atom, an amino group, a carboxyl group, an alkoxycarbonyl group, a sulfo group, a nitro group, a cyano group, an alkyl group, an aryl group, an alkoxy group, an aryloxy group, an alkylamino group, an arylamino group, an alkylsulfonyl group and an arylsulfonyl group. Among them, a hydrogen atom, a carboxyl group, an alkoxycarbonyl group, an alkyl group or an aryl group is preferable. $R_5$ each independently represents a monovalent organic group. The monovalent organic group for $R_5$ preferably includes those described for the monovalent organic group for any one of $R_1$ to $R_3$ above. Alternatively, $R_5$ may from a ring together with L.

Examples of the substituent capable of being introduced into the organic group include those described in formula (1). W represents an oxygen atom, a sulfur atom, $-N(R_{12})-$ or $-C(R_{12}R_{13})-$. $R_{12}$ and $R_{13}$ have the same meanings as $R_{12}$ and $R_{13}$ defined in formula (1), respectively. Preferable examples of $R_{12}$ and $R_{13}$ are also same as those described in formula (1), respectively.

L and n have the same meanings as L and n defmed in formula (1), respectively. Preferable examples of L and n are also same as those described in formula (1), respectively.

Specific examples of the polymerizable compound represented by formula (5) include an ester of a vinylphosphonic acid (for example, vinylphosphonic acid or methyl 2-phosphonoacrylate) with a monofunctional or polyfunctional alcohol, an amide of the vinylphosphonic acid with a monofunctional or polyfunctional amine, an ester of a vinylphosphonic acid containing a hydroxy group (for example, bis(2-hydroxyethyl) vinylphosphonic acid) with a monofunctional or polyfunctional carboxylic acid, a urethane of the vinylphosphonic acid containing a hydroxy group with a monofunctional or polyfunctional iso(thio)cyanate, a substitution product of the vinylphosphonic acid containing a hydroxy group with a monofunctional or polyfunctional halogenated alkyl or a sulfonic acid ester of a monofunctional or polyfunctional alcohol, an addition product of the vinylphosphonic acid containing a hydroxy group with a monofunctional or polyfunctional epoxy, a substitution reaction product of a vinylphosphonic acid containing a halogenated alkyl group (for example, bis (2-bromoethyl) vinylphosphonic acid) or a vinylphosphonic acid containing a sulfonic acid ester group (for example, p-tosyloxyethyl vinylphosphonic acid) with a nucleophilic compound, for example, a monofunctional or polyfunctional alcohol, a monofunctional or polyfunctional amine, a monofunctional or polyfunctional phosphine, a monofunctional or polyfunctional thiol, a monofunctional or polyfunctional carbonyl compound or a monofunctional or polyfunctional carboxylate.

Details of the method of using the polymerizable compound, for example, selection of the structure, individual or combination use or an amount added, can be appropriately determined in accordance with the characteristic design of the lithographic printing plate precursor. For instance, the compound is selected from the following standpoints.

In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support, a protective layer or the like described hereinafter.

The polymerizable compound is used preferably in a range of 5 to 80% by weight, more preferably in a range of 25 to 75% by weight, based on the total solid content of the photosensitive layer. The polymerizable compounds may be used individually or in combination of two or more thereof The method of using the polymerizable compound can be adequately selected by taking account of the degree of polymerization inhibition due to oxygen, resolution, anti-fogging property, change in refractive index, surface tackiness and the like.

(Binder)

The binder (hereinafter also referred to as a binder polymer) for use in the photosensitive layer according to the invention is preferably a binder polymer having a hydrophilic group from the standpoint of developing property in a developer having pH of 2 to 10.

The hydrophilic group is selected from monovalent and divalent or more valent hydrophilic groups, and preferably includes, for example, a hydroxy group, a sulfonic acid group, an alkylene oxy group (for example, an ethylene oxy group or a propylene oxy group), a primary amino group, a secondary amino group, a tertiary amino group, a salt formed by neutralization of each of these amino groups with an acid, a quaternary ammonium group, an amido group, an ether group, a salt formed by neutralization of an acid, for example, carboxylic acid, sulfonic acid or phosphoric acid and a heterocyclic group containing a positively charged nitrogen atom. A primary amino group, a secondary amino group, a tertiary amino group, a salt formed by neutralization of each of these amino groups with an acid, a quaternary ammonium group, an amido group, a hydroxy group, a repeating unit of $-CH_2CH_2O-$, a repeating unit of $-CH_2CH_2NH-$, a sulfonic acid group, a sulfonate group and a pyridinium group are more preferable, a tertiary amino group, a salt formed by neutralization of the tertiary amino group with an acid, a quaternary ammonium group, an amido group, a sulfonic acid group and a sulfonate group are particularly preferable, and a tertiary amino group, a salt formed by neutralization of the tertiary amino group with an acid and a quaternary ammonium group are most preferable.

The binder polymer having a hydrophilic group (hereinafter also referred to as a hydrophilic group-containing binder polymer) according to the invention may be any appropriate compound as long as it is a polymer having the hydrophilic group described above in its main chain and/or side chain. It is preferably a polymer having the hydrophilic group described above in its side chain, more preferably a polymer having a primary amino group, a secondary amino group, a tertiary amino group, a salt formed by neutralization of each of these amino groups with an acid, a quaternary ammonium group, an amido group, a hydroxy group, a repeating unit of $-CH_2CH_2O-$, a repeating unit of $-CH_2CH_2NH-$, a sulfonic acid group, a sulfonate group and a pyridinium group in its side chain, and particularly preferably a polymer having an amino group and/or an ammonium group represented by formula <1> or <2> shown below in its side chain. The binder polymer having a group represented by formula <1> or <2> shown below in its side chain may be any appropriate compound as long as it is a polymer compound including a repeating unit containing the structure represented by formula <1> or <2>.

<1>

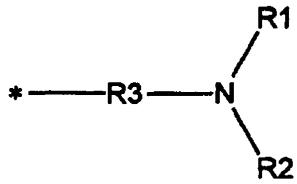

<2>

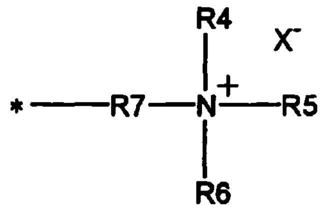

In formulae <1> and <2>, R1, R2 and R4 to R6 each independently represents a monovalent organic group, R3 and R7 each represents a single bond or a divalent organic group, or appropriate two of R1 to R3 or appropriate two of R4 to R7 may be combined with each other to form a ring, or appropriate one of R1 to R3 or appropriate one of R4 to R7 may form a double bond between the nitrogen atom, in this case R1 or R2 in formula <1> or one of R4 to R6 in formula <2> is not present, $X^-$ represents an anion, and * represents a position connecting to the binder polymer.

In formulae <1> and <2>, the monovalent organic group is a monovalent substituent comprising at least one atom selected from hydrogen, carbon, oxygen, nitrogen, sulfur, phosphorus, halogen and silicon. The divalent organic group is a divalent connecting group comprising at least one atom selected from hydrogen, carbon, oxygen, nitrogen, sulfur, phosphorus, halogen and silicon. The monovalent substituent comprising at least one atom selected from hydrogen, carbon, oxygen, nitrogen, sulfur, phosphorus, halogen and silicon includes substituents formed from -H, -F, -Cl, -Br, -I, >C<, =C<, ≡C-, -O-, O=, -N<, -N=, ≡N, -S-, S=, >S<, ≡S≡, -P<, ≡P<, >Si<, =Si<, =Si- and combinations thereof. Examples of the monovalent substituent include a hydrogen atom, an alkyl group (for example, a methyl group, an ethyl group, a cyclohexyl group, a chloromethyl group, a methoxyethoxyethyl group, an allyloxymethyl group, an N-(methoxyphenyl)carbamoylethyl group or a p-methylbenzyl group), an aryl group (for example, a phenyl group, a biphenyl group or a naphthyl group), a heteroaryl group (for example, a group derived from a hetero ring, for example, thiophene, furan, pyran, pyrrole, pyrazole, isothiazole, isoxazole, pyrazine, pyrimidine, carbazole, acridine, furazane or phenoxazine), an alkenyl group (for example, a vinyl group, a 1-propenyl group or a 2-chloro-1-ethenyl group), an alkynyl group (for example, an ethynyl group, a 1-propynyl group or a trimethylsilylethynyl group), a halogen atom (for example, -F, -Br, -Cl or -I), a hydroxy group, an alkoxy group, an aryloxy group, a mercapto group, an acyl group, a sulfo group ($-SO_3H$) and its conjugated base group (hereinafter referred to as a "sulfonato group"), a phosphono group ($-PO_3H_2$) and its conjugated base group (hereinafter referred to as a "phosphonato group"), a phosphonooxy group ($-OPO_3H_2$) and its conjugated base group (hereinafter referred to as a "phosphonatooxy group"), a cyano group and a nitro group. Among the above-described groups, a hydrogen atom, an alkyl group, an aryl group, an alkenyl group, an alkynyl group, a halogen atom, an alkoxy group and an acyl group are preferable. The divalent connecting group is nor particularly restricted and preferably includes an alkylene group, an arylene group and a connecting group containing a hetero atom, for example, an ester bond, an amido bond or an ether bond, and combinations thereof.

In formula <1>, it is preferred that R1 and R2 each independently represents a hydrogen atom, an alkyl group or an aryl group from the standpoint of the developing property in a developer having pH of 2.0 to 10.0. The total number of carbon numbers included in R1 and R2 is preferably from 0 to 24, more preferably from 0 to 12. When the total number of carbon atoms included in R1 and R2 is 0, both R1 and R2 represent hydrogen atoms.

In formula <2>, it is preferred that R4, R5 and R6 each independently represents a hydrogen atom, an alkyl group or an aryl group from the standpoint of the developing property in a developer having pH of 2 to 10. The total number of carbon atoms included in R4, R5 and R6 is preferably from 0 to 36, more preferably from 0 to 18. When the total number of carbon atoms included in R4, R5 and R6 is 0, R4, R5 and R6 all represent hydrogen atoms.

In formulae <1> and <2>, specific examples of the anion represented by X- include a halogen anion, a halogen oxoacid anion (for example, $ClO_4^-$, $IO_3^-$ or $BrO_3^-$), a halogeno complex anion (for example, $BF_4^-$, $PF_6^-$ or $AlCl_4^-$), a sulfate anion, a nitrate anion, a phosphate anion, a borate anion, a carboxylate anion, a sulfonate anion, a phosphonate anion and a metal complex anion (for example, $[Fe(CN)_6]^-$) Among them, from the standpoint of the developing property in a developer having pH of 2 to 10, a halogen anion, a halogeno complex anion, a borate anion, a carboxylate anion and a sulfonate anion are preferable, and a halogeno complex anion, a borate anion and a sulfonate anion are more preferable.

The hydrophilic group-containing binder polymer for use in the invention is preferably a copolymer. The ratio of a copolymerization component having the hydrophilic group described above is preferably from 1 to 70% by mole based on the total copolymerization component of the copolymer from the standpoint of the developing property. In consideration of the compatibility between the developing property and printing durability, the ratio is more preferably from 1 to 50% by mole, and still more preferably from 1 to 30% by mole.

It is preferred that the hydrophilic group-containing binder polymer for use in the invention does not substantially

contain a carboxylic acid group or a phosphoric acid group in view of the developing property and stain resistance.

An acid value (acid content per g of polymer, indicated by the chemical equivalent number) of the hydrophilic group-containing binder polymer is preferably 0.3 meq/g or less, and more preferably 0.1 meq/g or less.

The hydrophilic group-containing binder polymer for use in the invention is preferably insoluble in water and an aqueous solution having a pH of 10 or more. The solubility (binder polymer concentration at the saturation dissolution) of the binder polymer in water or an aqueous solution having a pH of 10 or more is preferably 10% by weight or less, and more preferably 1.0% by weight or less. The temperature for measuring the above-described solubility is 25˚C which is ordinary temperature at the plate making.

As the skeleton of the binder polymer, a polymer selected from an acrylic resin, a polyvinyl acetal resin, a polyvinyl alcohol resin, a polyurethane resin, a polyamide resin, an epoxy resin, a methacrylic resin, a styrene resin and a polyester resin is preferable. Among them, a vinyl copolymer, for example, an acrylic resin, a methacrylic resin or a styrene resin and a polyurethane resin are particularly preferable.

The binder polymer for use in the invention preferably has a crosslinkable group.

The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group and a halogen atom. Among them, the ethylenically unsaturated bonding group is preferable.

In the binder polymer having a crosslinkable group, for example, a free radical (a polymerization initiating radical or a propagating radical in the process of polymerization of the polymerizable compound) is added to the crosslinkable functional group to cause an addition-polymerization between polymers directly or through a polymerization chain of the polymerizable compound, as a result, crosslinking is formed between polymer molecules to effect curing. Alternatively, an atom (for example, a hydrogen atom on the carbon atom adjacent to the crosslinkable functional group) in the polymer is withdrawn by a free radical to produce a polymer radical and the polymer radicals combine with each other to form crosslinking between polymer molecules to effect curing. The crosslinkable group is not particularly restricted as long as it has a radical polymerizable unsaturated double bond in its side chain. The crosslinkable group preferably includes a (meth)acryloyl group, an ally group and a styryl group and the (meth)acryloyl group is particularly preferably in view of the printing durability.

The content of the crosslinkable group (content of radical-polymerizable unsaturated double bond determined by iodine titration) in the binder polymer is preferably from 0.01 to 10.0 mmol, more preferably from 0.05 to 5.0 mmol, still more preferably from 0.1 to 2.0 mmol, per g of the binder polymer.

From the standpoint of improvement in the printing durability, it is preferred in the hydrophilic group-containing binder polymer that the crosslinkable group is present near the hydrophilic group and both the hydrophilic group and the crosslinkable group may be present in the same polymerization unit.

In the case where the binder polymer is an acrylic resin, it is preferred that the binder polymer has a unit of alkyl (meth)acrylate or aralkyl (meth)acrylate besides the unit having a hydrophilic group, the unit having a crosslinkable group or the unit having a hydrophilic group and a crosslinkable group. The alkyl group in the alkyl (meth)acrylate is preferably an alkyl group having from 1 to 5 carbon atoms and more preferably a methyl group. The aralkyl (meth) acrylate includes, for example, benzyl (meth)acrylate.

In the case where the binder polymer is a urethane resin, it is preferred that the binder polymer has a hydrophobic unit besides the unit having a hydrophilic group, the unit having a crosslinkable group or the unit having a hydrophilic group and a crosslinkable group. The hydrophobic unit includes an alkyl group having 5 or more carbon atoms, an alkylene group having 5 or more carbon atoms, an aryl group and an arylene group. A polyurethane resin including an alkylene group having 5 or more carbon atoms or an arylene group in its main chain skeleton is particularly preferable from the standpoint of the printing durability.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymer may be any of a random polymer, a block polymer, a graft polymer and the like.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to

75% by weight.

Specific examples of the binder polymer for use in the invention are set forth below, but the invention should not be construed as being limited thereto. In the tables below, the molecular weight is a weight average molecular weight (Mw) measured by gel permeation chromatography (GPC) and determined using polystyrene as a standard substance.

| Polymer No. | Structure of Binder Polymer (% by mole) | Molecular Weight |
|---|---|---|
| P-1 | 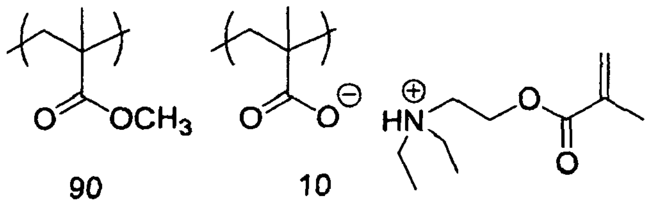 90 10 | 80000 |
| P-2 | 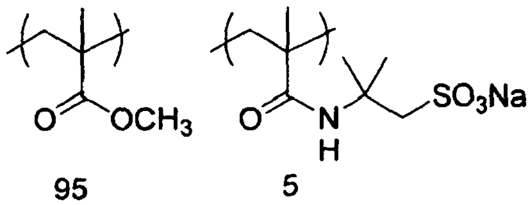 95 5 | 72000 |

| Polymer No. | Diisocyanate Compound Used (% by mole) | Diol Compound Used (% by mole) | Molecular Weight |
|---|---|---|---|
| P-3 | 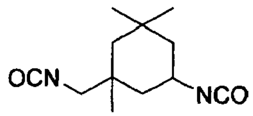 70 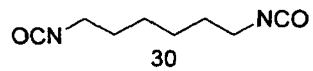 30 | 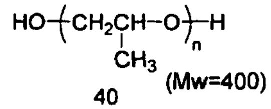 (Mw=400) 40 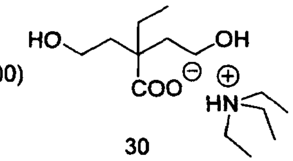 30 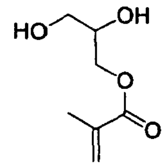 30 | 60000 |

| Polymer No. | Structure of Binder Polymer (% by mole) | Molecular Weight |
|---|---|---|
| P-4 | 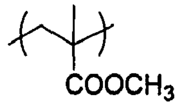 90 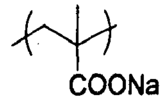 10 | 50000 |
| P-5 | 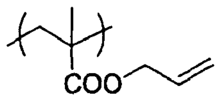 90 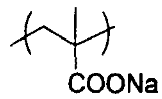 10 | 60000 |
| P-6 | 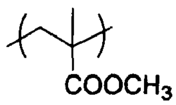 65 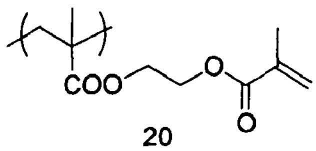 20 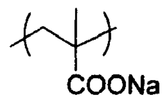 15 | 65000 |
| P-7 | 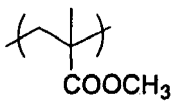 85 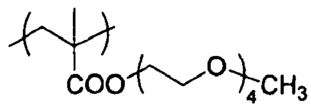 10 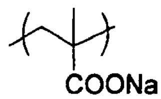 5 | 60000 |
| P-8 | 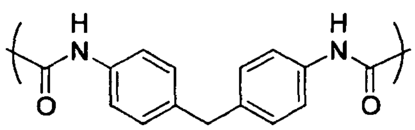 40 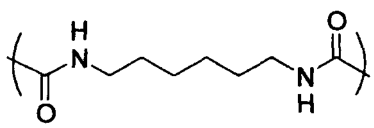 10 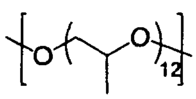 20 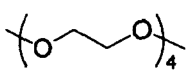 20 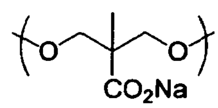 10 | 63000 |
| P-9 | 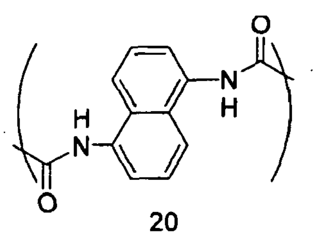 20 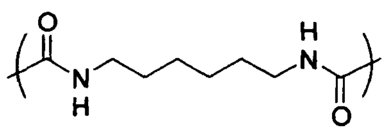 30 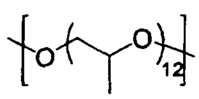 20 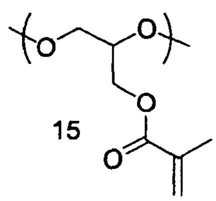 15 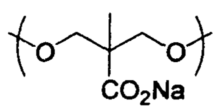 15 | 60000 |

| Polymer No. | Structure of Binder Polymer | Composition Ratio | Molecular Weight |
|---|---|---|---|
| P-10 | 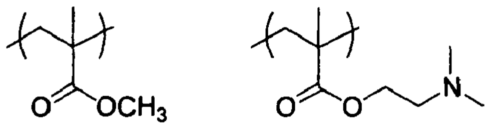 | 90/10 | 70000 |
| P-11 | 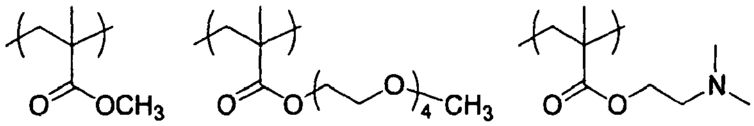 | 90/5/5 | 80000 |
| P-12 | 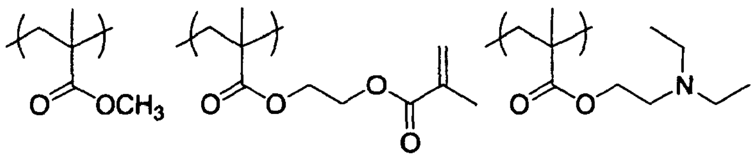 | 60/35/5 | 80000 |

| Polymer No. | Diisocyanate Compound Used (% by mole) | Diol Compound Used (% by mole) | Molecular Weight |
|---|---|---|---|
| P-13 | 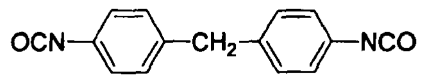 80 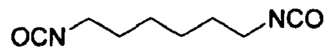 20 | 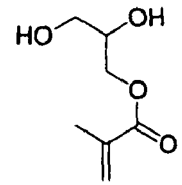 30 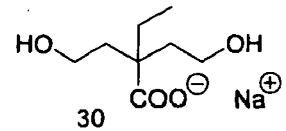 30 $HO-(CH_2CH(CH_3)-O)_n-H$ 40 (Mw=400) | 57000 |

| Polymer No. | Structure of Binder Polymer | Compositic Ratio | Molecular Weight |
|---|---|---|---|
| P-14 | 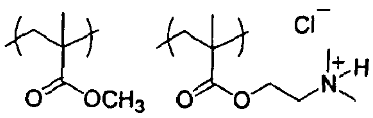 | 90/10 | 70000 |
| P-15 | 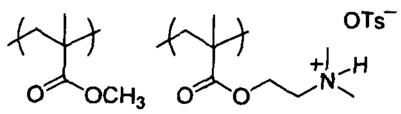 | 90/10 | 58000 |
| P-16 | 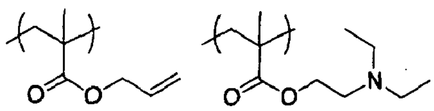 | 90/10 | 90000 |
| P-17 | 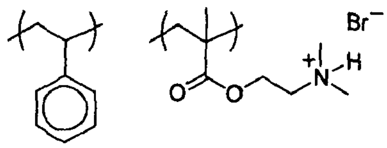 | 70/30 | 62000 |
| P-18 | 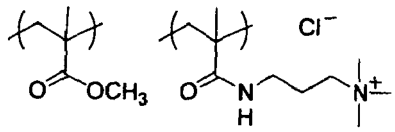 | 70/30 | 58000 |
| P-19 | 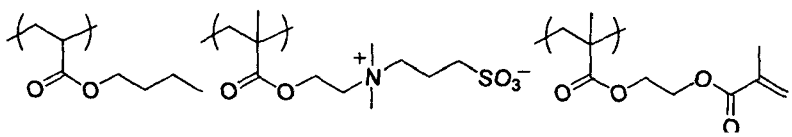 | 50/25/25 | 49000 |

| Polymer No. | Structure of Diisocyanate/Dicarboxylic acid | | Structure of Diol/Diamine | | | Molecular Weight |
|---|---|---|---|---|---|---|
| P-20 | 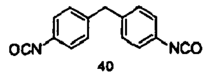 40 | 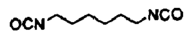 10 | $HO-(CH_2CH(CH_3)-O)_n-H$ 10 (Mw=1000) | 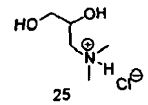 25 | 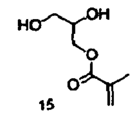 15 | 59000 |
| P-21 | 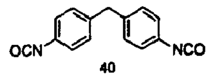 40 | 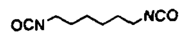 10 | $HO-(CH_2CH(CH_3)-O)_n-H$ 10 (Mw=1000) | 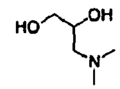 25 | 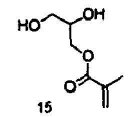 15 | 59000 |
| P-22 | 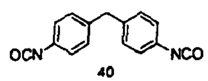 40 | 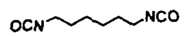 10 | $HO-(CH_2CH(CH_3)-O)_n-H$ 10 (Mw=1000) | 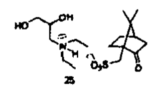 25 | 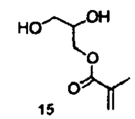 15 | 62000 |
| P-23 | 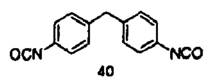 40 | 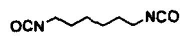 10 | 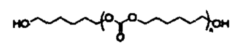 10 | 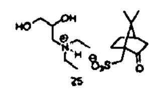 25 | 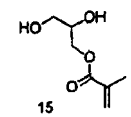 15 | 53000 |

| Polymer No. | Structure of Binder Polymer (% by mole) | Molecular Weight |
|---|---|---|
| P-24 | 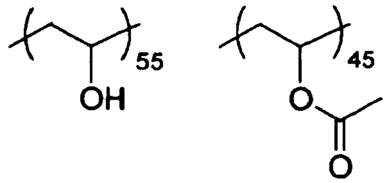 | 80000 |
| P-25 | 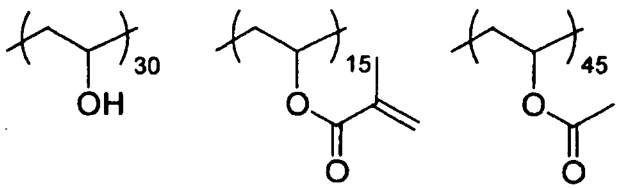 | 100000 |

Specific examples of the binder polymer including the structure represented by formula <1> or <2> in its repeating unit are set forth below, but the invention should not be construed as being limited thereto.

In the tables below, the molecular weight is a weight average molecular weight (Mw) measured by gel permeation chromatography (GPC) and determined using polystyrene as a standard substance.

Further, with respect to Polymers PB-1 to PB-50b shown below, the numeral attached to the compound means a reaction ratio (% by mole) of each constituting component. Also, "PPG" and "PEG" mean polypropylene glycol and polyethylene glycol, respectively, and the subsequent numeral means an average molecular weight. For example, "PPG1000" means polypropylene glycol having an average molecular weight of 1,000.

| | | Composition Ratio | Molecular Weight |
|---|---|---|---|
| PA-1 | 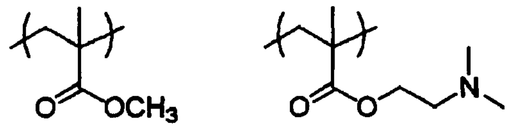 | 90/10 | 70000 |
| PA-2 | 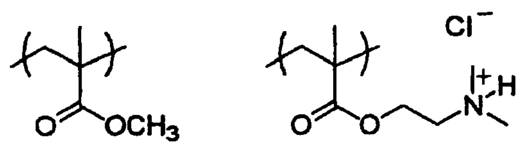 | 90/10 | 70000 |
| PA-3 | 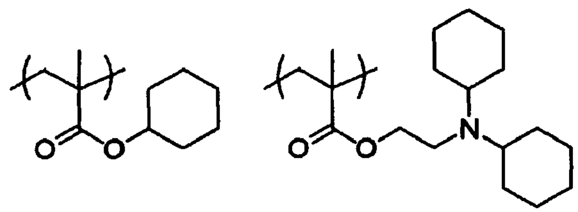 | 80/20 | 60000 |
| PA-4 | 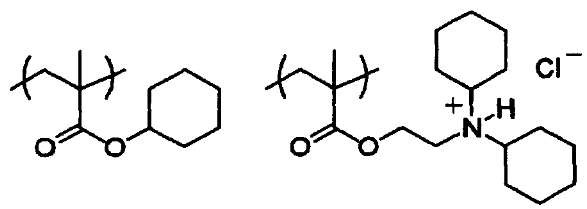 | 80/20 | 60000 |
| PA-5 | 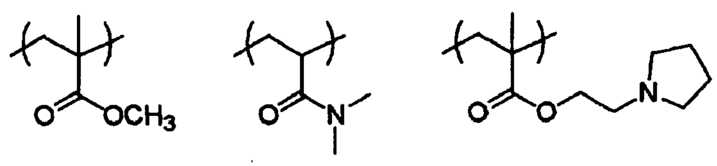 | 90/5/5 | 60000 |

(continued)

| | | Composition Ratio | Molecular Weight |
|---|---|---|---|
| PA-6 | 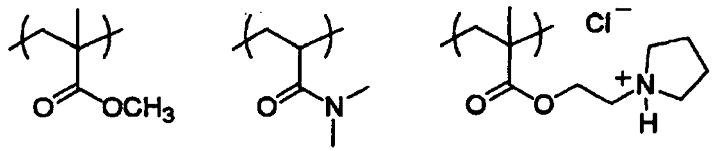 | 90/5/5 | 60000 |
| PA-7 | 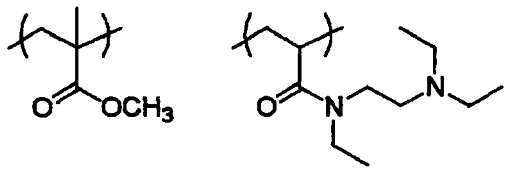 | 95/5 | 70000 |
| PA-8 | 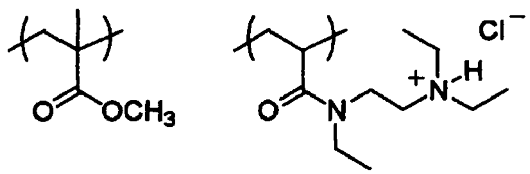 | 95/5 | 70000 |
| PA-9 | 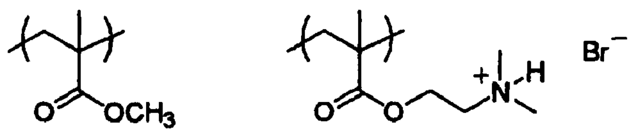 | 90/10 | 70000 |
| PA-10 | 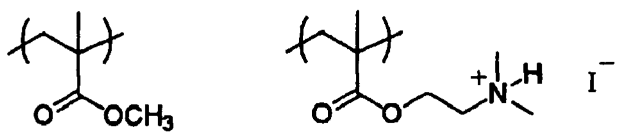 | 90/10 | 52000 |

(continued)

| | | | Composition Ratio | Molecular Weight |
|---|---|---|---|---|
| PA-11 | 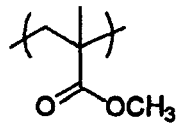 | 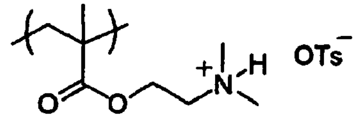 | 90/10 | 58000 |
| PA-12 | 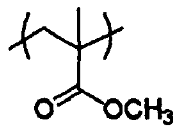 | 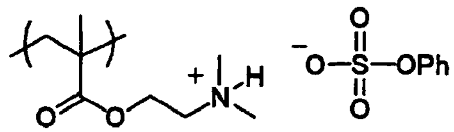 | 90/10 | 49000 |
| PA-13 | 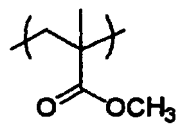 | 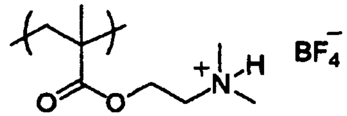 | 90/10 | 50000 |
| PA-14 | 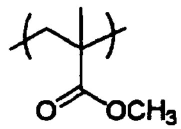 | 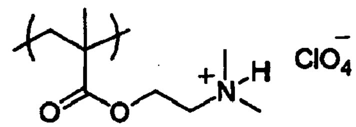 | 90/10 | 63000 |
| PA-15 | 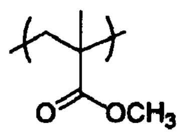 | 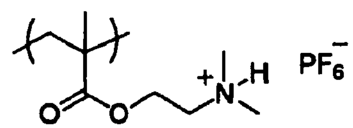 | 90/10 | 80000 |
| PA-16 | 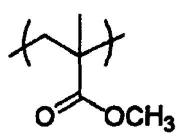 | 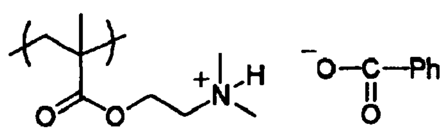 | 90/10 | 65000 |
| PA-17 | 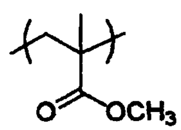 | 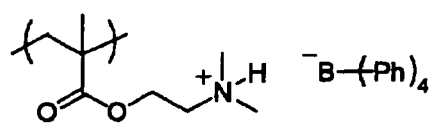 | 90/10 | 60000 |

(continued)

| | | Composition Ratio | Molecular Weight |
|---|---|---|---|
| PA-18 | 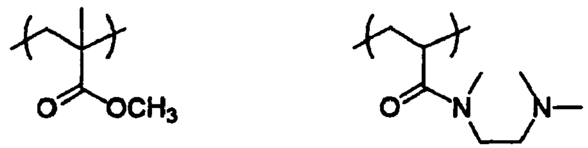 | 80/20 | 65000 |
| PA-19 | 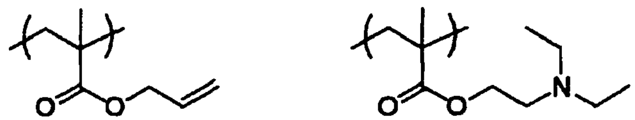 | 90/10 | 90000 |
| PA-20 | 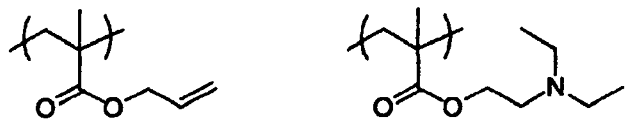 | 80/20 | 64000 |
| PA-21 | 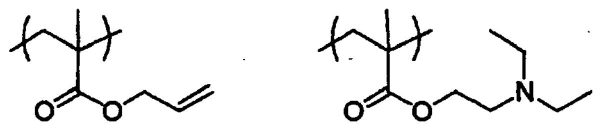 | 70/30 | 77000 |
| PA-22 | 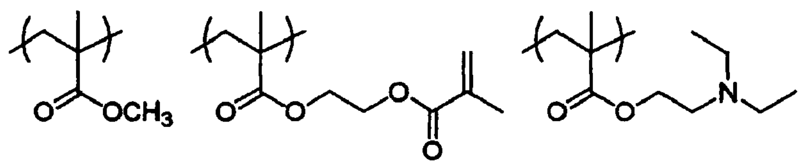 | 60/35/5 | 80000 |
| PA-23 | 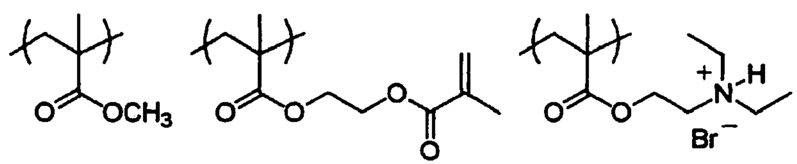 | 60/35/5 | 72000 |

(continued)

| | | Composition Ratio | Molecular Weight |
|---|---|---|---|
| PA-24 | 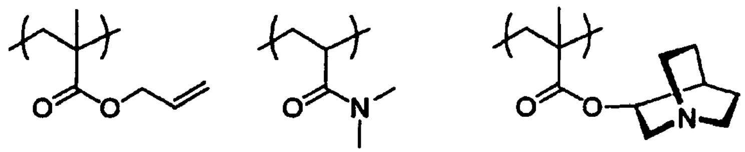 | 80/10/10 | 90000 |
| PA-25 | 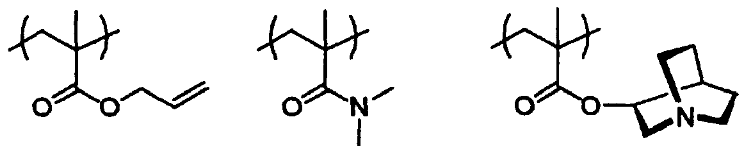 | 60/20/20 | 53000 |
| PA-26 | 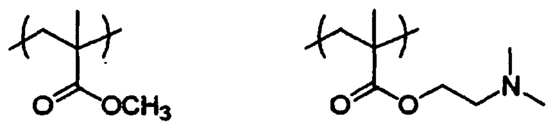 | 80/20 | 57000 |
| PA-27 | 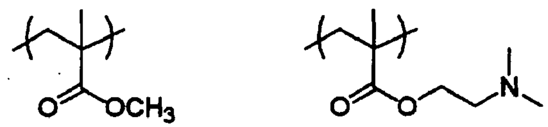 | 70/30 | 48000 |
| PA-28 | 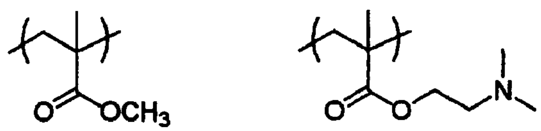 | 60/40 | 81000 |
| PA-29 | 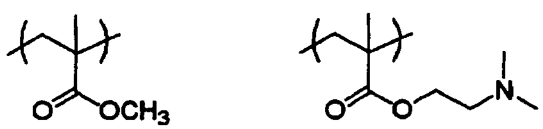 | 50/50 | 70000 |

(continued)

| | | | Composition Ratio | Molecular Weight |
|---|---|---|---|---|
| PA-30 | 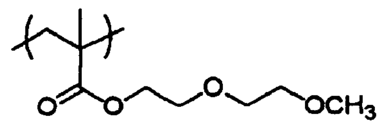 | 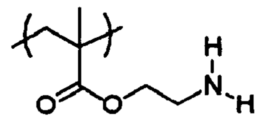 | 50/50 | 72000 |
| PA-31 | 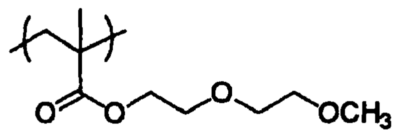 | 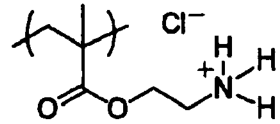 | 50/50 | 72000 |
| PA-32 | 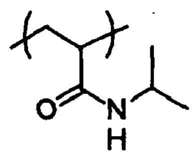 | 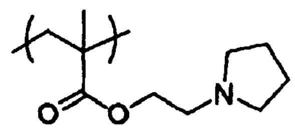 | 50/50 | 65000 |
| PA-33 | 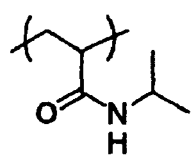 | 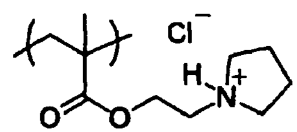 | 50/50 | 65000 |
| PA-34 | 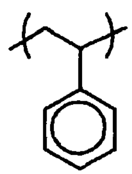 | 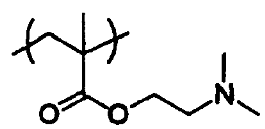 | 60/40 | 50000 |

(continued)

| | | | Composition Ratio | Molecular Weight |
|---|---|---|---|---|
| PA-35 | 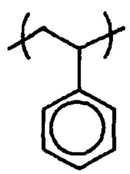 | 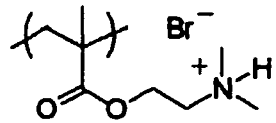 | 70/30 | 62000 |
| PA-36 | 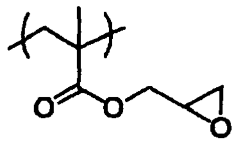 | 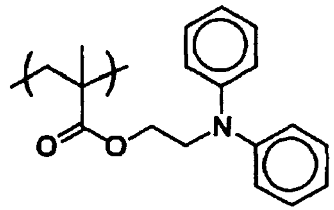 | 30/70 | 71000 |
| PA-37 | 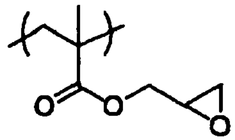 | 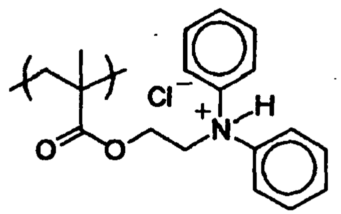 | 30/70 | 71000 |
| PA-38 | 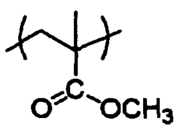 | 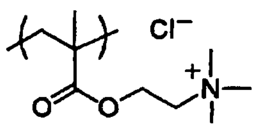 | 60/40 | 65000 |
| PA-39 | 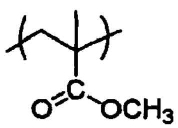 | 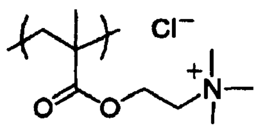 | 70/30 | 70000 |

(continued)

| | Structure | Composition Ratio | Molecular Weight |
|---|---|---|---|
| PA-40 | 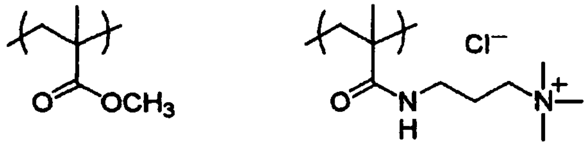 | 70/30 | 58000 |
| PA-41 | 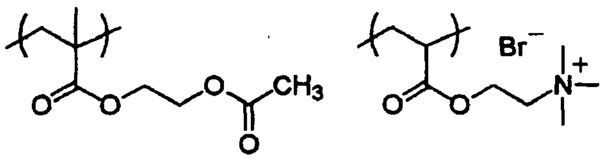 | 65/35 | 60000 |
| PA-42 | 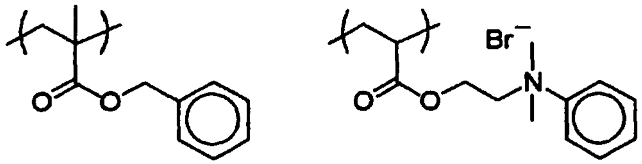 | 60/40 | 57000 |
| PA-43 | 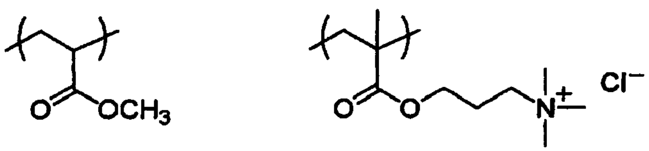 | 60/40 | 65000 |
| PA-44 | 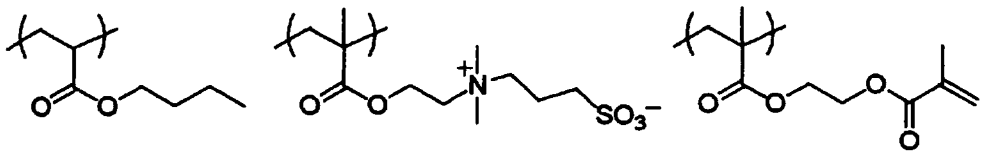 | 50/25/25 | 49000 |
| PA-45 | 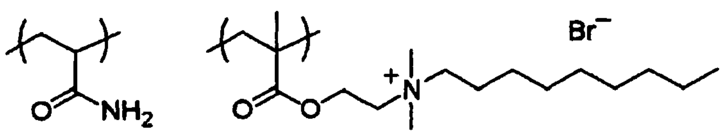 | 50/50 | 71000 |

(continued)

| | | | Composition Ratio | Molecular Weight |
|---|---|---|---|---|
| PA-46 | 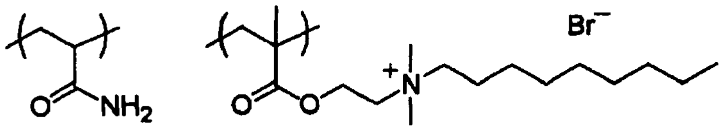 | | 60/40 | 65000 |
| PA-47 | 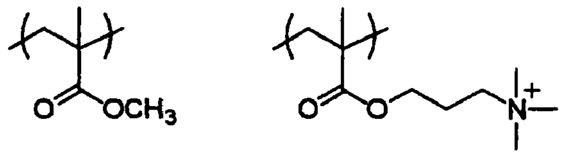 | $ClO^-$ | 70/30 | 69000 |
| PA-48 | 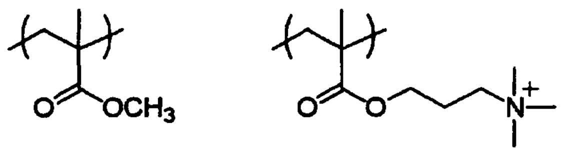 | $PF_6$- | 70/30 | 60000 |
| PA-49 | 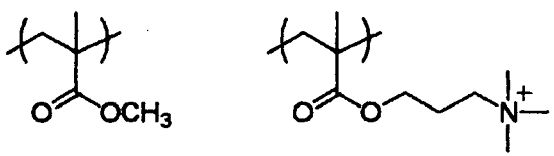 | OTs- | 70/30 | 55000 |
| PA-50 | 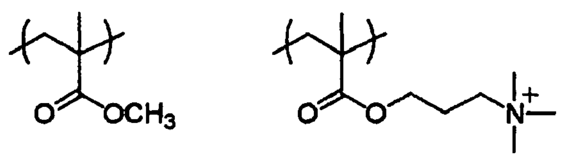 | BF4- | 70/30 | 50000 |

(continued)

| | | | Composition Ratio | Molecular Weight |
|---|---|---|---|---|
| PA-51 | 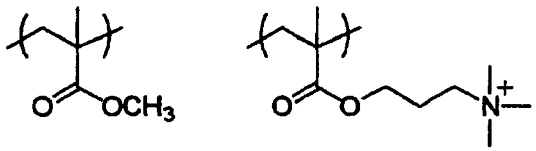 | $^{-}OSO_3CH_3$ | 70/30 | 63000 |
| PA-52 | 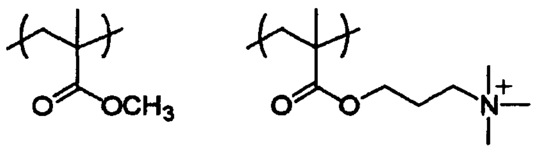 | BPh4- | 70/30 | 58000 |
| PA-53 | 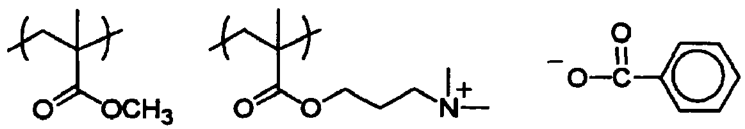 | | 70/30 | 60000 |
| PA-54 | 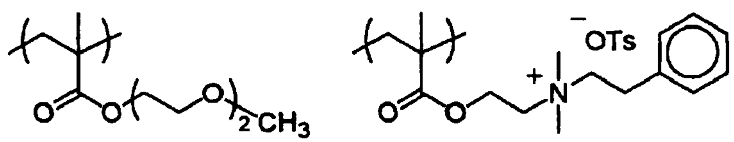 | | 60/40 | 58000 |
| PA-55 | 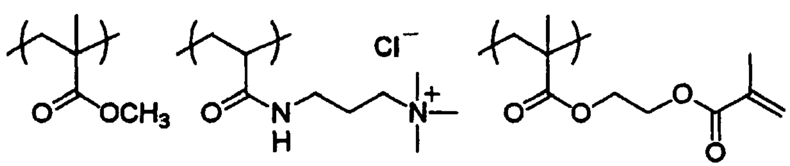 | | 70/15/15 | 60000 |

(continued)

| | | Composition Ratio | Molecular Weight |
|---|---|---|---|
| PA-56 | 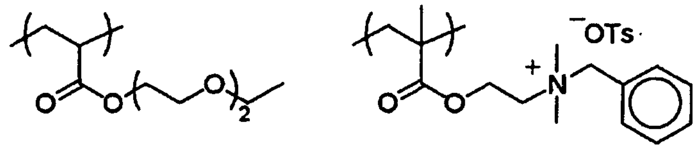 | 50/50 | 55000 |
| PA-57 | 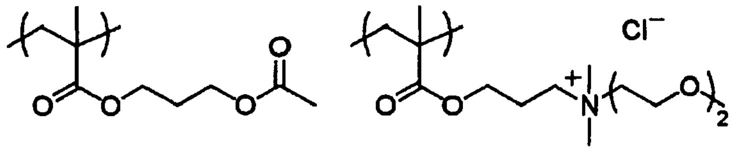 | 45/55 | 60000 |
| PA-58 | 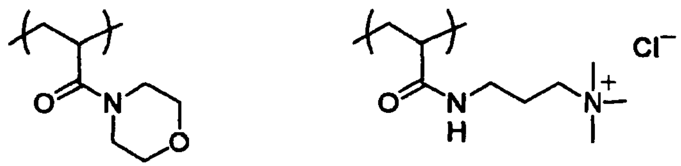 | 80/20 | 70000 |
| PA-59 | 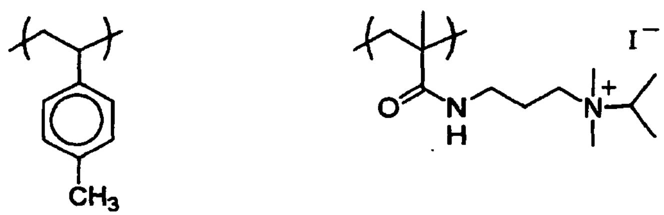 | 50150 | 60000 |
| PA-60 | 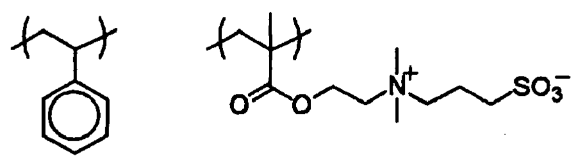 | 60/40 | 69000 |

(continued)

| | | | Composition Ratio | Molecular Weight |
|---|---|---|---|---|
| PA-61 | 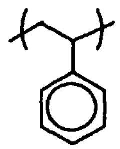 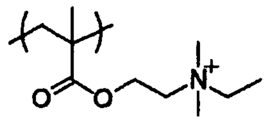 | $^{-}OSO_3Et$ | 40/60 | 80000 |
| PA-62 | 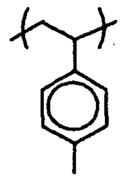 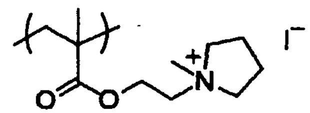 | | 40/60 | 73000 |
| PA-63 | 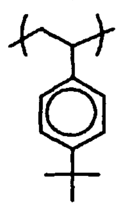 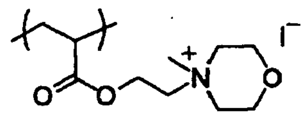 | | 80/20 | 50000 |
| PA-64 | 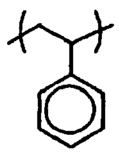 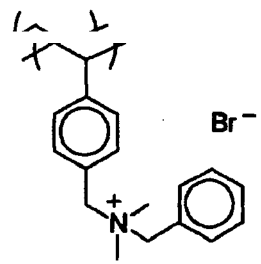 | | 50/50 | 40000 |
| PA-65 | 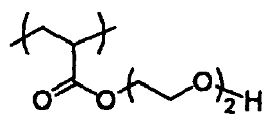 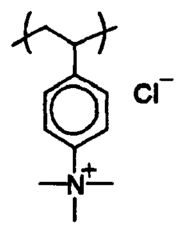 | | 70/30 | 50000 |

(continued)

| | | | Composition Ratio | Molecular Weight |
|---|---|---|---|---|
| PA-66 | 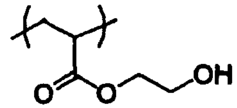 | 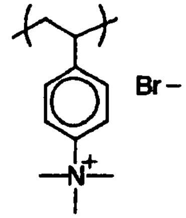 | 80/20 | 44000 |
| PA-67 | 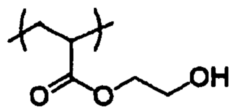 | 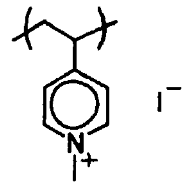 | 50/50 | 55000 |
| PA-68 | 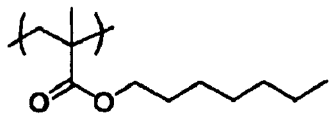 | 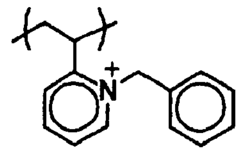 | 30/70 | 58000 |

| | Structure of Diisocyanate/Dicarboxylic Acid | | Structure of Diol/Diamine | | | Molecular Weight |
|---|---|---|---|---|---|---|
| PB-1 | 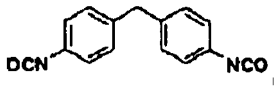 | | 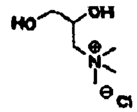 | | | 60000 |
| | 50 | | 50 | | | |
| PB-2 | 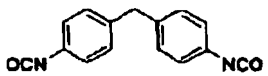 | | PPG1000 | 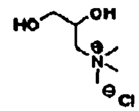 | | 45000 |
| | 50 | | 20 | 30 | | |
| PB-3 | 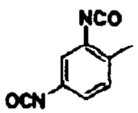 | | PPG1000 | 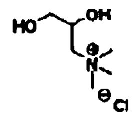 | | 55000 |
| | 50 | | 20 | 30 | | |
| PB-4 | 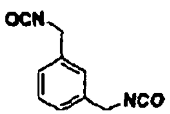 | | PPG1000 | 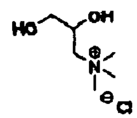 | | 50000 |
| | 50 | | 20 | 30 | | |
| PB-5 | 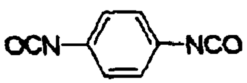 | | PPG1000 | 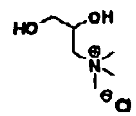 | | 52000 |
| | 50 | | 20 | 30 | | |
| PB-6 | 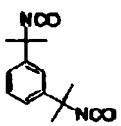 | | PPG1000 | 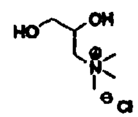 | | 70000 |
| | 50 | | 20 | 30 | | |

(continued)

| | Structure of Diisocyanate/Dicarboxylic Acid | | Structure of Diol/Diamine | | | Molecular Weight |
|---|---|---|---|---|---|---|
| PB-7 | 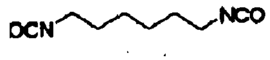 | | PPG1000 | 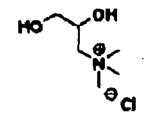 | | 78000 |
| | 50 | | 20 | 30 | | |
| PB-8 | 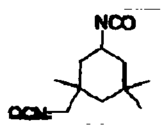 | | PPG1000 | 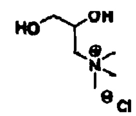 | | 53000 |
| | 50 | | 20 | 30 | | |
| PB-9 | 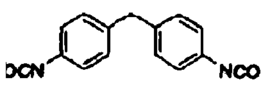 | | PPG1000 | 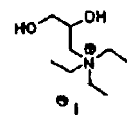 | | 55000 |
| | 50 | | 25 | 25 | | |
| PB-10 | 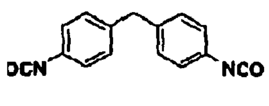 | | PPG1000 | 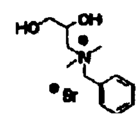 | | 56000 |
| | 50 | | 25 | 25 | | |
| PB-11 | 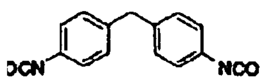 | | PPG1000 | 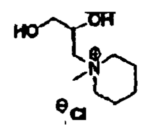 | | 60000 |
| | 50 | | 25 | 25 | | |
| PB-12 | 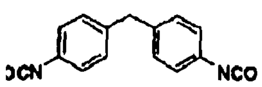 | | PPG1000 | 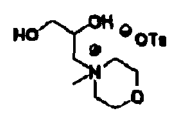 | | 48000 |
| | 50 | | 25 | 25 | | |

(continued)

| | Structure of Diisocyanate/Dicarboxylic Acid | | Structure of Diol/Diamine | | | Molecular Weight |
|---|---|---|---|---|---|---|
| PB-13 | 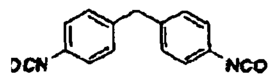 | | PPG1000 | 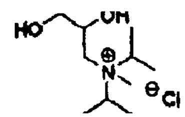 | | 55000 |
| | 50 | | 10 | 40 | | |
| PB-14 | 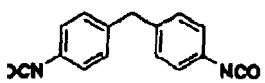 | | PPG1000 | 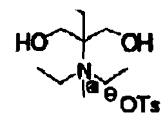 | | 63000 |
| | 50 | | 10 | 40 | | |
| PB-15 | 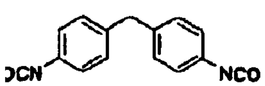 | | PPG1000 | 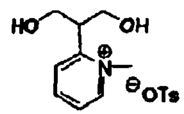 | | 50000 |
| | 50 | | 10 | 40 | | |
| PB-16 | 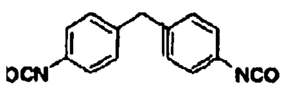 | | PPG1000 | 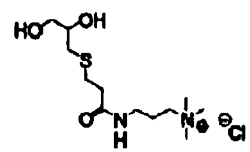 | | 52000 |
| | 50 | | 20 | 30 | | |
| PB-17 | 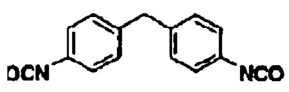 | | PPG1000 | 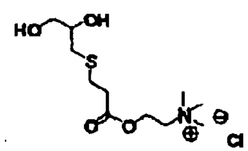 | | 51000 |
| | 50 | | 20 | 30 | | |

(continued)

| | Structure of Diisocyanate/Dicarboxylic Acid | | Structure of Diol/Diamine | | | Molecular Weight |
|---|---|---|---|---|---|---|
| PB-18 | 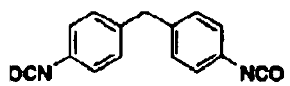 | | PPG1000 | 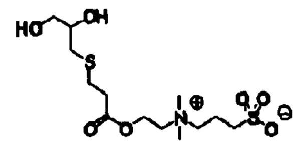 | | 49000 |
| | 50 | | 20 | 30 | | |
| PB-19 | 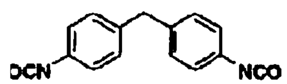 | | PPG1000 | 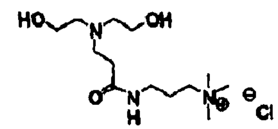 | | 53000 |
| | 50 | | 20 | 30 | | |
| PB-20 | 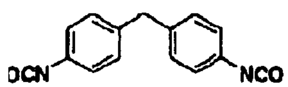 | | PPG1000 | 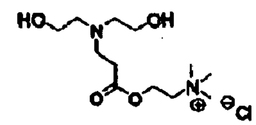 | | 55000 |
| | 50 | | 20 | 30 | | |
| PB-21 | 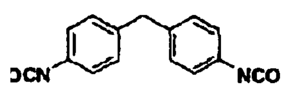 | | PPG1000 | 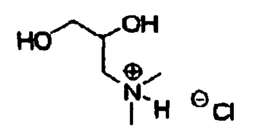 | | 67000 |
| | 50 | | 20 | 30 | | |
| PB-21b b | 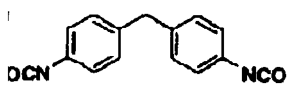 | | PPG1000 | 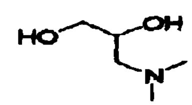 | | 67000 |
| | 50 | | 20 | 30 | | |

(continued)

| | Structure of Diisocyanate/Dicarboxylic Acid | | Structure of Diol/Diamine | | | Molecular Weight |
|---|---|---|---|---|---|---|
| PB-22 | 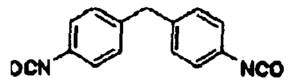 | | PPG1000 | 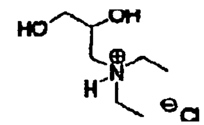 | | 79000 |
| | 50 | | 20 | 30 | | |
| PB-22b | 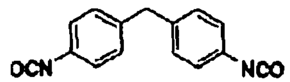 | | PPG1000 | 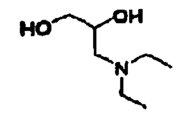 | | 79000 |
| | 50 | | 20 | 30 | | |
| PB-23 | 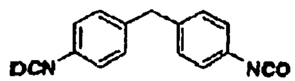 | | PPG1000 | 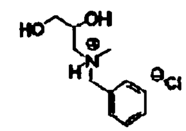 | | 77000 |
| | 50 | | 20 | 30 | | |
| PB-23b | 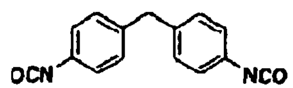 | | PPG1000 | 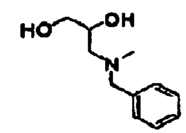 | | 77000 |
| | 50 | | 20 | 30 | | |
| PB-24 | 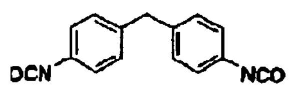 | | PPG 1000 | 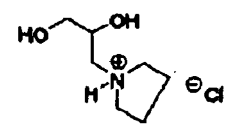 | | 76000 |
| | 50 | | 20 | 30 | | |
| PB-24b | 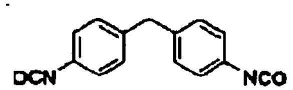 | | PPG1000 | 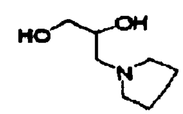 | | 76000 |
| | 50 | | 20 | 30 | | |

(continued)

| | Structure of Diisocyanate/Dicarboxylic Acid | | Structure of Diol/Diamine | | | Molecular Weight |
|---|---|---|---|---|---|---|
| PB-25 | 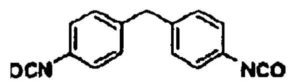 | | PPG1000 | 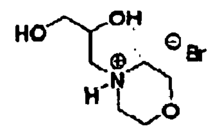 | | 80000 |
| | 50 | | 20 | 30 | | |
| PB-25b | 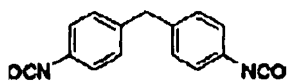 | | PPG1000 | 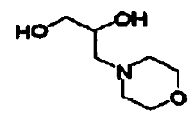 | | 80000 |
| | 50 | | 20 | 30 | | |
| PB-26 | 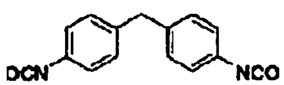 | | PPG1000 | 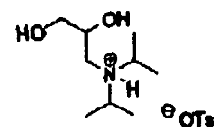 | | 56000 |
| | 50 | | 20 | 30 | | |
| PB-26b | 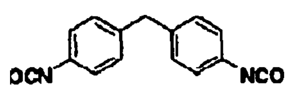 | | PPG1000 | 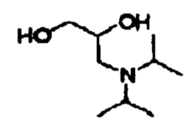 | | 56000 |
| | I 50 | | 20 | 30 | | |
| PB-27 | 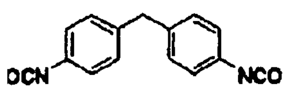 | | PPG1000 | 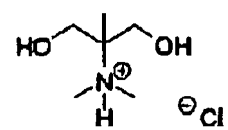 | | 90000 |
| | 50 | | 20 | 30 | | |
| PB-27b | 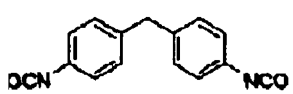 | | PPG1000 | 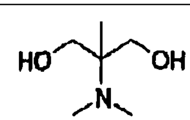 | | 90000 |
| | 50 | | 20 | 30 | | |

(continued)

| | Structure of Diisocyanate/Dicarboxylic Acid | | Structure of Diol/Diamine | | | Molecular Weight |
|---|---|---|---|---|---|---|
| PB-28 | 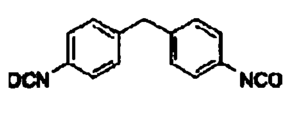 | | PPG1000 | 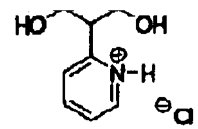 | | 78000 |
| | 50 | | 20 | 30 | | |
| PB-28b | 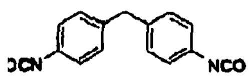 | | PPG1000 | 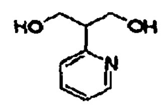 | | 78000 |
| | 50 | | 20 | 30 | | |
| PB-29 | 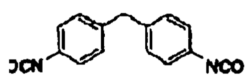 | 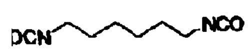 | PEG600 | 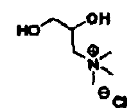 | | 68000 |
| | 30 | 20 | 15 | 35 | | |
| PB-30 | 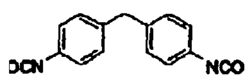 | 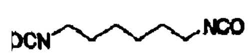 | PPG1000 | 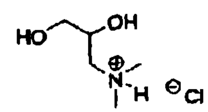 | 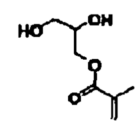 | 59000 |
| | 40 | 10 | 10 | 25 | 15 | |
| PB-30b | 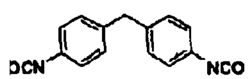 | 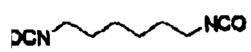 | PPG1000 | 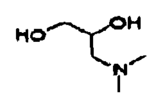 | 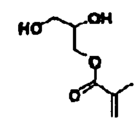 | 59000 |
| | 40 | 10 | 10 | 25 | 15 | |
| PB-31 | 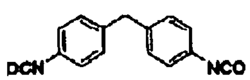 | 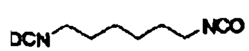 | PPG1000 | 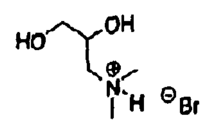 | 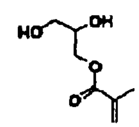 | 91000 |
| | 30 | 20 | 10 | 25 | 15 | |

(continued)

| | Structure of Diisocyanate/Dicarboxylic Acid | | Structure of Diol/Diamine | | | Molecular Weight |
|---|---|---|---|---|---|---|
| PB-31 b | 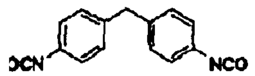 | 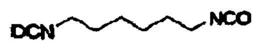 | PPG1000 | 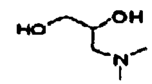 | 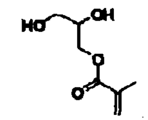 | 91000 |
| | 30 | 20 | 10 | 25 | 15 | |
| PB-32 | 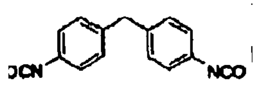 | 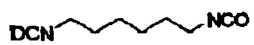 | PPG1000 | 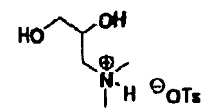 | 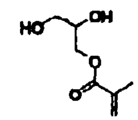 | 84000 |
| | 40 | 10 | 10 | 25 | 15 | |
| PB-32b | 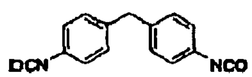 | 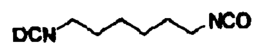 | PPG1000 | 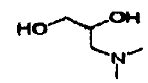 | 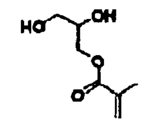 | 84000 |
| | 40 | 10 | 10 | 25 | 15 | |
| PB-33 | 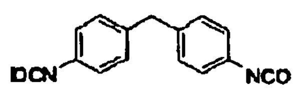 | 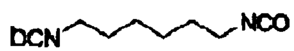 | PPG1000 | 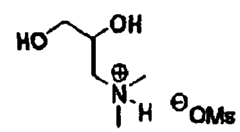 | 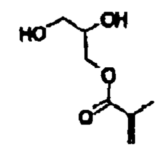 | 70000 |
| | 40 | 10 | 10 | 25 | 15 | |
| PB-33b | 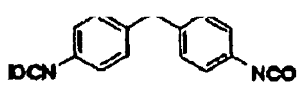 | 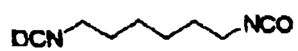 | PPG1000 | 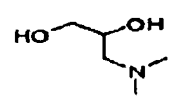 | 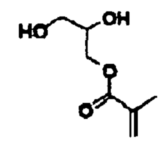 | 70000 |
| | 40 | 10 | 10 | 25 | 15 | |

(continued)

| | Structure of Diisocyanate/Dicarboxylic Acid | | Structure of Diol/Diamine | | | Molecular Weight |
|---|---|---|---|---|---|---|
| PB-34 | 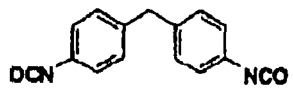 | 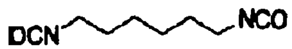 | PPG1000 | 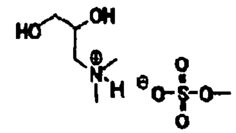 | 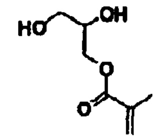 | 68000 |
| | 40 | 10 | 10 | 25 | 15 | |
| PB-34b | 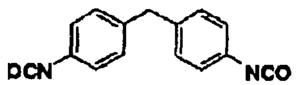 | 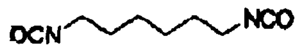 | PPG1000 | 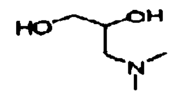 | 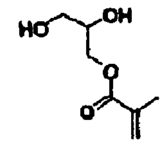 | 68000 |
| | 40 | 10 | 10 | 25 | 15 | |
| PB-35 | 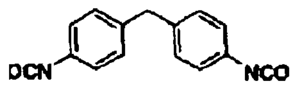 | 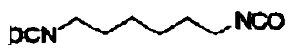 | PPG1000 | 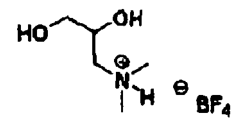 | 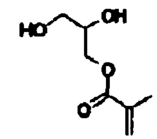 | 75000 |
| | 40 | 10 | 10 | 25 | 15 | |
| PB-35b | 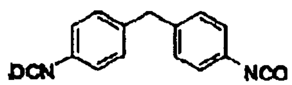 | 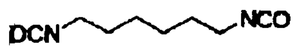 | PPG1000 | 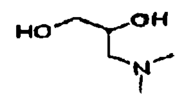 | 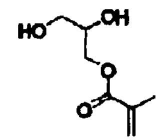 | 75000 |
| | 40 | 10 | 10 | 25 | 15 | |
| PB-36 | 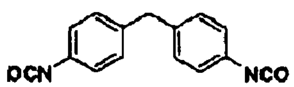 | 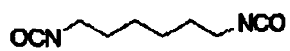 | PPG1000 | 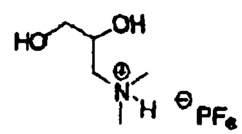 | 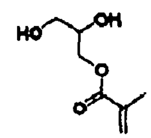 | 77000 |
| | 40 | 10 | 10 | 25 | 15 | |

(continued)

| | Structure of Diisocyanate/Dicarboxylic Acid | | Structure of Diol/Diamine | | | Molecular Weight |
|---|---|---|---|---|---|---|
| PB-36b | 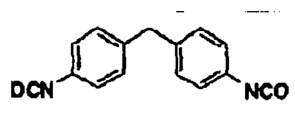 | 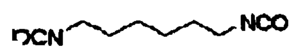 | PPG1000 | 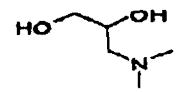 | 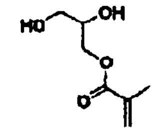 | 77000 |
| | 40 | 10 | 10 | 25 | 15 | |
| PB-37 | 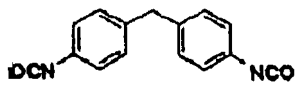 | 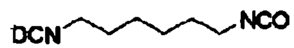 | PPG1000 | 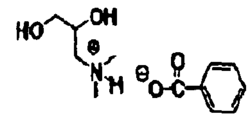 | 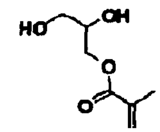 | 80000 |
| | 40 | 10 | 10 | 25 | 15 | |
| PB-37b | 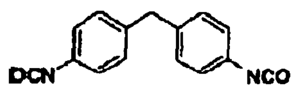 | 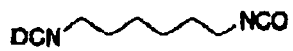 | PPG1000 | 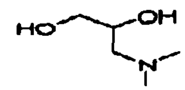 | 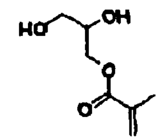 | 80000 |
| | 40 | 10 | 10 | 25 | 15 | |
| PB-38 | 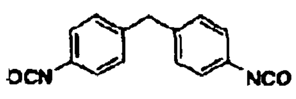 | 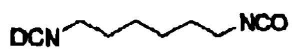 | PPG1000 | 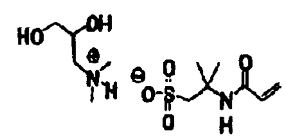 | 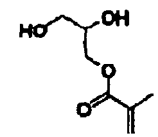 | 75000 |
| | 40 | 10 | 10 | 25 | 15 | |
| PB-38b | 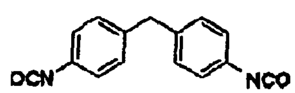 | 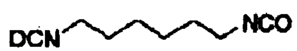 | | 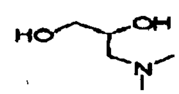 | 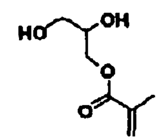 | 75000 |
| | 40 | 10 | 10 | 25 | 15 | |

(continued)

| | Structure of Diisocyanate/Dicarboxylic Acid | | Structure of Diol/Diamine | | | Molecular Weight |
|---|---|---|---|---|---|---|
| PB-39 | 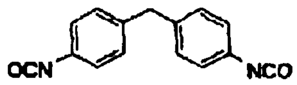 | 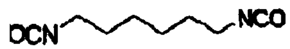 | PPG1000 | 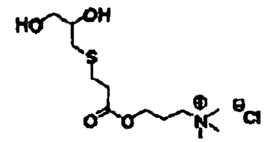 | 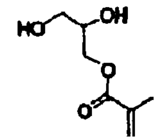 | 66000 |
| | 40 | 10 | 10 | 25 | 15 | |
| PB-40 | 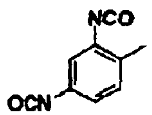 | 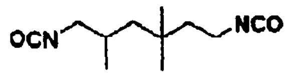 | PEG2000 | 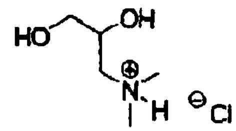 | 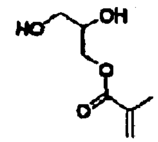 | 58000 |
| | 30 | 20 | 5 | 25 | 20 | |
| PB-40b | 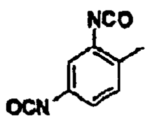 | 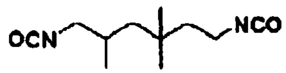 | PEG2000 | 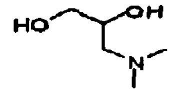 | 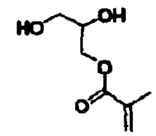 | 58000 |
| | 30 | 20 | 5 | 25 | 20 | |
| PB-41 | 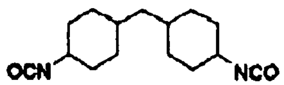 | 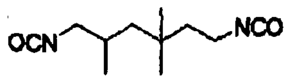 | PPG700 | 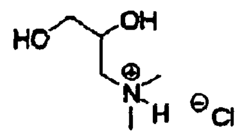 | 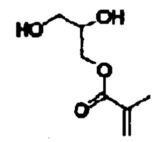 | 70000 |
| | 25 | 25 | 15 | 25 | 10 | |
| PB-41b | 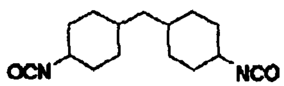 | 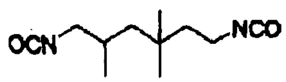 | PPG700 | 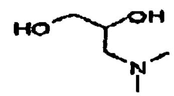 | 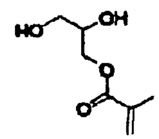 | 70000 |
| | 25 | 25 | 15 | 25 | 10 | |

(continued)

| | Structure of Diisocyanate/Dicarboxylic Acid | | Structure of Diol/Diamine | | | Molecular Weight |
|---|---|---|---|---|---|---|
| PB-42 | 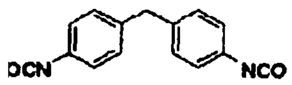 | 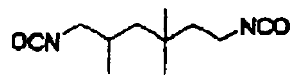 | 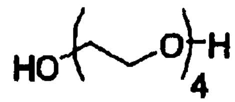 | 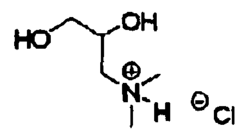 | 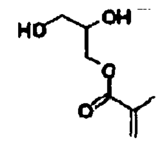 | 65000 |
| | 30 | 20 | 15 | 25 | 10 | |
| PB-42b | 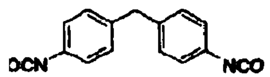 | 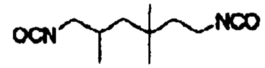 | 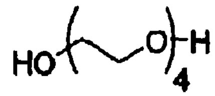 | 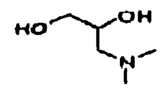 | 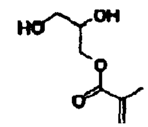 | 65000 |
| | 30 | 20 | 15 | 25 | 10 | |
| PB-43 | 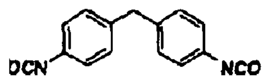 | 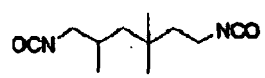 | 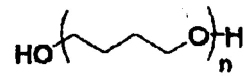 | 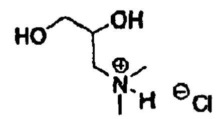 | 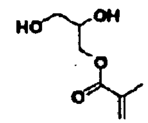 | 66000 |
| | 30 | 20 | 15 | 25 | 10 | |
| PB-43b | 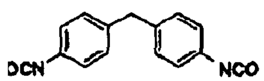 | 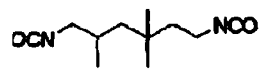 | 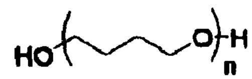 | 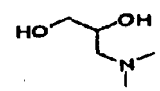 | 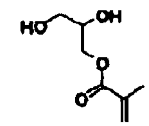 | 66000 |
| | 30 | 20 | 15 | 25 | 10 | |
| PB-44 | 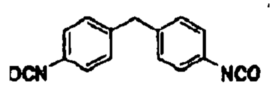 | 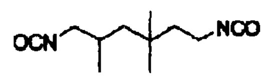 | 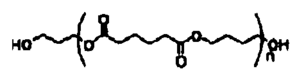 | 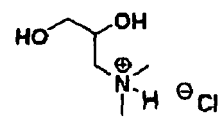 | 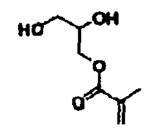 | 70000 |
| | 30 | 20 | 15 | 25 | 10 | |

(continued)

| | Structure of Diisocyanate/Dicarboxylic Acid | | Structure of Diol/Diamine | | | Molecular Weight |
|---|---|---|---|---|---|---|
| PB-44b | 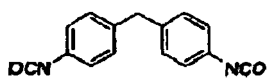 | 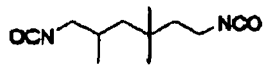 | 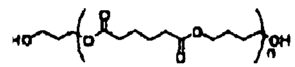 | 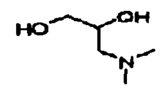 | 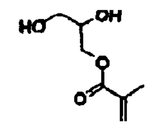 | 70000 |
| | 30 | 20 | 15 | 25 | 10 | |
| PB-45 | 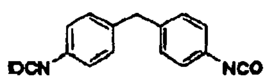 | 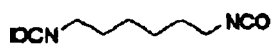 | 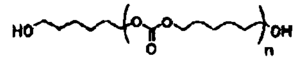 | 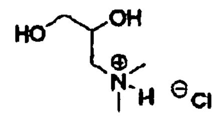 | 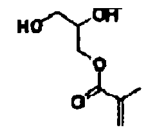 | 58000 |
| | 30 | 20 | 15 | 25 | 10 | |
| PB-45b | 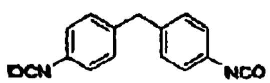 | 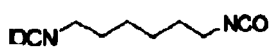 | 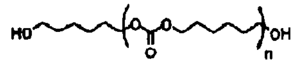 | 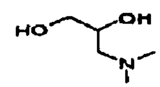 | 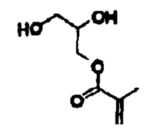 | 58000 |
| | 30 | 20 | 15 | 25 | 10 | |
| PB-46 | 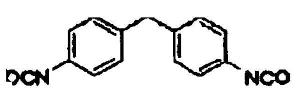 | 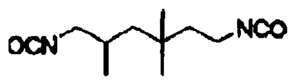 | 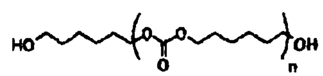 | 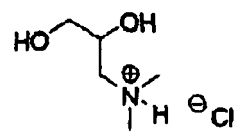 | 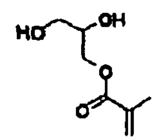 | 60000 |
| | 30 | 20 | 15 | 25 | 10 | |
| PB-46b | 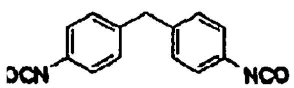 | 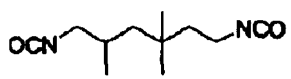 | 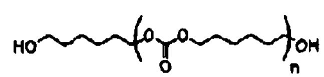 | 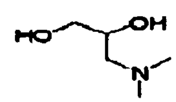 | 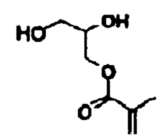 | 60000 |
| | 30 | 20 | 15 | 25 | 10 | |

(continued)

| | Structure of Diisocyanate/Dicarboxylic Acid | | Structure of Diol/Diamine | | | Molecular Weight |
|---|---|---|---|---|---|---|
| PB-47 | 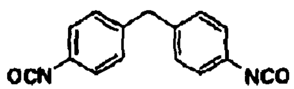 | | PPG1000 | 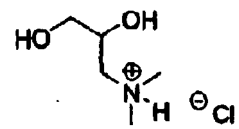 | 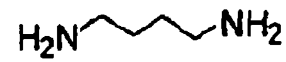 | 5000 |
| | 50 | | 10 | 35 | 5 | |
| PB-47b | 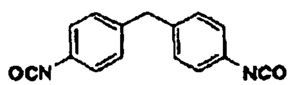 | | PPG1000 | 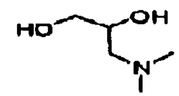 | 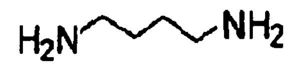 | 5000 |
| | 50 | | 10 | 35 | 5 | |
| PB-48 | 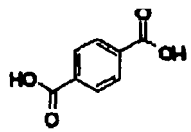 | | PEG200 | 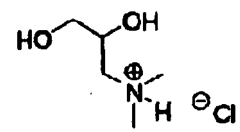 | | 63000 |
| | 50 | | 30 | 20 | | |
| PB-48b | 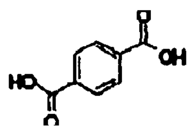 | | PEG200 | 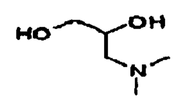 | | 63000 |
| | 50 | | 30 | 20 | | |
| PB-49 | 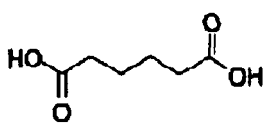 | | PEG200 | 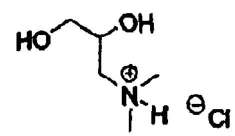 | | 62000 |
| | 50 | | 30 | 20 | | |

(continued)

| | Structure of Diisocyanate/Dicarboxylic Acid | | Structure of Diol/Diamine | | | Molecular Weight |
|---|---|---|---|---|---|---|
| PB-49b | 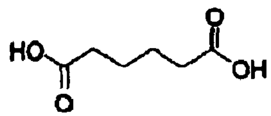 | | PEG200 | 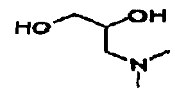 | | 62000 |
| | 50 | | 30 | 20 | | |
| PB-50 | 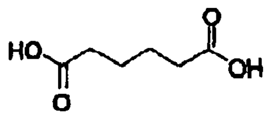 | | PEG200 | 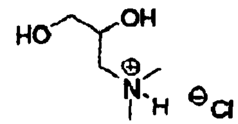 | 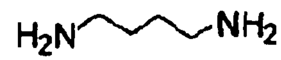 | 60000 |
| | 50 | | 25 | 20 | 5 | |
| PB-50b | 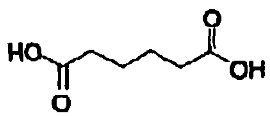 | | PEG200 | 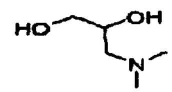 | 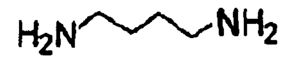 | 60000 |
| | 50 | | 25 | 20 | 5 | |

(Sensitizing dye)

The sensitizing dye for use in the photosensitive layer according to the invention can be appropriately selected according to the wavelength of light source used for the image exposure, the use or the like and is not particularly restricted. For instance, an infrared absorbing agent and a sensitizing dye absorbing light of 350 to 450 nm are preferably exemplified.

<Infrared absorbing agent>

The infrared absorbing agent is a component used for increasing sensitivity to an infrared laser. The infrared absorbing agent has a function of converting an infrared ray absorbed to heat. It is preferred that the infrared absorbing agent for use in the invention is a dye or pigment having an absorption maximum in a wavelength range of 760 to 1,200 nm.
As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.
Examples of preferable dye include cyanine dyes described, for example, in JP-A-58-125246, JP-A-59-84356 and JP-A-60-78787, methine dyes described, for example, in JP-A-58-173696, JP-A-58-181690 and JP-A-58-194595, naphthoquinone dyes described, for example, in JP-A-58-112793, JP-A-58-224793, JP-A-59-48187, JP-A-59-73996, JP-A-60-52940 and JP-A-60-63744, squarylium dyes described, for example, in JP-A-58-112792, and cyanine dyes described, for example, in British Patent 434,875.
Also, near infrared absorbing sensitizers described in U.S. Patent 5,156,938 are preferably used. Further, substituted arylbenzo(thio)pyrylium salts described in U.S. Patent 3,881,924, trimethinethiapyrylium salts described in JP-A-57-142645 (corresponding to U.S. Patent 4,327,169), pyrylium compounds described in JP-A-58-181051, JP-A-58-220143, JP-A-59-41363, JP-A-59-84248, JP-A-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-5-13514 and JP-B-5-19702 are also preferably used. Other preferable examples of the dye include near infrared absorbing dyes represented by formulae (I) and (II) in U.S. Patent 4,756,993.
Other preferable examples of the infrared absorbing dye include specific indolenine cyanine dyes described in JP-A-2002-278057 as illustrated below.

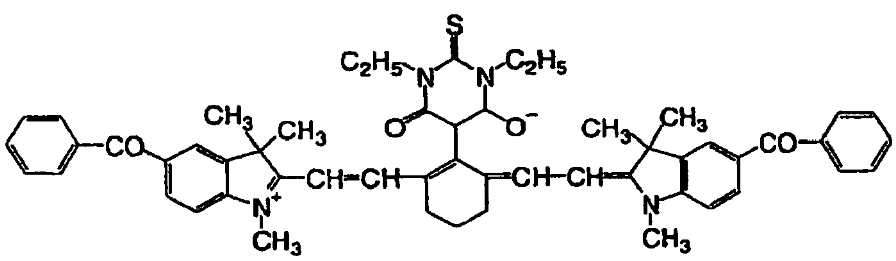

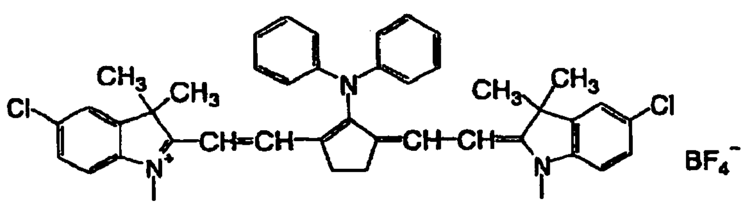

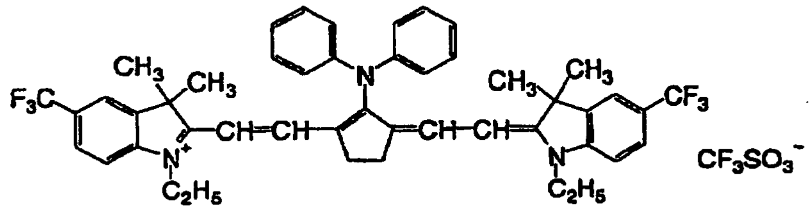

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As a particularly preferable example of the dye, a cyanine dye represented by the following formula (A) is exemplified. Formula (A):

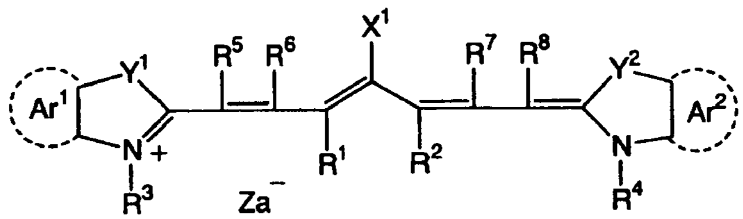

In formula (A), $X^1$ represents a hydrogen atom, a halogen atom, $-NPh_2$, $X^2$-$L^1$ or a group represented by formula (Ia) below. $X^2$ represents an oxygen atom, a nitrogen atom or a sulfur atom, $L^1$ represents a hydrocarbon group having from 1 to 12 carbon atoms, an aromatic cyclic group containing a hetero atom or a hydrocarbon group having from 1 to 12 carbon atoms and containing a hetero atom. The hetero atom indicates herein a nitrogen atom, a sulfur atom, an oxygen atom, a halogen atom or a selenium atom. $Xa^-$ has the same meaning as $Za^-$ defined hereinafter. $R^a$ represents a hydrogen atom, an alkyl group, an aryl group, an amino group or a halogen atom.

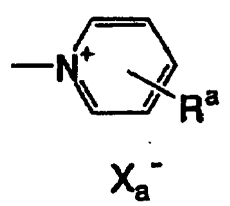

(Ia)

In formula (A), $R^1$ and $R^2$ each independently represents a hydrocarbon group having from 1 to 12 carbon atoms. In view of the preservation stability of a coating solution for photosensitive layer, it is preferred that $R^1$ and $R^2$ each represents a hydrocarbon group having two or more carbon atoms, and it is particularly preferred that $R^1$ and $R^2$ are combined with each other to form a 5-membered or 6-membered ring.

$Ar^1$ and $Ar^2$, which may be the same or different, each represents an aromatic hydrocarbon group. Preferable examples of the aromatic hydrocarbon group include a benzene ring group and a naphthalene ring group. Also, preferable examples of the substituent for the aromatic hydrocarbon group include a hydrocarbon group having 12 or less carbon atoms, a halogen atom and an alkoxy group having 12 or less carbon atoms. $Y^1$ and $Y^2$, which may be the same or different, each represents a sulfur atom or a dialkyhnethylene group having 12 or less carbon atoms. $R^3$ and $R^4$, which may be the same or different, each represents a hydrocarbon group having 20 or less carbon atoms. Preferable examples of the substituent for the hydrocarbon group include an alkoxy group having 12 or less carbon atoms, a carboxyl group and a sulfo group. $R^5$, $R^6$, $R^7$ and $R^8$, which may be the same or different, each represents a hydrogen atom or a hydrocarbon group having 12 or less carbon atoms. In view of the availability of raw materials, a hydrogen atom is preferred. $Za^-$ represents a counter anion. However, Za- is not necessary when the cyanine dye represented by formula (A) has an anionic substituent in the structure thereof and neutralization of charge is not needed. In view of the preservation stability of a coating solution for photosensitive layer, preferable examples of the counter ion for $Za^-$ include a halogen ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion.

Specific examples of the cyanine dye represented by formula (A), which can be preferably used in the invention, include those described in Paragraph Nos. [0017] to [0019] of JP-A-2001-133969.

Further, other particularly preferable examples include specific indolenine cyanine dyes described in JP-A-2002-278057 described above.

Examples of the pigment for use in the invention include commercially available pigments and pigments described in Colour Index (C.I.), Saishin Ganryo Binran (Handbook of the Newest Pigment) compiled by Pigment Technology Society of Japan (1977), Saishin Ganryo Oyou Giiutsu (Newest Application on Technologies for Pigments), CMC Publishing Co., Ltd. (1986) and Insatsu Ink Gijutsu (Printing Ink Technology), CMC Publishing Co., Ltd. (1984).

Examples of the pigment include black pigments, yellow pigments, orange pigments, brown pigments, red pigments, purple pigments, blue pigments, green pigments, fluorescent pigments, metal powder pigments and polymer-bonded dyes. Specific examples of usable pigment include insoluble azo pigments, azo lake pigments, condensed azo pigments, chelated azo pigments, phthalocyanine pigments, anthraquinone pigments, perylene and perynone pigments, thioindigo pigments, quinacridone pigments, dioxazine pigments, isoindolinone pigments, quinophthalone pigments, dying lake pigments, azine pigments, nitroso pigments, nitro pigments, natural pigments, fluorescent pigments, inorganic pigments and carbon black. Of the pigments, carbon black is preferred.

The pigment may be used without undergoing surface treatment or may be used after the surface treatment. For the surface treatment, a method of coating a resin or wax on the surface, a method of attaching a surfactant and a method of bonding a reactive substance (for example, a silane coupling agent, an epoxy compound or polyisocyanate) to the pigment surface. The surface treatment methods are described in Kinzoku Sekken no Seishitsu to Oyo (Properties and Applications of Metal Soap), Saiwai Shobo, Insatsu Ink Gijutsu (Printing Ink Technology), CMC Publishing Co., Ltd. (1984), and Saishin Ganryo Oyo Gijutsu (Newest Application on Technologies for Pigments), CMC Publishing Co., Ltd. (1986).

The pigment has a particle size of preferably from 0.01 to 10 $\mu$m, more preferably from 0.05 to 1 $\mu$m, particularly preferably from 0.1 to 1 $\mu$m. In the above-described range, good stability and good uniformity of the pigment dispersion in the photosensitive layer can be obtained.

For dispersing the pigment, a known dispersion technique for use in the production of ink or toner may be used. Examples of the dispersing machine include an ultrasonic dispersing machine, a sand mill, an attritor, a pearl mill, a super-mill, a ball mill, an impeller, a disperser, a KD mill, a colloid mill, a dynatron, a three roll mill and a pressure kneader. The dispersing machines are described in detail in Saishin Ganryo Oyo Gijutsu (Newest Application on Technologies for Pigments), CMC Publishing Co., Ltd. (1986). The infrared absorbing agent may be added to the photosensitive layer by being incorporated into a microcapsule.

The amount of the infrared absorbing agent added is so controlled that absorbance of the photosensitive layer at the maximum absorption wavelength in the wavelength region of 760 to 1,200 nm measured by reflection measurement is preferably in a range of 0.1 to 1.5, more preferably in a range of 0.2 to 1.2, still more preferably in a range of 0.3 to 1.0. In the above-described range, the polymerization reaction proceeds uniformly in the thickness direction of the photosensitive layer and good film strength of the image area and good adhesion property of the image area to a support are achieved.

The absorbance of the photosensitive layer can be controlled depending on the amount of the infrared absorbing agent added to the photosensitive layer and the thickness of the photosensitive layer. The measurement of the absorbance can be carried out in a conventional manner. The method for measurement includes, for example, a method of forming a photosensitive layer having a thickness determined appropriately in the range necessary for a lithographic printing plate on a reflective support, for example, an aluminum plate, and measuring reflection density of the photosensitive layer by an optical densitometer or a spectrophotometer according to a reflection method using an integrating sphere.

<Sensitizing dye absorbing light of 350 to 450 nm>

It is preferred that the sensitizing dye absorbing light of 350 to 450 nm is a sensitizing dye having an absorption maximum in a wavelength range of 350 to 450 nm. Such sensitizing dyes include, for example, merocyanine dyes represented by formula (I) shown below, benzopyranes or coumarins represented by formula (II) shown below, aromatic ketones represented by formula (III) shown below and anthracenes represented by formula (IV) shown below.

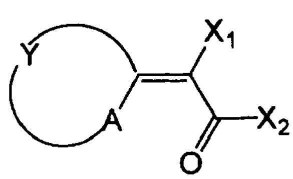

(I)

In formula (I), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

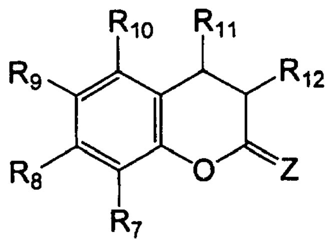
(II)

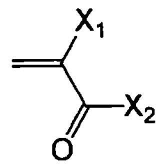
(I')

In formula (II), =Z represents an oxo group, a thioxo group, an imino group or an alkylydene group represented by partial structural formula (I') described above, $X_1$ and $X_2$ have the same meanings as defined in formula (I) respectively, and $R_7$ to $R_{12}$ each independently represents a monovalent non-metallic atomic group.

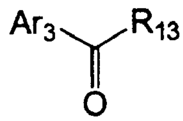
(III)

In formula (III), $Ar_3$ represents an aromatic group or a heteroaromatic group, and $R_{13}$ represents a monovalent non-metallic atomic group. $R_{13}$ preferably represents an aromatic group or a heteroaromatic group. Alternatively, $Ar_3$ and $R_{13}$ may be combined with each other to form a ring.

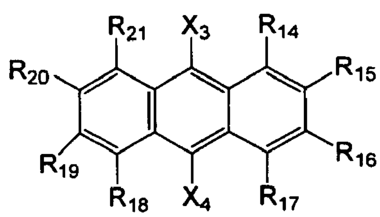
(IV)

In formula (IV), $X_3$, $X_4$ and $R_{14}$ to $R_{21}$ each independently represents a monovalent non-metallic atomic group. Preferably, $X_3$ and $X_4$ each independently represents an electron-donating group having a negative Hammett substituent constant.

In formulae (I) to (IV), preferable examples of the monovalent non-metallic atomic group represented by any one of $X_1$ to $X_4$ and $R_6$ to $R_{21}$ include a hydrogen atom, an alkyl group (for example, a methyl group, an ethyl group, a propyl group, a tert-butyl group or a cyclohexyl group), an aryl group (for example, a phenyl group or a biphenyl group), a heteroaryl group (for example, a group derived from thiophene, pyrrole or furan), an alkenyl group (for example, a vinyl group or a 1-propenyl group), an alkynyl group (for example, an ethynyl group or a 1-propynyl group), a halogen atom (for example, -F, -Br, -Cl or -I), a hydroxy group, an alkoxy group, an aryloxy group, an acyl group, a nitrogen atom-containing group (for example, an amino group, a cyano group, a nitro group, an N-alkylamino group or an N,N-diarylamino group), a sulfur atom-containing group (for example, a mercapto group, an alkylthio group, an arylthio group, an alkyldithio group, an aryldithio group, an alkylsulfinyl group, a sulfo group ($-SO_3H$) and its conjugated base group (a sulfonato group) or an alkoxysulfonyl group) and a phosphorus atom-containing group (for example, a phosphono group ($-PO_3H_2$) and its conjugated base group (a phosphonato group) or a dialkylphosphono group ($-PO_3(alkyl)_2$). Of the monovalent non-metallic atomic groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (I) includes, for example, a 5-membered, 6-membered or 7-membered, nitrogen-containing or sulfur-containing heterocyclic ring, and is preferably the 5-membered or 6-membered heterocyclic ring.

As the nitrogen-containing heterocyclic ring, those which are known to constitute basic nuclei in merocyanine

dyes described in L.G. Brooker et al, J. Am. Chem. Soc., Vol. 73, pp. 5326 to 5358 (1951) and references cited therein can be preferably used. Specific examples thereof include thiazoles, benzothiazoles, naphthothiazoles, thianaphtheno-7',6',4,5-thiazoles, oxazoles, benzoxazoles, naphthoxazoles, selenazoles, benzoselenazoles, naphthoselenazoles, thiazolines, quinolines, isoquinolines, benzimidazoles, 3,3-dialkylindolenines and pyridines. Examples of the sulfur-containing heterocyclic ring include dithiol partial structures in dyes described in JP-A-3-296759. Specific examples thereof include benzodithiols, naphthodithiols and dithiols.

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolylidene group.

Further, sensitizing dyes represented by formulae (V) to (XI) can also be used.

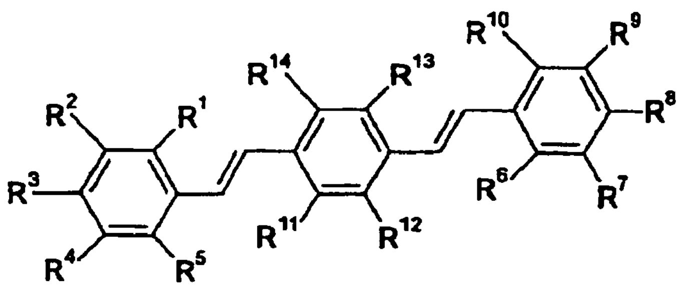

(V)

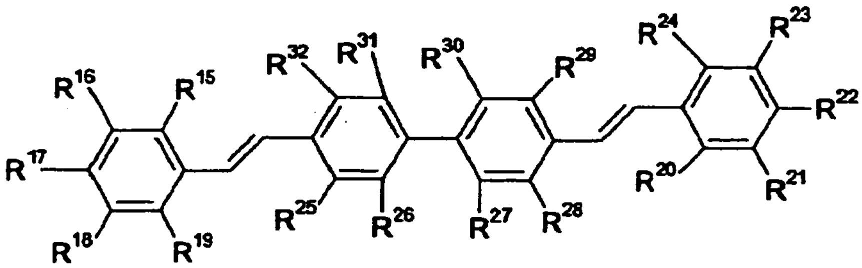

(VI)

In formula (V), $R^1$ to $R^{14}$ each independently represents a hydrogen atom, an alkyl group, an alkoxy group, a cyano group or a halogen atom, provided that at least one of $R^1$ to $R^{10}$ represents an alkoxy group having 2 or more carbon atoms.

In formula (VI), $R^{15}$ to $R^{32}$ each independently represents a hydrogen atom, an alkyl group, an alkoxy group, a cyano group or a halogen atom, provided that at least one of $R^{15}$ to $R^{24}$ represents an alkoxy group having 2 or more carbon atoms.

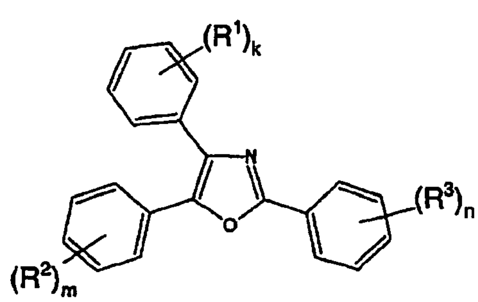

(VII)

In formula (VII), $R^1$, $R^2$ and $R^3$ each independently represents a halogen atom, an alkyl group, an aryl group,

an aralkyl group, an $-NR^4R^5$ group or an $-OR^6$ group, $R^4$, $R^5$ and $R^6$ each independently represents a hydrogen atom, an alkyl group, an aryl group or an aralkyl group, and k, m and n each represents an integer of 0 to 5.

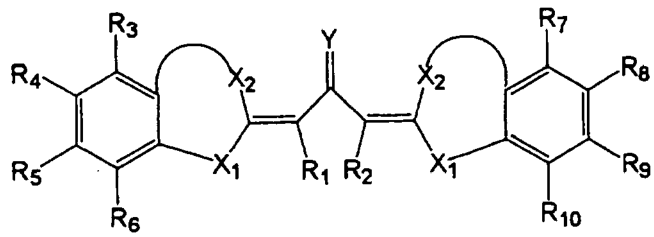

(VIII)

In formula (VIII), $X_1$ and $X_2$ each independently represents an oxygen atom, a sulfur atom, $-CR_{11}R_{12}-$ or $NR_{13}-$, provided that at least one of $X_1$ and $X_2$ represents an oxygen atom, a sulfur atom or $-NR_{13}-$. Y represents an oxygen atom, a sulfur atom or $=NR_{14}$. $R_1$ to $R_{14}$ each independently represents a hydrogen atom or a monovalent non-metallic atomic group. Alternatively, $R_1$ to $R_{14}$ may be combined with each other to from an aliphatic or aromatic ring.

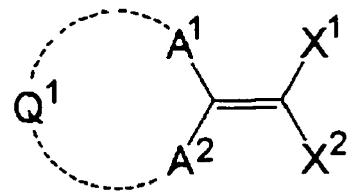

(IX)

In formula (IX), $A^1$ and $A^2$ each represents a carbon atom or a hetero atom. $Q^1$ represents a non-metallic atomic group necessary for forming a hetero ring together with $A^1$, $A^2$ and the carbon atom adjacent thereto. $X^1$ and $X^2$ each independently represents a cyano group or a substituted carbonyl group, or $X^1$ and $X^2$ may be combined with each other to form a ring.

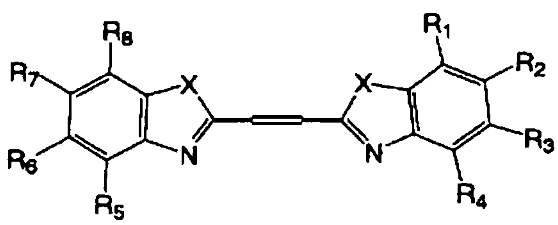

(X)

In formula (X), X each represents an oxygen atom or a sulfur atom, and $R_1$, $R_2$, $R_3$, $R_4$, $R_5$, $R_6$, $R_7$ and $R_8$ each independently represents a hydrogen atom or a monovalent non-metallic atomic group.

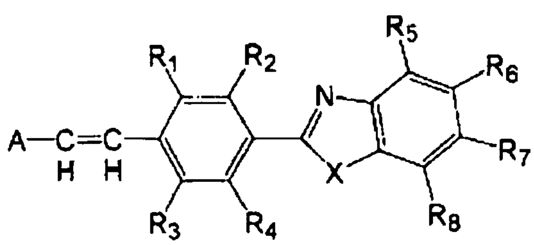

(XI)

In formula (XI), X represents an oxygen atom or a sulfur atom, $R_1$, $R_2$, $R_3$, $R_4$, $R_5$, $R_6$, $R_7$ and $R_8$ each independently represents a hydrogen atom or a monovalent non-metallic atomic group, and A represents an aryl group or heteroaryl group having 20 or less carbon atoms.

Of the sensitizing dyes having an absorption maximum in a wavelength range of 350 to 450 nm, dyes represented

by formula (XII) shown below are more preferable in view of high sensitivity.

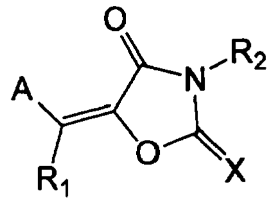

(XII)

In formula (XII), A represents an aromatic cyclic group or a heterocyclic group, X represents an oxygen atom, a sulfur atom or =N-$R_3$, and $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (XII) will be described in more detail below. $R_1$, $R_2$ and $R_3$ each independently represents a monovalent non-metallic atomic group, preferably an alkyl group, an alkenyl group, an aryl group, an aromatic heterocyclic residue, an alkoxy group, an alkylthio group, a hydroxy group or a halogen atom.

Preferable examples of $R_1$, $R_2$ and $R_3$ are specifically described below.

The alkyl group preferably represented by any one of $R_1$, $R_2$ and $R_3$ includes, for example, a straight chain, branched or cyclic alkyl group having 20 or less carbon atoms, and specific examples thereof include a methyl group, an ethyl group, a propyl group, a tert-butyl group and an isopentyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group preferably represented by any one of $R_1$, $R_2$ and $R_3$, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, an acyl group, a nitrogen atom-containing group (for example, a cyano group, a nitro group, an amino group, an N-alkylamino group or an N,N-diarylamino group), a sulfur atom-containing group (for example, a mercapto group, an alkylthio group, an arylthio group, an alkyldithio group, an aryldithio group, an alkylsulfinyl group, a sulfo group (-$SO_3H$) and its conjugated base group (a sulfonato group) or an alkoxysulfonyl group), a phosphorus atom-containing group (for example, a phosphono group (-$PO_3H_2$) and its conjugated base group (a phosphonato group) or a dialkylphosphono group (-$PO_3(alkyl)_2$), an aryl group, a heteroaryl group, an alkenyl group and an alkynyl group.

Examples of the alkyl group in the substituent include those described for the alkyl group above. Specific examples of the aryl group in the substituent include a phenyl group, a methoxyphenyl group and a chlorophenyl group.

Examples of the heteroaryl group in the substituent include a monocyclic or polycyclic aromatic cyclic group containing at least one of a nitrogen atom, an oxygen atom and a sulfur atom. Preferable examples of the heteroaryl group include a thienyl group, a furyl group, a pyranyl group, a carbazolyl group and an acridyl group. The heteroaryl group may be benzo-fused or may have a substituent.

Examples of the alkenyl group in the substituent include a vinyl group and a 1-propenyl group. Examples of the alkynyl group in the substituent include an ethynyl group, a 1-propynyl group and a 1-butynyl group. Examples of $G_1$ in the acyl group ($G_1$CO-) include a hydrogen atom, the above-described alkyl group and the aryl group described below.

Of the substituents for the substituted alkyl group, a halogen atom (for example, -F, -Br, -Cl or -I), an alkoxy group, an aryloxy group, an alkylthio group, an arylthio group, an aryl group, an alkenyl group, a nitrogen atom-containing group (for example, an N-alkylamino group or an N,N-diarylamino group), a sulfur atom-containing group (for example, an alkylsulfinyl group, a sulfo group (-$SO_3H$) and its conjugated base group (a sulfonato group) or an alkoxysulfonyl group) and a phosphorus atom-containing group (for example, a phosphono group (-$PO_3H_2$) and its conjugated base group (a phosphonato group) or a dialkylphosphono group (-$PO_3(alkyl)_2$).

On the other hand, as an alkylene group in the substituted alkyl group, a divalent residue resulting from elimination of any one of hydrogen atoms on the above-described alkyl group having 20 or less carbon atoms can be enumerated. Preferable examples of the alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of $R_1$, $R_2$ and $R_3$, which is obtained by combining the above-described substituent with the alkylene group, include a chloromethyl group, a trifluoromethyl group, a methoxymethyl group, a phenoxymethyl group, a methylthiomethyl group, a diethylaminopropyl group, a morpholinopropyl group, an acetyloxymethyl group, an N-cyclohexylcarbamoyloxyethyl group, a 2-oxoethyl group, a carboxypropyl group, a methoxycarbonylethyl group, a chlorophenoxycarbonylmethyl group, a carbamoylmethyl group, an N-methylcarbamoylethyl group, a phosphonobutyl group and a benzyl group.

The alkenyl group preferably represented by any one of $R_1$, $R_2$ and $R_3$ includes, for example, a straight chain, branched or cyclic alkenyl group having 20 or less carbon atoms, and specific examples thereof include a vinyl group, a 1-propenyl group and 2-propenyl group.

The substituted alkenyl group preferably represented by any one of $R_1$, $R_2$ and $R_3$ includes alkenyl groups having a monovalent non-metallic atomic group exclusive of a hydrogen atom as a substituent on the carbon atom of the alkenyl group described above. Preferable examples of the substituent include the above-described alkyl groups, substituted alkyl groups and the substituents described for the substituted alkyl group. Specific examples of the preferable substituted alkenyl group include a styryl group and a cinnamyl group.

The aryl group preferably represented by any one of $R_1$, $R_2$ and $R_3$ includes, for example, a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group, and a phenyl group and a naphthyl group are preferable.

The substituted aryl group preferably represented by any one of $R_1$, $R_2$ and $R_3$ include aryl groups having a monovalent non-metallic atomic group exclusive of a hydrogen atom as a substituent on the ring-forming carbon atom of the aryl group described above. Preferable examples of the substituent include the above-described alkyl groups, substituted alkyl groups and the substituents described for the substituted alkyl group. Specific examples of the preferable substituted aryl group include a biphenyl group, a tolyl group, a chlorophenyl group, a hydroxyphenyl group, a methoxyphenyl group, a methylthiophenyl, an ethylaminophenyl, a benzoyloxyphenyl group, an acetylaminophenyl group, a carboxyphenyl group, a sulfophenyl group, a sulfonatophenyl group, a phosphonophenyl group and a phosphonatophenyl group.

The aromatic heterocyclic residue preferably represented by any one of $R_1$, $R_2$ and $R_3$ include a monocyclic or polycyclic aromatic heterocyclic group containing at least one of a nitrogen atom, an oxygen atom and a sulfur atom. Examples of the aromatic heterocyclic residue include groups derived from hetero rings, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phenarsazine or furazane. The aromatic heterocyclic residue may be benzo-fused.

The substituted aromatic heterocyclic residue preferably represented by any one of $R_1$, $R_2$ and $R_3$ include aromatic heterocyclic residues having a monovalent non-metallic atomic group exclusive of a hydrogen atom as a substituent on the ring-forming atom of the aromatic heterocyclic residue described above. Preferable examples of the substituent include the above-described alkyl groups, substituted alkyl groups and the substituents described for the substituted alkyl group.

The alkyl groups in the alkoxy group and alkylthio group preferably represented by any one of $R_1$, $R_2$ and $R_3$ are same as those described above with respect to the alkyl group preferably represented by any one of $R_1$, $R_2$ and $R_3$.

The substituted alkyl group in the substituted alkoxy group and substituted alkylthio group preferably represented by any one of $R_1$, $R_2$ and $R_3$ are same as those described above with respect to the substituted alkyl group preferably represented by any one of $R_1$, $R_2$ and $R_3$.

The aromatic cyclic group and heterocyclic group represented by A in formula (XII) include those described above with respect to the aryl group and aromatic heterocyclic residue represented by any one of $R_1$, $R_2$ and $R_3$, respectively.

The sensitizing dye represented by formula (XII) is obtained by a condensation reaction of the above-described acidic nucleus or an active methyl group-containing acidic nucleus with an aromatic ring or hetero ring. Specifically, it can be synthesized with reference to the description of JP-B-59-28329.

Preferable specific examples of the compound represented by formula (XII) are set forth below, but the invention should not be construed as being limited thereto. Further, when isomers with respect to a double bond connecting an acidic nucleus and a basic nucleus are present in each of the compounds, the invention should not be construed as being limited to any one of the isomers.

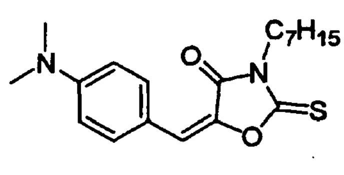

(D1)

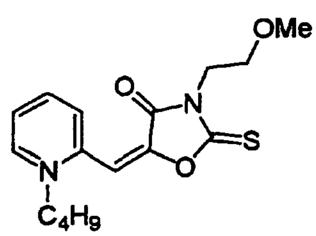

(D2)

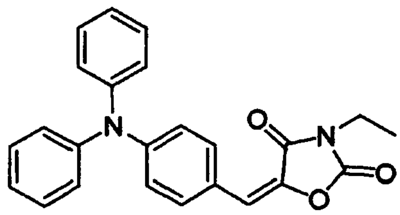

(D3)

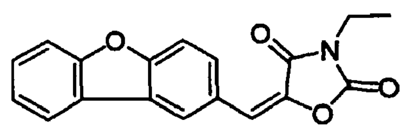

(D4)

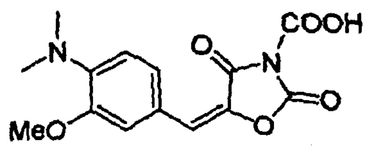

(D5)

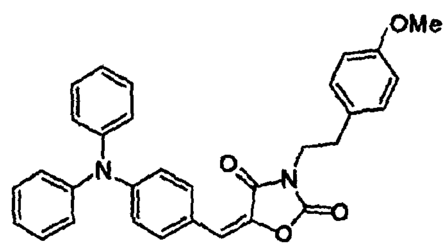

(D6)

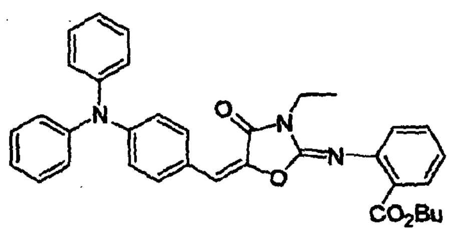

(D7)

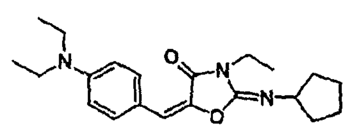

(D8)

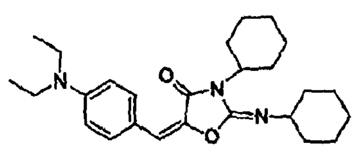

(D9)

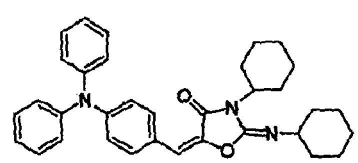

(D10)

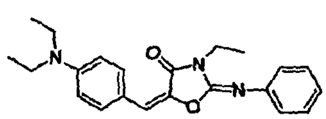

(D11)

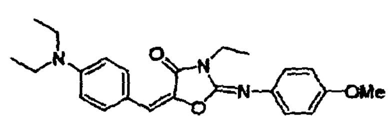

(D12)

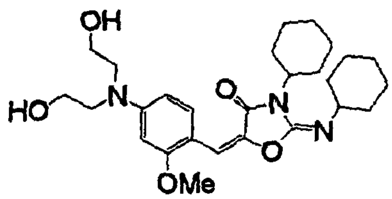

(D13)

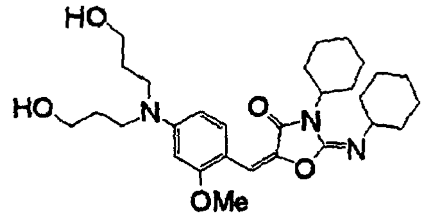

(D14)

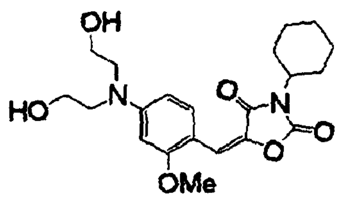

(D15)

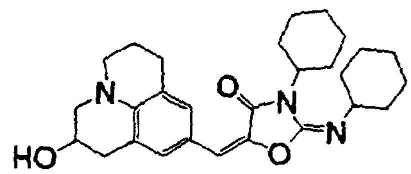

(D16)

Details of the method of using the sensitizing dye, for example, the structure thereof, individual or combination use or the amount thereof added, can be appropriately determined in accordance with the characteristic design of the lithographic printing plate precursor.

For instance, when two or more sensitizing dyes are used in combination, the compatibility thereof in the composition constituting the photosensitive layer can be increased. For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small. Also, the use of such a dye is advantageous in view of physical properties of the photosensitive layer. Since the photosensitivity and resolution of the photosensitive layer and the physical properties of the exposed area of the photosensitive layer are greatly influenced by the absorbance of sensitizing dye at the wavelength of light source, the amount of the sensitizing dye added is appropriately determined by taking account of these factors.

However, for the purpose of curing a layer having a large thickness, for example, of 5 $\mu$m or more, low absorbance is sometimes rather effective for increasing the curing degree. In the case of a lithographic printing plate precursor having the photosensitive of a relatively small thickness, the amount of the sensitizing dye added is so controlled that absorbance of the photosensitive layer at the maximum absorption wavelength measured by reflection measurement is preferably in a range of 0.1 to 1.5, more preferably in a range of 0.2 to 1.2, still more preferably in a range of 0.3 to 1.0. Ordinarily, the amount of the sensitizing dye added is preferably from 0.05 to 30 parts by weight, more preferably from 0.1 to 20 parts by weight, still more preferably from 0.2 to 10 parts by weight, per 100 parts by weight of the total solid content of the photosensitive layer.

(Radical polymerization initiator)

The radical polymerization initiator (hereinafter also simply referred to as a polymerization initiator) for use in the photosensitive layer according to the invention is a compound which generates a radical with light energy or heat energy to initiate or accelerate polymerization of a compound having a polymerizable unsaturated group. The polymerization initiator is appropriately selected to use, for example, from known radical polymerization initiators and compounds containing a bond having small bond dissociation energy.

The polymerization initiators include, for example, organic halogen compounds, carbonyl compounds, organic peroxides, azo compounds, metallocene compounds, hexaarylbiimidazole compounds, organic boron compounds, disulfone compounds, oxime ester compounds and onium salt compounds.

The organic halogen compounds described above specifically include, for example, compounds described in Wakabayashi et al., Bull. Chem. Soc. Japan, 42, 2924 (1969), U.S. Patent 3,905,815, JP-B-46-4605, JP-A-48-36281,

JP-A-53-133428, JP-A-55-32070, JP-A-60-239736, JP-A-61-169835, JP-A-61-169837, JP-A-62-58241, JP-A-62-212401, JP-A-63-70243, JP-A-63-298339 and M. P. Hutt, Journal of Heterocyclic Chemistry, 1, No. 3 (1970). Among them, oxazole compounds and s-triazine compounds each substituted with a trihalomethyl group are preferable.

More preferably, s-triazine derivatives in which at least one mono-, di- or tri-halogen substituted methyl group is connected to the s-triazine ring and oxazole derivatives in which at least one mono-, di- or tri-halogen substituted methyl group is connected to the oxazole ring are exemplified. Specific examples thereof include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl-4,6-bis(trichloromethyl)-s-triazine, 2-(p-isopropyloxystyryl-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine and compounds shown below.

(I)-1

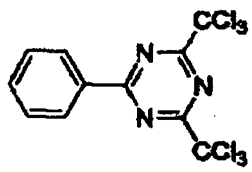

(I)-2

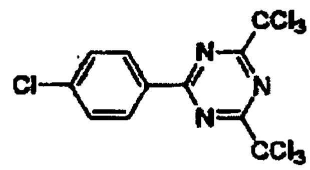

(I)-3

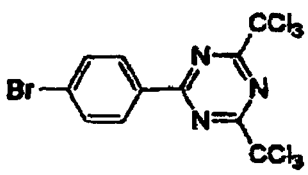

(I)-4

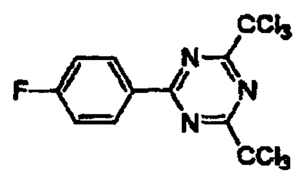

(I)-5

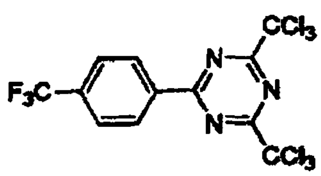

(I)-6

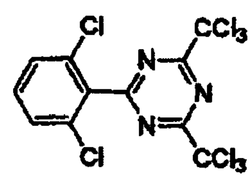

(I)-7

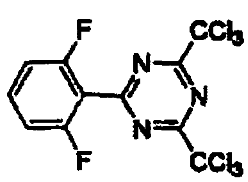

(I)-8

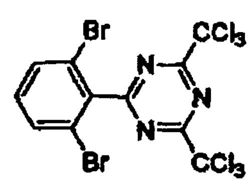

(I)-9

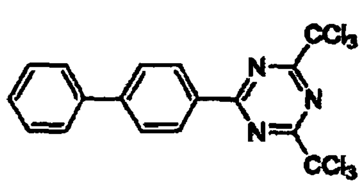

(I)-10

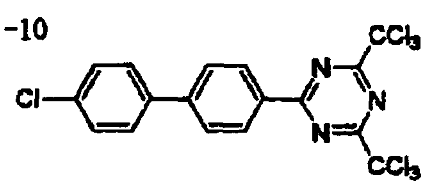

(I)-11

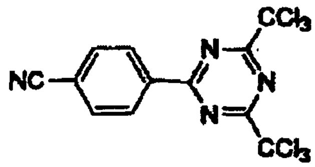

(I)-12

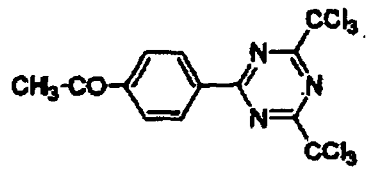

(I)-13

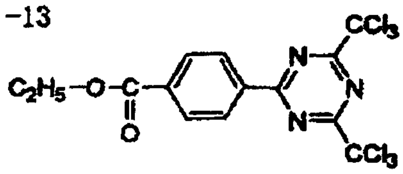

(I)-14

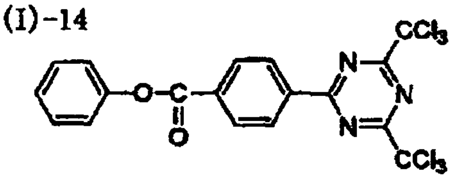

(I)-15

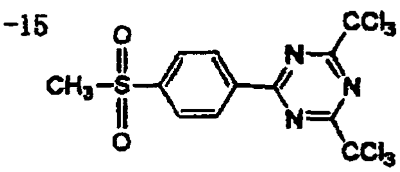

(I)-16

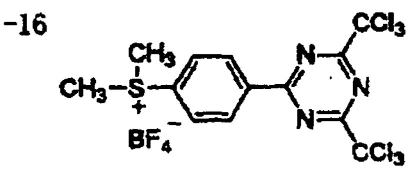

(I)-17

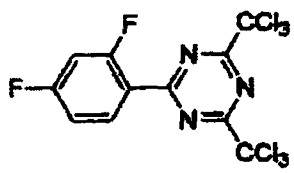

(I)-18

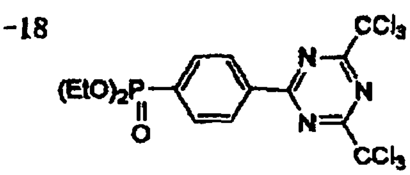

(I)-19

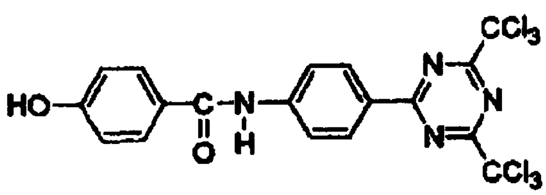

(I)-20

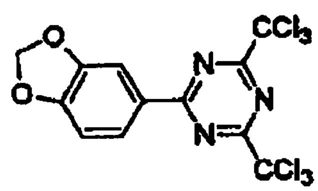

(I)-21

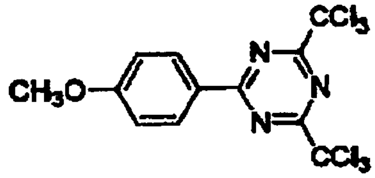

(I)-22

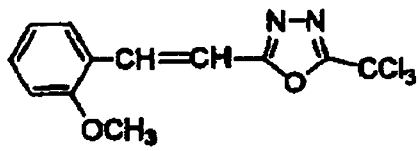

(I)-23

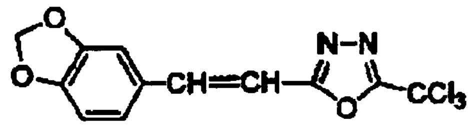

(I)-24

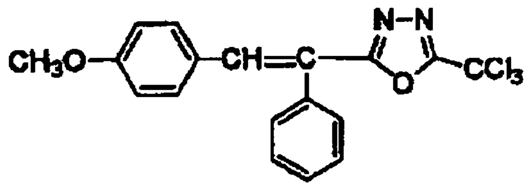

(I)-25

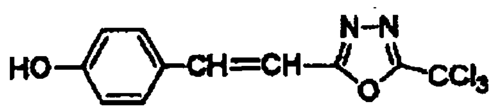

(I)-26

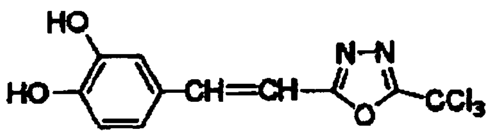

(I)-27

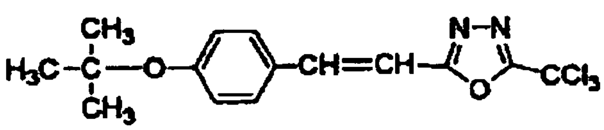

The carbonyl compounds described above include, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propane or 1,1,1,-trichloromethyl-(p-butylphenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, and benzoic acid ester derivatives, e.g., ethyl p-dimethylaminobenzoate or ethyl p-diethylaminobenzoate.

The azo compounds described above include, for example, azo compounds described in JP-A-8-108621.

The organic peroxides described above include, for example, trimethylcyclohexanone peroxide, acetylacetone

peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butylhydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, peroxy succinic acid, benzoyl peroxide, 2,4-dichlorobenzoyl peroxide, diisopropylperoxy dicarbonate, di-2-ethylhexylperoxy dicarbonate, di-2-ethoxyethylperoxy dicarbonate, dimethoxyisopropylperoxy dicarbonate, di(3-methyl-3-methoxybutyl)peroxy dicarbonate, tert-butylperoxy acetate, tert-butylperoxy pivalate, tert-butylperoxy neodecanoate, tert-butylperoxy octanoate, tert-butylperoxy laurate, tersyl carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropylcumylperoxycarbonyl)benzophenone, carbonyl di(tert-butylperoxydihydrogen diphthalate) and carbonyl di(tert-hexylperoxydihydrogen diphthalate).

The metallocene compounds described above include, for example, various titanocene compounds described in JP-A-59-152396, JP-A-61-151197, JP-A-63-41484, JP-A-2-249, JP-A-2-4705 and JP-A-5-83588, for example, dicyclopentadienyl-Ti-bisphenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl, dimethylcyclopentadienyl-Ti-bis-2,3,4,5,6-pentafluorophen-1-yl, or bis(cyclopentadienyl)-bis(2,6-difluoro-3-(pyr-1-yl)phenyl) titanium and iron-arene complexes described in JP-A-1-304453 and JP-A-1-152109.

The hexaarylbiimidazole compounds described above include, for example, various compounds described in JP-B-6-29285 and U.S. Patents 3,479,185, 4,311,783 and 4,622,286, specifically, for example, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The organic boron compounds described above include, for example, organic boric acid salts described in JP-A-62-143044, JP-A-62-150242, JP-A-9-188685, JP-A-9-188686, JP-A-9-188710, JP-A-2000-131837, JP-A-2002-107916, Japanese Patent 2764769, JP-A-2002-116539 and Martin Kunz, Rad Tech '98, Proceeding, April 19-22 (1998), Chicago, organic boron sulfonium complexes or organic boron oxosulfonium complexes described in JP-A-6-157623, JP-A-6-175564 and JP-A-6-175561, organic boron iodonium complexes described in JP-A-6-175554 and JP-A-6-175553, organic boron phosphonium complexes described in JP-A-9-188710, and organic boron transition metal coordination complexes described in JP-A-6-348011, JP-A-7-128785, JP-A-7-140589, JP-A-7-306527 and JP-A-7-292014.

The disulfone compounds described above include, for example, compounds described in JP-A-61-166544 and JP-A-2002-328465.

The oxime ester compounds described above include, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068. Specific examples thereof include compounds represented by the following structural formulae:

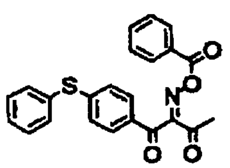
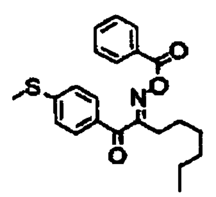
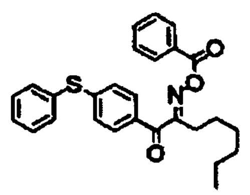
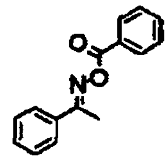
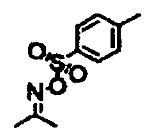

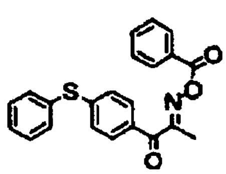
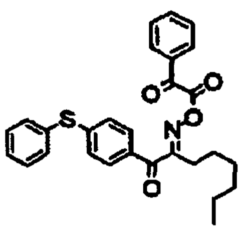
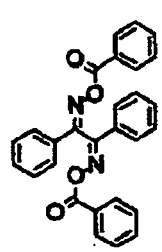
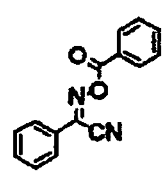
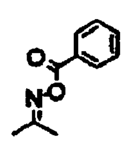

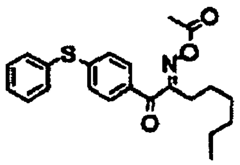
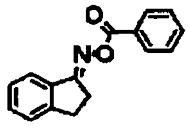
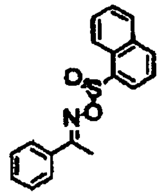
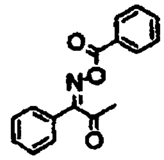
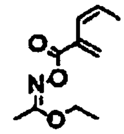

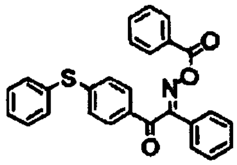
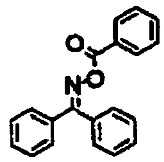
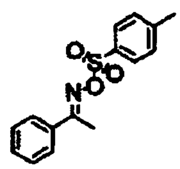
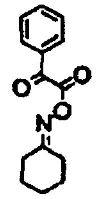
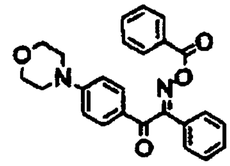

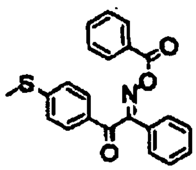
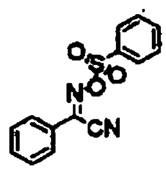

The onium salt compounds described above include onium salts, for example, diazonium salts described in S. I. Schlesinger, Photogr. Sci. Eng., 18, 387 (1974) and T. S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827 and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh, Proc. Conf. Rad. Curing ASIA, p. 478, Tokyo, Oct. (1988).

In the invention, the onium salt compound functions not as an acid generator, but as an ionic radical polymerization initiator.

The onium salt compounds preferably used include onium salts represented by the following formulae (RI-I) to (RI-III):

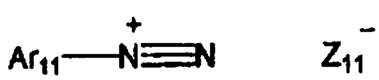
(RI-I)

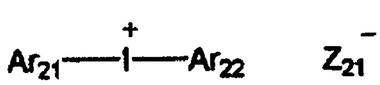
(RI-II)

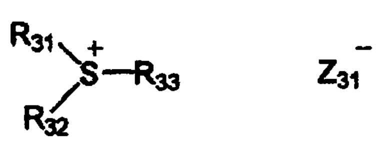
(RI-III)

In formula (RI-I), $Ar_{11}$ represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{11}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion and a sulfate ion. Among them, a perchlorate ion, a hexafluorophosphate ion, a tetrafluoroborate ion, a sulfonate ion and a sulfinate ion are preferred in view of stability.

In the formula (RI-II), $Ar_{21}$ and $Ar_{22}$ each independently represents an aryl group having 20 or less carbon atoms, which may have 1 to 6 substituents. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{21}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity.

In the formula (RI-III), $R_{31}$, $R_{32}$ and $R_{33}$ each independently represents an aryl group having 20 or less carbon atoms, which may have 1 to 6 substituents, an alkyl group, an alkenyl group or an alkynyl group. Among them, the aryl group is preferred in view of reactivity and stability. Preferable examples of the substituent include an alkyl group having 12 or less carbon atoms, an alkenyl group having 12 or less carbon atoms, an alkynyl group having 12 or less carbon atoms, an aryl group having 12 or less carbon atoms, an alkoxy group having 12 or less carbon atoms, an aryloxy group having 12 or less carbon atoms, a halogen atom, an alkylamino group having 12 or less carbon atoms, a dialkylimino group having 12 or less carbon atoms, an alkylamido group or arylamido group having 12 or less carbon atoms, a carbonyl group, a carboxyl group, a cyano group, a sulfonyl group, an thioalkyl group having 12 or less carbon atoms and an thioaryl group having 12 or less carbon atoms. $Z_{31}^-$ represents a monovalent anion. Specific examples of the monovalent anion include a halogen ion, a perchlorate ion, a hexafluorophosphate ion, a tetrafluoroborate ion, a sulfonate ion, a sulfinate ion, a thiosulfonate ion, a sulfate ion and a carboxylate ion. Among them, a perchlorate ion, a hexafluorophosphate ion, a tetrafluoroborate ion, a sulfonate ion, a sulfinate ion and a carboxylate ion are preferred in view of stability and reactivity. Carboxylate ions described in JP-A-2001-343742 are more preferable, and carboxylate ions described in JP-A-2002-148790 are particularly preferable.

Specific examples of the onium salt represented by any on of formulae (RI-I) to (RI-III) are set forth below, but the invention should not be construed as being limited thereto.

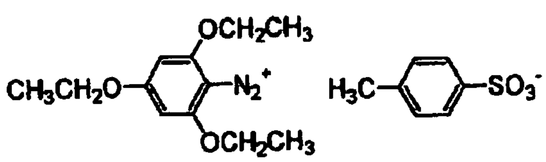

(N-1)

$PF_6^-$ (N-2)

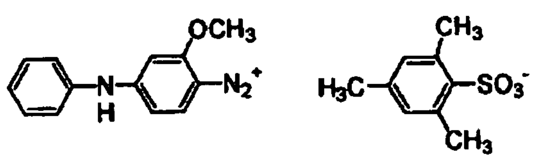

(N-3)

$ClO_4^-$ (N-4)

$PF_6^-$ (N-5)

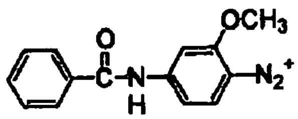 $CF_3SO_3^-$ (N-6)

$BF_4^-$ (N-7)

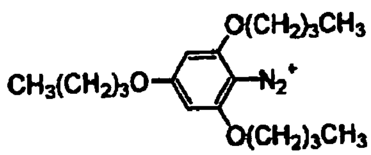 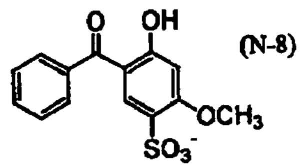 (N-8)

$ClO_4^-$ (N-9)

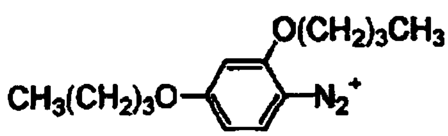 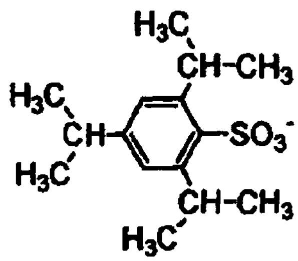 (N-10)

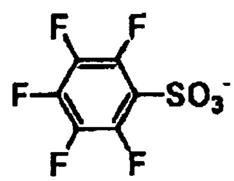 (N-11)

$PF_6^-$ (N-12)

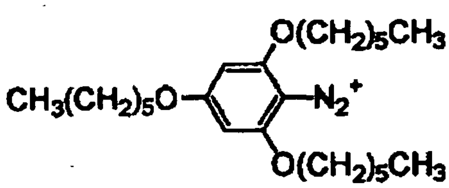 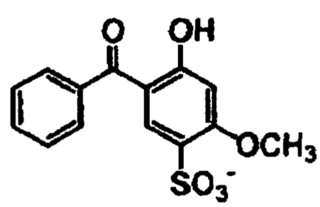 (N-13)

$ClO_4^-$ (N-14)

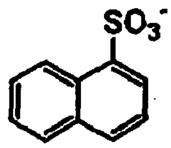

(N-15)

$PF_6^-$ (N-16)

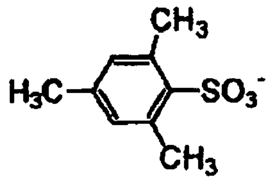

(N-17)

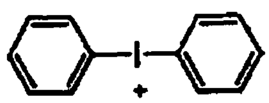

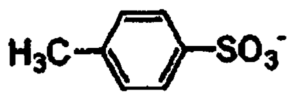

(I-1)

$PF_6^-$ (I-2)

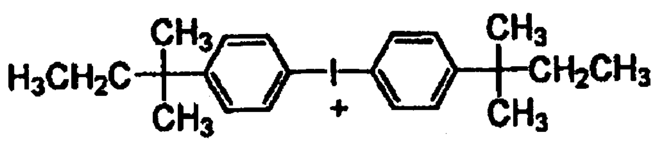

$PF_6^-$ (I-3)

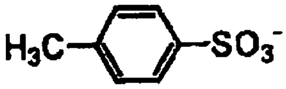

(I-4)

$ClO_4^-$ (I-5)

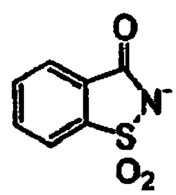

(I-9)

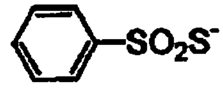

(I-10)

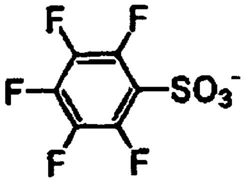 (I-6)

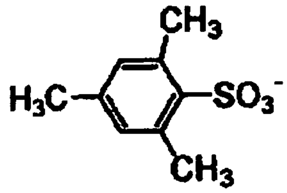 (I-11)

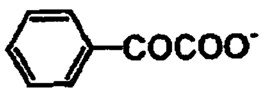 (I-7)

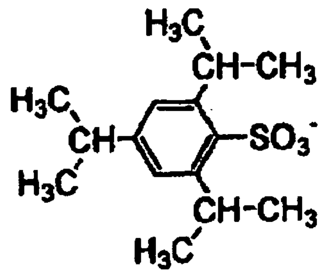 (I-12)

$CF_3SO_3^-$ (I-8)

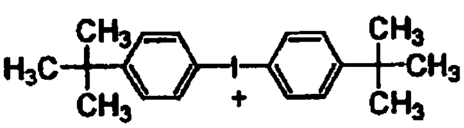 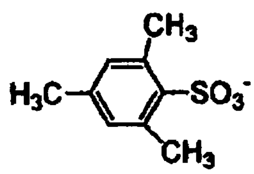 (I-13)

$ClO_4^-$ (I-14)

$PF_6^-$ (I-15)

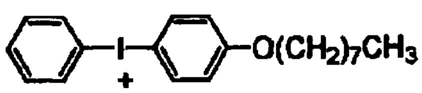 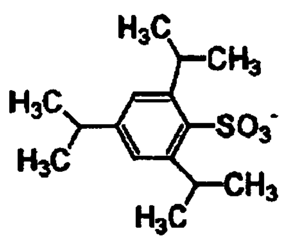 (I-16)

$CF_3COO^-$ (I-17)

$CF_3SO_3^-$ (I-18)

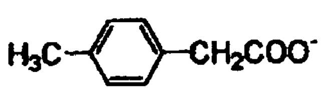 (I-19)

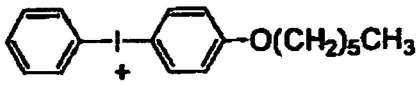 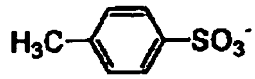 (I-20)

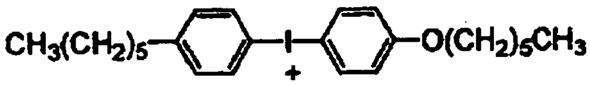 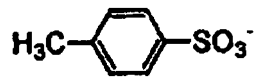 (I-21)

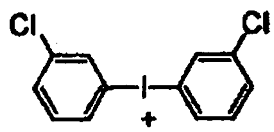

$BF_4^-$ (I-22)

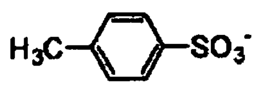 (I-23)

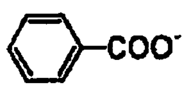 (I-18)

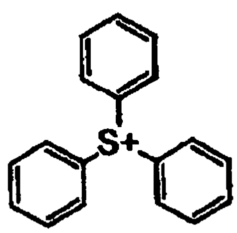 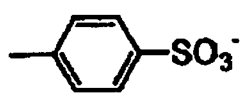 (S-1)

$PF_6^-$ (S-2)

$ClO_4^-$ (S-3)

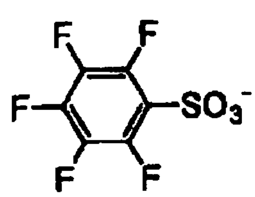 (S-4)

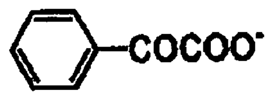 (S-5)

$CF_3SO_3^-$ (S-6)

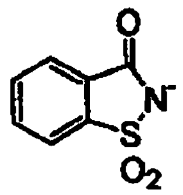 (S-7)

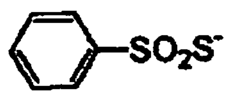 (S-8)

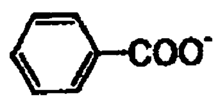 (S-9)

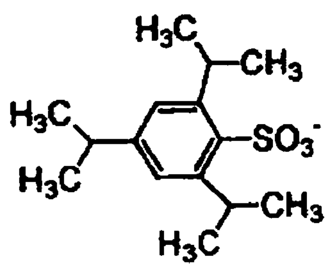 (S-10)

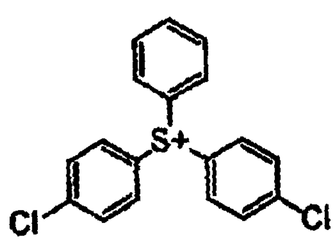

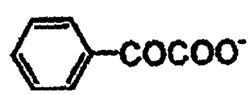 (S-11)

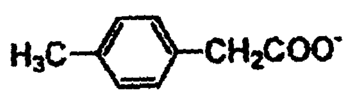 (S-12)

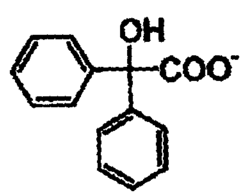 (S-13)

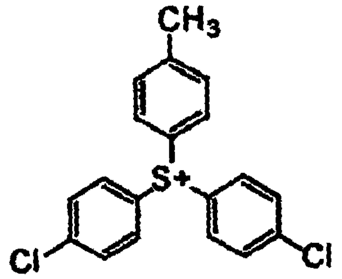

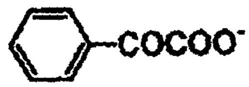

(S-14)

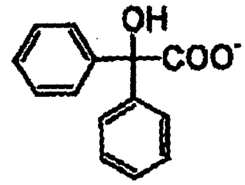

(S-15)

$BF_4^-$ (S-16)

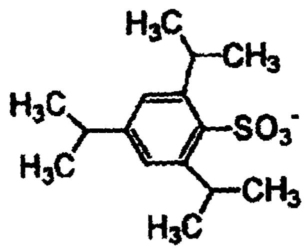

(S-17)

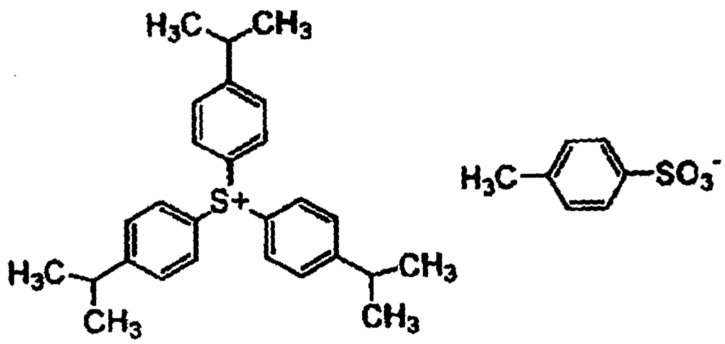

(S-18)

As the polymerization initiator, particularly, from the standpoint of reactivity and stability, the organic halogen compounds, metallocene compounds, hexaarylbiimidazole compounds, organic boron compounds, oxime ester compounds and onium salt compounds are preferable and the organic halogen compounds, metallocene compounds, hexaarylbiimidazole compounds and onium salt compounds are more preferable.

The polymerization initiators may be used individually or in combination of two or more thereof. The content of the polymerization initiator is preferably from 0.1 to 50% by weight, more preferably from 0.5 to 30% by weight, still more preferably from 0.8 to 20% by weight, based on the total solid content of the photosensitive layer.

(Co-sensitizer)

A co-sensitizer can be used in the photosensitive layer. The co-sensitizer is an additive which can further increase the sensitivity of the photosensitive layer when added to the photosensitive layer. The operation mechanism of the co-sensitizer is not quite clear but may be considered to be mostly based on the following chemical process. Specifically, the co-sensitizer reacts with various intermediate active species (for example, a radical, a peroxide, an oxidizing agent or a reducing agent) generated during the process of photo-reaction initiated by light absorption of the polymerization initiator and subsequent addition-polymerization reaction to produce new active radicals. The co-sensitizers are roughly classified into (a) a compound which is reduced to produce an active radical, (b) a compound which

is oxidized to produce an active radical and (c) a compound which reacts with a radical having low activity to convert it into a more highly active radical or acts as a chain transfer agent. However, in many cases, a common view about that an individual compound belongs to which type is not present.

(a) Compound which is reduced to produce an active radical Compound having carbon-halogen bond:

An active radical is considered to be generated by the reductive cleavage of the carbon-halogen bond. Specific examples of the compound preferably used include a trihalomethyl-s-triazine and a trihalomethyloxadiazole.

Compound having nitrogen-nitrogen bond:

An active radical is considered to be generated by the reductive cleavage of the nitrogen-nitrogen bond. Specific examples of the compound preferably used include a hexaarylbiimidazole.

Compound having oxygen-oxygen bond:

An active radical is considered to be generated by the reductive cleavage of the oxygen-oxygen bond. Specific examples of the compound preferably used include an organic peroxide.

Onium compound:

An active radical is considered to be generated by the reductive cleavage of a carbon-hetero bond or oxygen-nitrogen bond. Specific examples of the compound preferably used include a diaryliodonium salt, a triarylsulfonium salt and an N-alkoxypyridinium (azinium) salt.

(b) Compound which is oxidized to produce an active radical Alkylate complex:

An active radical is considered to be generated by the oxidative cleavage of a carbon-hetero bond. Specific examples of the compound preferably used include a triaryl alkyl borate.

Alkylamine compound:

An active radical is considered to be generated by the oxidative cleavage of a C-X bond on the carbon adjacent to nitrogen, wherein X is preferably, for example, a hydrogen atom, a carboxyl group, a trimethylsilyl group or a benzyl group. Specific examples of the compound include an ethanolamine, an N-phenylglycine and an N-trimethylsilylmethylaniline.

Sulfur-containing or tin-containing compound:

A compound in which the nitrogen atom of the above-described amine is replaced by a sulfur atom or a tin atom can generate an active radical in the same manner. Also, a compound having an S-S bond is known to effect sensitization by the cleavage of the S-S bond.

$\alpha$ -Substituted methylcarbonyl compound:

An active radical can be generated by the oxidative cleavage of carbonyl-$\alpha$-carbon bond. The compound in which the carbonyl is converted into an oxime ether also shows the similar function. Specific examples of the compound include an 2-alkyl-1-[4-(alkylthio)phenyl]-2-morpholinopropanone-1 and an oxime ether obtained by a reaction of the 2-alkyl-1-[4-(alkylthio)phenyl]-2-morpholinopropanone-1 with a hydroxyamine and subsequent etherification of the N-OH and an oxime ester obtained by subsequent esterification of the N-OH.

Sulfinic acid salt:

An active radical can be reductively generated. Specific examples of the compound include sodium arylsulfinate.

(c) Compound which reacts with a radical to convert it into a more highly active radical or acts as a chain transfer agent:

For example, a compound having SH, PH, SiH or GeH in its molecule is used as the compound which reacts

with a radical to convert it into a more highly active radical or acts as a chain transfer agent. The compound donates hydrogen to a low active radical species to generate a radical or is oxidized and deprotonized to generate a radical. The chain transfer agent contributes to improvements in the sensitivity and preservation stability.

A thiol compound (for example, a 2-mercaptobenzimidazole) is preferably used as the chain transfer agent. Among them, a thiol compound represented by formula (T) shown below is particularly preferably used. By using the thiol compound represented by formula (T) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

Formula (T):

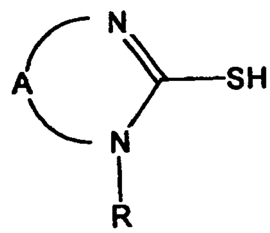

In formula (T), R represents a hydrogen atom, an alkyl group or an aryl group, A represents an atomic group necessary for forming a 5-membered or 6-membered hetero ring containing a carbon atom together with the N=C-N linkage, and A may have a substituent.

Compounds represented by any one of formulae (TA) and (TB) shown below are more preferably used.

Formula (TA):

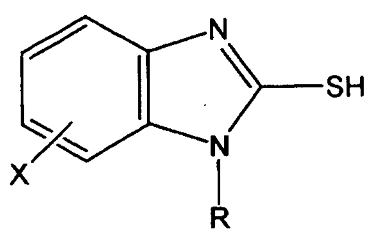

Formula (TB):

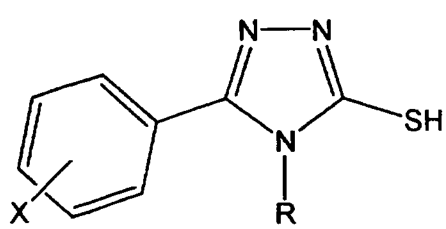

In formulae (TA) and (TB), R represents a hydrogen atom, an alkyl group or an aryl group, and X represents a hydrogen atom, a halogen atom, an alkoxy group, an alkyl group or an aryl group.

Specific examples of the compound represented by formula (T) are set forth below, but the invention should not be construed as being limited thereto.

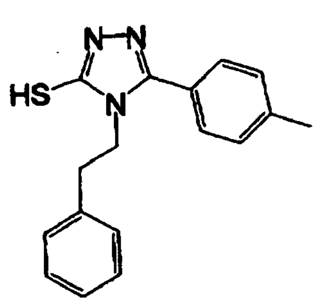

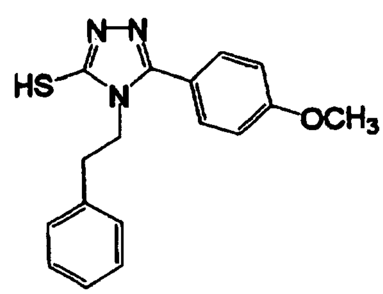

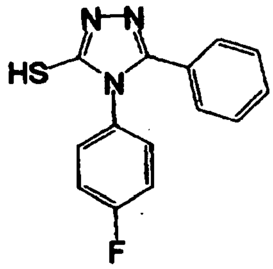
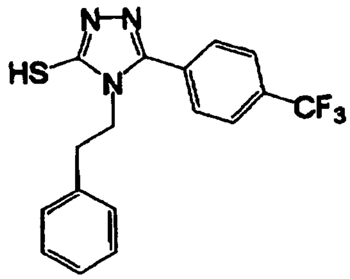

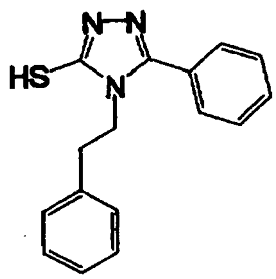
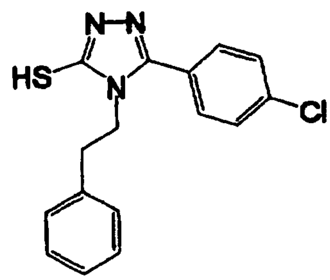

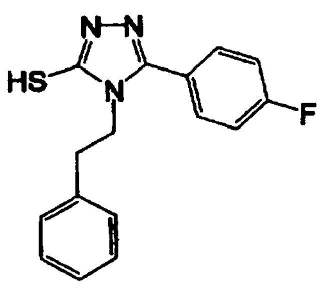
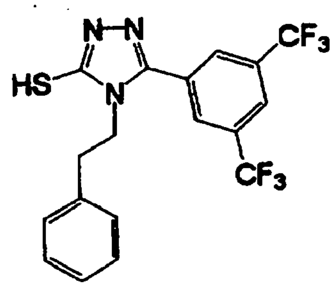

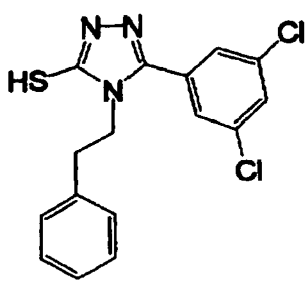
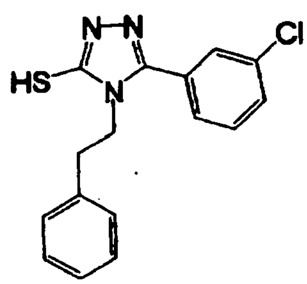

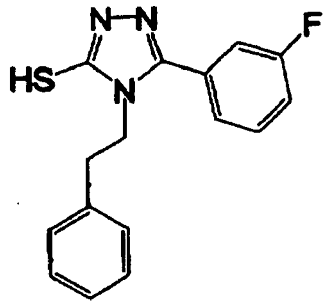
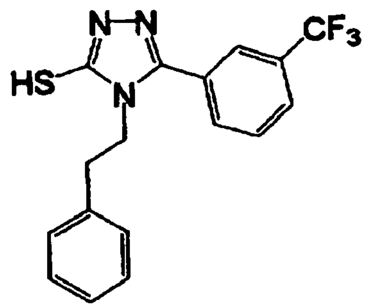

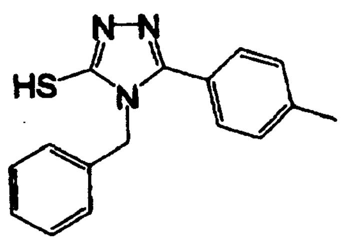
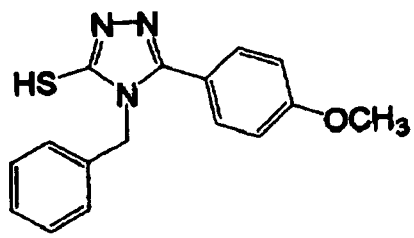

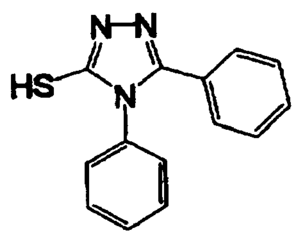
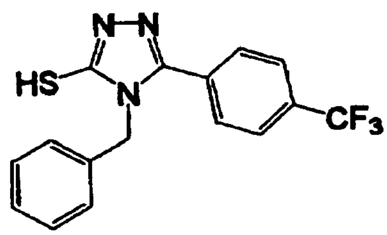

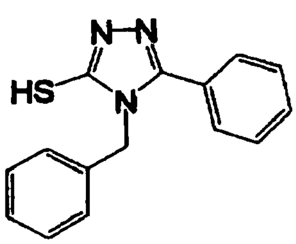
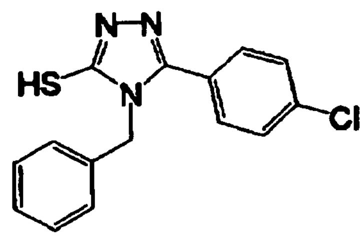

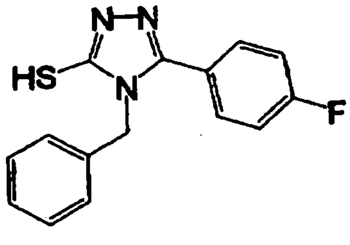
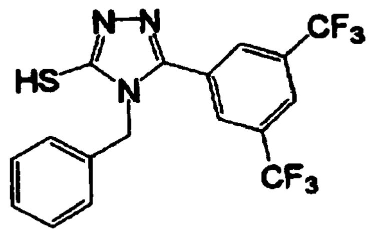

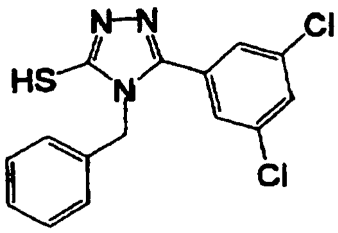

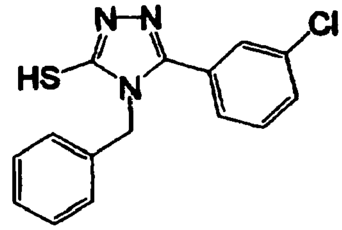

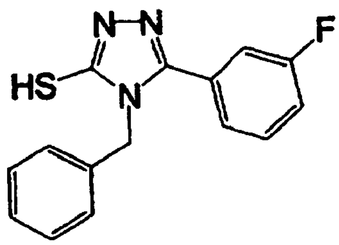

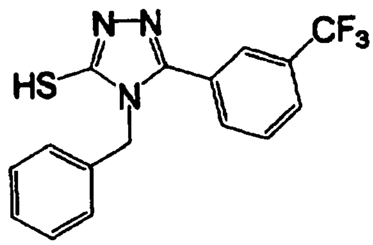

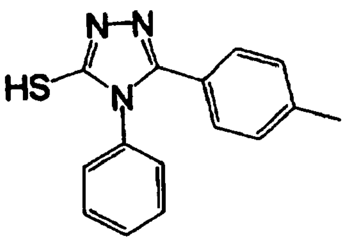

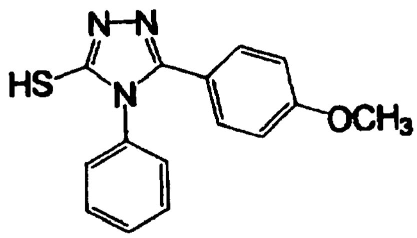

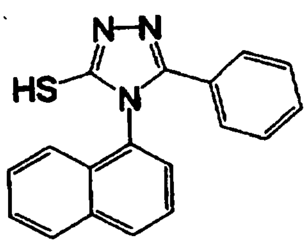

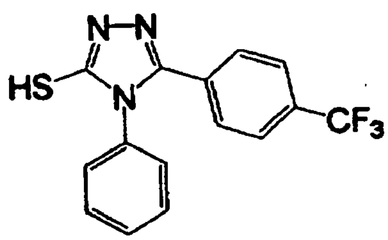

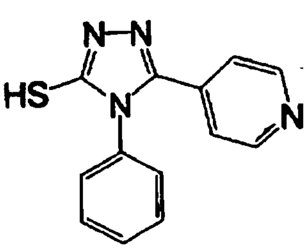

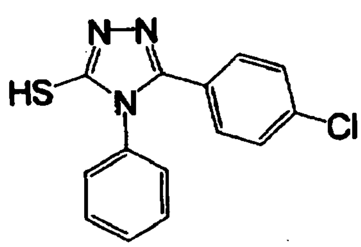

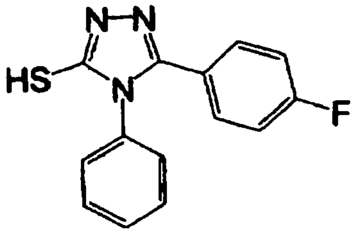

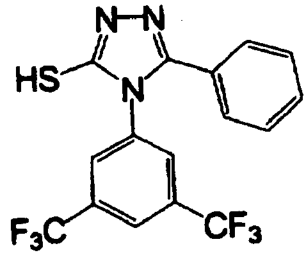

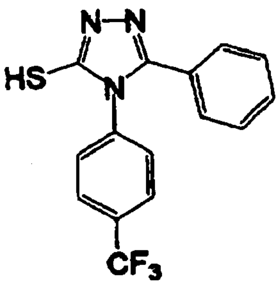

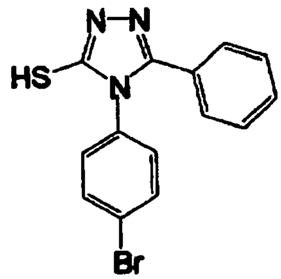

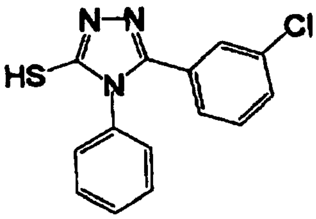

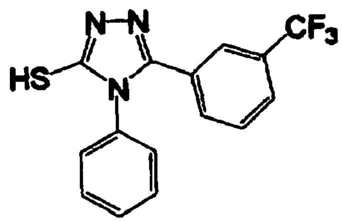

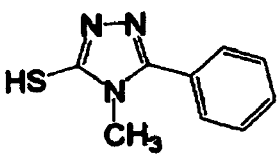

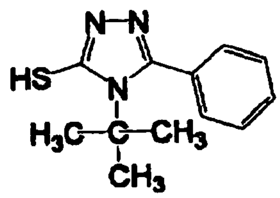

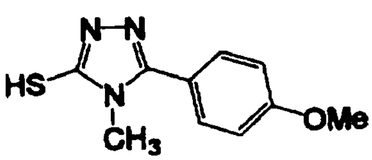

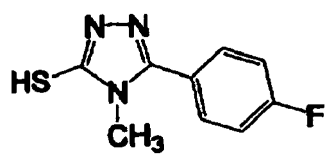

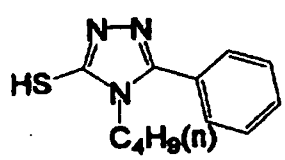

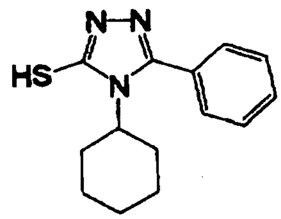

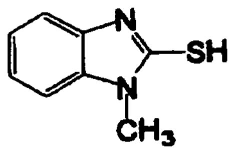

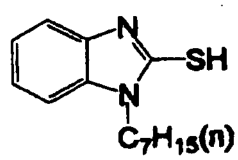

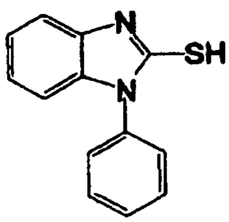

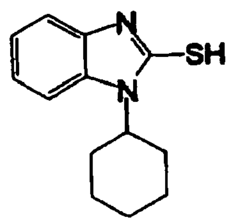

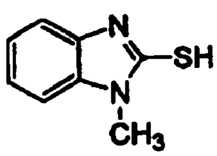

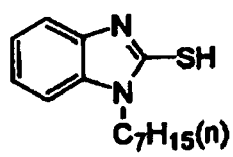

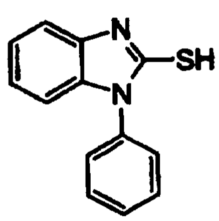

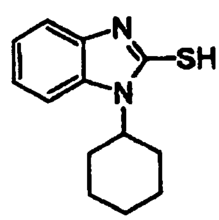

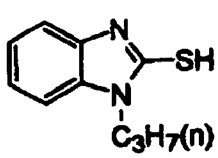

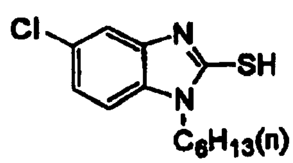

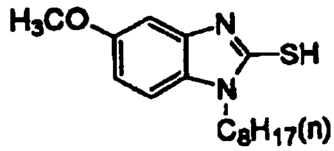

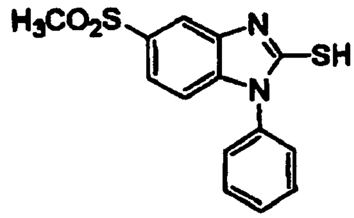

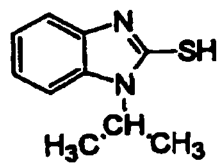

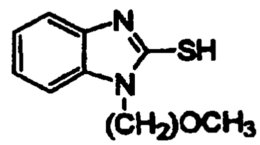

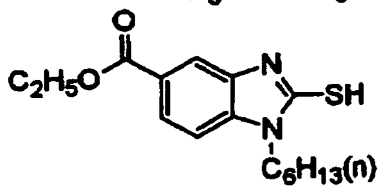

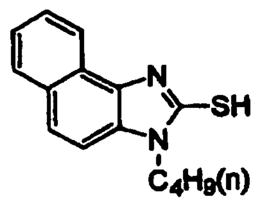

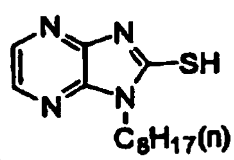

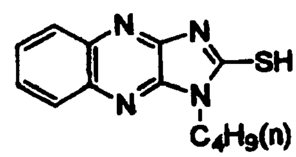

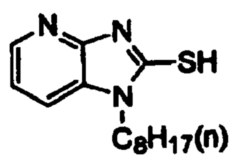

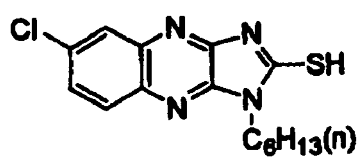

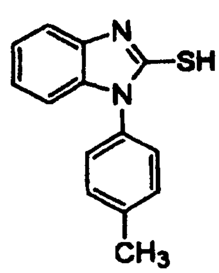

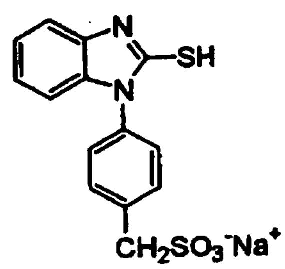

The amount of the chain transfer agent used is preferably from 0.01 to 20% by weight, more preferably from 0.1 to 15% by weight, still more preferably from 1.0 to 10% by weight, based on the total solid content of the photosensitive layer.

Other specific examples of the co-sensitizer include compounds described, for example, in JP-A-9-236913 as additives for the purpose of increasing sensitivity. Some of them are set forth below, but the invention should not be construed as being limited thereto.

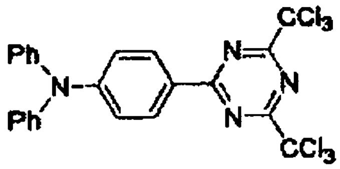
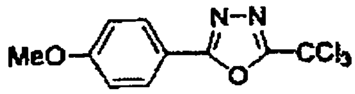
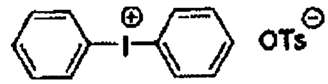

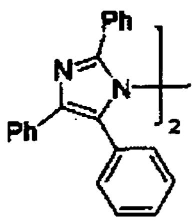
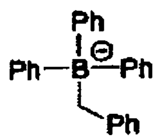
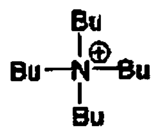
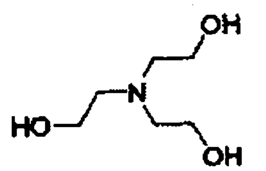

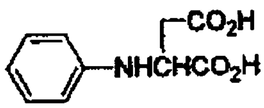
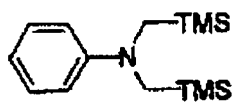
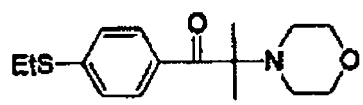

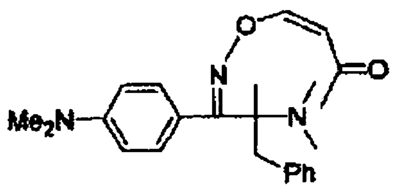
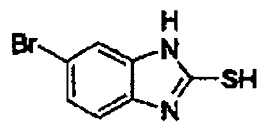

The co-sensitizers may be used individually or in combination of two or more thereof. The amount of the co-sensitizer used is ordinarily from 0.05 to 100 parts by weight, preferably from 1 to 80 parts by weight, more preferably from 3 to 50 parts by weight, per 100 parts by weight of the polymerizable compound.

(Polymerization inhibitor)

To the photosensitive layer, a small amount of a polymerization inhibitor is preferably added in order to prevent the polymerizable compound from undergoing undesirable thermal polymerization during the production or preservation of the photosensitive layer.

Preferable examples of the polymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The amount of the polymerization inhibitor added is preferably from about 0.01 to about 5% by weight based on the total solid content of the photosensitive layer. (Surfactant)

Into the photosensitive layer, a surfactant can be incorporated in order to progress the developing property and to improve the state of surface coated. The surfactant includes, for example, a nonionic surfactant, an anionic surfactant, a cationic surfactant, an amphoteric surfactant and a fluorine-based surfactant.

The nonionic surfactant for use in the invention is not particular restricted, and nonionic surfactants hitherto known can be used. Examples of the nonionic surfactant include polyoxyethylene alkyl ethers, polyoxyethylene alkyl phenyl ethers, polyoxyethylene polystyryl phenyl ethers, polyoxyethylene polyoxypropylene alkyl ethers, glycerin fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N-bis-2-hydroxyalkylamines,

polyoxyethylene alkylamines, triethanolamine fatty acid esters, trialylamine oxides, polyethylene glycols and copolymer of polyethylene glycol and polypropylene glycol.

The anionic surfactant for use in the invention is not particularly restricted and anionic surfactants hitherto known can be used. Examples of the anionic surfactant include fatty acid salts, abietic acid salts, hydroxyalkanesulfonic acid salts, alkanesulfonic acid salts, dialkylsulfosuccinic ester salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styrylphenyl ether sulfate ester salts, alkyl phosphate ester salts, polyoxyethylene alkyl ether phosphate ester salts, polyoxyethylene alkyl phenyl ether phosphate ester salts, partial saponification products of styrene/maleic anhydride copolymer, partial saponification products of olefin/maleic anhydride copolymer and naphthalene sulfonate formalin condensates.

The cationic surfactant for use in the invention is not particularly restricted and cationic surfactants hitherto known can be used. Examples of the cationic surfactant include alkylamine salts, quaternary ammonium salts, polyoxyethylene alkylamine salts and polyethylene polyamine derivatives.

The amphoteric surfactant for use in the invention is not particularly restricted and amphoteric surfactants hitherto known can be used. Examples of the amphoteric surfactant include carboxybetaines, aminocarboxylic acids, sulfobetaines, aminosulfuric esters and imidazolines.

With respect to the surfactants described above, the term "polyoxyethylene" can be replaced with "polyoxyalkylene", for example, polyoxymethylene, polyoxypropylene or polyoxybutylene, and such surfactants can also be used in the invention.

Further, a preferable surfactant includes a fluorine-based surfactant containing a perfluoroalkyl group in its molecule. Examples of the fluorine-based surfactant include an anionic type, for example, perfluoroalkyl carboxylates, perfluoroalkyl sulfonates or perfluoroalkyl phosphates; an amphoteric type, for example, perfluoroalkyl betaines; a cationic type, for example, perfluoroalkyl trimethyl ammonium salts; and a nonionic type, for example, perfluoroalkyl amine oxides, perfluoroalkyl ethylene oxide adducts, oligomers having a perfluoroalkyl group and a hydrophilic group, oligomers having a perfluoroalkyl group and an oleophilic group, oligomers having a perfluoroalkyl group, a hydrophilic group and an oleophilic group or urethanes having a perfluoroalkyl group and an oleophilic group. Also, fluorine-based surfactants described in JP-A-62-170950, JP-A-62-226143 and JP-A-60-168144 are also preferably exemplified.

The surfactants may be used individually or in combination of two or more thereof. The content of the surfactant is preferably from 0.001 to 10% by weight, more preferably from 0.01 to 7% by weight, based on the total solid content of the photosensitive layer. (Hydrophilic polymer) Into the photosensitive layer, a hydrophilic polymer can be incorporated in order to improve the developing property and dispersion stability of microcapsule.

Preferable examples of the hydrophilic polymer include those having a hydrophilic group, for example, a hydroxy group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group and a phosphoric acid group.

Specific examples of the hydrophilic polymer include gum arabic, casein, gelatin, a starch derivative, carboxymethyl cellulose or sodium salt thereof, cellulose acetate, sodium alginate, a vinyl acetate-maleic acid copolymer, a styrene-maleic acid copolymer, polyacrylic acid or salt thereof, polymethacrylic acid or salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycol, a hydroxypropylene polymer, polyvinyl alcohol, a hydrolyzed polyvinyl acetate having a hydrolysis degree of 60% by mole or more, preferably 80% by mole or more, polyvinyl formal, polyvinyl butyral, polyvinyl pyrrolidone, a homopolymer or polymer of acrylamide, a homopolymer or copolymer of methacrylamide, a homopolymer or copolymer of N-methylolacrylamide, an alcohol-soluble nylon, and a polyether of 2,2-bis(4-hydroxyphenyl)propane with epichlorohydrin.

The weight average molecular weight of the hydrophilic polymer is preferably 5,000 or more, more preferably from 10,000 to 300,000. The hydrophilic polymer may be any of a random polymer, a block polymer, a graft polymer and the like. The content of the hydrophilic polymer is preferably 20% by weight or less, more preferably 10% by weight or less, based on the total solid content of the photosensitive layer. (Coloring agent)

Into the photosensitive layer, a dye having large absorption in the visible light region can be used as a coloring agent for the image. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (produced by Orient Chemical Industry Co., Ltd.), Victoria Pure Blue, Crystal Violet (CI42555), Methyl Violet (CI42535), Ethyl Violet, Rhodamine B (CI45170B), Malachite Green (CI42000), Methylene Blue (CI52015), and dyes described in JP-A-62-293247. Also, a pigment, for example, phthalocyanine-based pigment, azo-based pigment, carbon black and titanium oxide can be preferably used.

It is preferable to add the coloring agent, because after the image formation, the image area and the non-image area can be easily distinguished. The amount of the coloring agent added is preferably from 0.01 to 10% by weight based on the total solid content of the photosensitive layer. (Print-out agent) To the photosensitive layer, a compound capable of undergoing discoloration with an acid or a radical can be added in order to form a print-out image. As such a compound, for example, various dyes, e.g., diphenylmethane-based, triphenylinethane-based, thiazine-based, oxazine-based, xanthene-based, anthraquinone-based, iminoquinone-based, azo-based and azomethine-based dyes are effectively used.

Specific examples thereof include dyes, for example, Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, α-Naphthyl Red, Nile Blue 2B, Nile Blue A, Methyl Violet, Malachite Green, Parafuchsine, Victoria Pure Blue BOH (produced by Hodogaya Chemical Co., Ltd.), Oil Blue #603, Oil Pink #312, Oil Red 5B, Oil Scarlet #308, Oil Red OG, Oil Red RR and Oil Green #502 (produced by Orient Chemical Industry Co., Ltd.), Spiron Red BEH Special (produced by Hodogaya Chemical Co., Ltd.), m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-β-naphthyl-4-p-diethylaminophenylimino-5-pyrazolone, and leuco dyes, for example, p,p',p''-hexamethyltriaminotriphenyl methane (leuco Crystal Violet) and Pergascript Blue SRB (produced by Ciba Geigy).

Other preferable examples include leuco dyes which are known as a material for heat-sensitive paper or pressure-sensitive paper. Specific examples thereof include Crystal Violet Lactone, Malachite Green Lactone, Benzoyl Leuco Methylene Blue, 2-(N-phenyl-N-methylamino)-6-(N-p-tolyl-N-ethyl)aminofluorane, 2-anilino-3-methyl-6-(N-ethyl-p-toluidino)fluorane, 3,6-dimethoxyfluorane, 3-(N,N-diethylamino)-5-methyl-7-(N,N-dibenzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-methoxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-azaphthalide and 3-(4-diethylaminophenyl)-3-(1-ethyl-2-methylindol-3-yl)phthalide.

The amount of the compound capable of undergoing discoloration with an acid or a radical added is preferably from 0.01 to 15% by weight based on the total solid content of the photosensitive layer.

(Higher fatty acid derivative)

To the photosensitive layer, a higher fatty acid derivative, for example, behenic acid or behenic acid amide may be added and localized on the surface of the photosensitive layer during the process of drying after coating in order to avoid polymerization inhibition due to oxygen. The amount of the higher fatty acid derivative added is preferably from about 0.1 to about 10% by weight based on the total solid content of the photosensitive layer.

(Plasticizer)

The photosensitive layer may contain a plasticizer. Preferable examples of the plasticizer include a phthalic acid ester, for example, dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate or diallyl phthalate; a glycol ester, for example, dimethyl glycol phthalate, ethyl phthalylethyl glycolate, methyl phthalylethyl glycolate, butyl phthalylbutyl glycolate or triethylene glycol dicaprylic acid ester; a phosphoric acid ester, for example, tricresyl phosphate or triphenyl phosphate; an aliphatic dibasic acid ester, for example, diisobutyl adipate, dioctyl adipate, dimethyl sebacate, dibutyl sebacate, dioctyl azelate or dibutyl maleate; polyglycidyl methacrylate, triethyl citrate, glycerin triacetyl ester and butyl laurate. The content of the plasticizer is preferably about 30% by weight or less based on the total solid content of the photosensitive layer.

(Fine inorganic particle)

The photosensitive layer may contain fine inorganic particle in order to increase strength of the cured layer in the image area. The fine inorganic particle preferably includes, for example, silica, alumina, magnesium oxide, titanium oxide, magnesium carbonate, calcium alginate and a mixture thereof. Even if the fine inorganic particle has no light-to-heat converting property, it can be used, for example, for strengthening the film or enhancing interface adhesion property

due to surface roughening. The average particle size of the fine inorganic particle is preferably from 5 nm to 10 μm, more preferably from 0.5 to 3μm, from the standpoint of the dispersion stability in the photosensitive layer, retention of sufficient film strength and formation of the non-image area excellent in hydrophilicity and preventing from the occurrence of stain at the printing. The fine inorganic particle is easily available as a commercial product, for example, colloidal silica dispersion. The content of the fine inorganic particle is preferably 20% by weight or less, more preferably 10% by weight or less, based on the total solid content of the photosensitive layer.

(Hydrophilic low molecular weight compound)

The photosensitive layer may contain a hydrophilic low molecular weight compound in order to improve the developing property. Examples of the hydrophilic low molecular weight compound include a water-soluble organic compound, for example, a glycol compound, e.g., ethylene glycol, diethylene glycol, triethylene glycol, propylene glycol, dipropylene glycol or tripropylene glycol, or an ether or ester derivative thereof, a polyhydroxy compound, e.g., glycerine or pentaerythritol, an organic amine, e.g., triethanol amine, diethanol amine or monoethanol amine, or a salt thereof, an organic sulfonic acid, e.g., toluene sulfonic acid or benzene sulfonic acid, or a salt thereof, an organic phosphonic acid, e.g., phenyl phosphonic acid, or a salt thereof, an organic carboxylic acid, e.g., tartaric acid, oxalic acid, citric acid, maleic acid, lactic acid, gluconic acid or an amino acid, or a salt thereof, and an organic quaternary ammonium salt, e.g., tetraethyl amine hydrochloride.

(Formation of photosensitive layer)

Several embodiments can be employed in order to form the photosensitive layer. One embodiment is a method of dissolving the constituting components of photosensitive layer in an appropriate solvent to coat as described, for example, in JP-A-2002-287334. The solvent used include, for example, ethylene dichloride, cyclohexanone, methyl ethyl ketone, methanol, ethanol, propanol, ethylene glycol monomethyl ether, 1-methoxy-2-propanol, 2-methxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethylsulfoxide, sulfolane, γ-butyrolactone, toluene and water. The solvents may be used individually or as a mixture. Another embodiment is a method (photosensitive layer of microcapsule type) of encapsulating the constituting components of photosensitive layer into microcapsule to incorporate into the photosensitive layer as described, for example, in JP-A-2001-277740 and JP-A-2001-277742. In the photosensitive layer of microcapsule type, the constituting components may be present outside the microcapsules. It is a more preferable embodiment of the photosensitive layer of microcapsule type that the hydrophobic constituting components are encapsulated in microcapsules and the hydrophilic constituting components are present outside the microcapsules.

As a method for microencapsulation of the constituting component of photosensitive layer, known methods can be used. Methods of producing the microcapsule include, for example, a method of utilizing coacervation described in U.S. Patents 2,800,457 and 2,800,458, a method of using interfacial polymerization described in U.S. Patent 3,287,154, JP-B-38-19574 and JP-B-42-446, a method of using deposition of polymer described in U.S. Patents 3,418,250 and 3,660,304, a method of using an isocyanate polyol wall material described in U.S. Patent 3,796,669, a method of using an isocyanate wall material described in U.S. Patent 3,914,511, a method of using a urea-formaldehyde-type or urea-formaldehyde-resorcinol-type wall-forming material described in U.S. Patens 4,001,140, 4,087,376 and 4,089,802, a method of using a wall material, for example, a melamine-formaldehyde resin or hydroxycellulose described in U.S. Patent 4,025,445, an in-situ method by monomer polymerization described in JP-B-36-9163 and JP-B-51-9079, a spray drying method described in British Patent 930,422 and U.S. Patent 3,111,407, and an electrolytic dispersion cooling method described in British Patents 952,807 and 967,074.

A preferable microcapsule wall used in the invention has three-dimensional crosslinkage and has a solvent-swellable property. From this point of view, a preferable wall material of the microcapsule includes polyurea, polyurethane, polyester, polycarbonate, polyamide and a mixture thereof, and polyurea and polyurethane are particularly preferred. Further, a compound having a crosslinkable functional group, for example, an ethylenically unsaturated bond may be introduced into the microcapsule wall.

The average particle size of the microcapsule is preferably from 0.01 to 3.0 μm, more preferably from 0.05 to 2.0 μm, still more preferably from 0.10 to 1.0 μm from the standpoint of good resolution and good preservation stability.

Further, an embodiment of incorporating the constituting component of photosensitive layer described above, particularly preferably, the infrared absorbing agent, into fine resin particles is also used according to the invention.

The embodiment is performed by dissolving the constituting component of photosensitive layer in a solvent and mixing the resulting solution with a polymer solution (preferably an aqueous polymer solution) using, for example, a homogenizer to prepare a dispersion of fine resin particles for use.

As the solvent used, ethyl acetate, methyl ethyl ketone (MEK), diisopropyl ether, dichloromethane, chloroform,

toluene, dichloroethane and mixed solvents thereof are exemplified. The solvents may be used individually or as a mixture.

As the polymer, polyvinyl alcohol (PVA), polyacrylic acid, sodium polyacrylate, polyacrylamide, polymethacrylic acid, sodium polymethacrylate, polymethacrylamide, polystyrenesulfonic acid, sodium polystyrenesulufonate, acrylic acid/methyl acrylate copolymer, methacrylic acid/methyl methacrylate copolymer and styrene/sodium styrenesulufonate copolymer are exemplified.

The solid concentration of the coating solution for photosensitive layer is preferably from 1 to 50% by weight.

The photosensitive layer may also be formed by preparing plural coating solutions by dispersing or dissolving the same or different constituting components into the same or different solvents and conducting repeatedly the coating and drying plural times.

The coating amount (solid content) of the photosensitive layer may be varied according to the use, but ordinarily, it is preferably from 0.3 to 3.0 g/m$^2$ in consideration of good sensitivity, good film property of the photosensitive layer and the like.

Various methods can be used for the coating of the photosensitive layer. Examples of the coating method include bar coater coating, spin coating, spray coating, curtain coating, dip coating, air knife coating, blade coating and roll coating.

[Support]

The support for use in the lithographic printing plate precursor according to the invention is not particularly restricted as long as it is a dimensionally stable plate-like hydrophilic support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero element and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Since completely pure aluminum is difficult to be produced in view of the refining technique, an aluminum alloy plate containing a slight amount of hetero element is preferably used. The composition of the aluminum plate is not limited and those materials known and used conventionally can be appropriately utilized. The thickness of the aluminum plate is preferably from 0.1 to 0.6 mm, more preferably from 0.15 to 0.4 mm, and still more preferably from 0.2 to 0.3 mm.

The aluminum plate is preferably subjected to a surface treatment, for example, roughening treatment or anodizing treatment. The surface treatment facilitates improvement in the hydrophilic property and ensures the adhesion property between the photosensitive layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). As the method of the mechanical roughening treatment, a known method, for example, a ball graining method, a brush graining method, a blast graining method or a buff graining method can be used. The electrochemical roughening treatment method includes, for example, a method of conducting it by passing alternating current or direct current in an electrolytic solution containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

For the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70˚C, current density is from 5 to 60 A/dm$^2$, voltage is from 1 to 100 V, and electrolysis time is from 10 seconds to 5 minutes. The amount of the anodized film formed is preferably from 1.0 to 5.0

$g/m^2$, more preferably from 1.5 to 4.0 $g/m^2$, from the standpoint of good printing durability, good scratch resistance in the non-image area and the like.

The aluminum plate subjected to the surface treatment and having the anodized film is used as it is as the support. However, in order to more improve the adhesion property to a layer provided thereon, hydrophilicity, resistance to stain, heat insulating property or the like, a known treatment, for example, a treatment for enlarging micropores or a sealing treatment of micropores of the anodized film described in JP-A-2001-253181 and JP-A-2001-322365, or a surface hydrophilizing treatment by immersing the aluminum plate in an aqueous solution containing a hydrophilic compound, may be appropriately conducted.

As the sealing treatment, a sealing treatment with water vapor, a sealing treatment with an aqueous solution containing an inorganic fluorine compound, for example, fluorozirconic acid alone or sodium fluoride, a sealing treatment with steam having lithium chloride added thereto or a sealing treatment with hot water may be employed. Among them, the sealing treatment with an aqueous solution containing an inorganic fluorine compound, the sealing treatment with water vapor and the sealing treatment with hot water are preferred.

The hydrophilizing treatment includes an alkali metal silicate method described in U.S. Patents 2,714,066, 3,181,461, 3,280,734 and 3,902,734. According to the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

In the case of using a support having a surface of insufficient hydrophilicity, for example, a polyester film, it is desirable to coat a hydrophilic layer thereon to make the surface sufficiently hydrophilic. Examples of the hydrophilic layer preferably includes a hydrophilic layer formed by coating a coating solution containing a colloid of oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer containing an organic hydrophilic matrix obtained by crosslinking or pseudo-crosslinking of an organic hydrophilic polymer described in JP-A-2002-79772, a hydrophilic layer containing an inorganic hydrophilic matrix obtained by sol-gel conversion comprising hydrolysis and condensation reaction of polyalkoxysilane and titanate, zirconate or aluminate, and a hydrophilic layer comprising an inorganic thin layer having a surface containing metal oxide. Among them, the hydrophilic layer formed by coating a coating solution containing a colloid of oxide or hydroxide of silicon is preferred.

Further, in the case of using, for example, a polyester film as the support, it is preferred to provide an antistatic layer on the hydrophilic layer side, opposite side to the hydrophilic layer or both sides. When the antistatic layer is provided between the support and the hydrophilic layer, it also contributes to improve the adhesion property of the hydrophilic layer to the support. As the antistatic layer, for example, a polymer layer containing fine particles of metal oxide or a matting agent dispersed therein described in JP-A-2002-79772 can be used.

The center line average roughness of support is preferably from 0.10 to 1.2 $\mu m$ from the standpoint of good adhesion property to the photosensitive layer, good printing durability, good resistance to stain and the like. The color density of the support is preferably from 0.15 to 0.65 in terms of the reflection density value from the standpoint of good image-forming property by preventing halation at the image exposure, good aptitude for plate inspection after development and the like. (Backcoat layer)

After applying the surface treatment to the support or forming the undercoat layer on the support, a backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, $Si(OCH_3)_4$, $Si(OC_2H_5)_4$, $Si(OC_3H_7)_4$ or $Si(OC_4H_9)_4$ is preferred since the starting material is inexpensive and easily available.

(Protective layer)

In the lithographic printing plate precursor according to the invention, a protective layer (oxygen-blocking layer) is preferably provided on the photosensitive layer in order to prevent diffusion and penetration of oxygen which inhibits the polymerization reaction at the time of exposure. The protective layer for use in the invention preferably has oxygen permeability (A) at 25°C under one atmosphere of $1.0 \leq (A) \leq 20$ ($ml/m^2 \cdot day$). When the oxygen permeability (A) is extremely lower than 1.0 ($ml/m^2 \cdot day$), problems may occur in that an undesirable polymerization reaction arises during the production or preservation before image exposure and in that undesirable fog or spread of image line occurs at the image exposure. On the contrary, when the oxygen permeability (A) greatly exceeds 20 ($ml/m^2 \cdot day$), decrease in sensitivity may be incurred. The oxygen permeability (A) is more preferably in a range of $1.5 \leq (A) \leq 12$ ($ml/m^2 \cdot day$), still more preferably in a range of $2.0 \leq (A) \leq 10.0$ ($ml/m^2 \cdot day$). Besides the above described oxygen permeability, as for the characteristics required of the protective layer, it is desired that the protective layer does not substantially hinder the

transmission of light for the exposure, is excellent in the adhesion property to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics of the protective layer, for example, oxygen-blocking property and removability by development.

Polyvinyl alcohol for use in the protective layer may be partially substituted with an ester, ether or acetal as long as it contains unsubstituted vinyl alcohol units for achieving the necessary oxygen-blocking property and water solubility. Also, a part of polyvinyl alcohol may have other copolymer component. As specific examples of the polyvinyl alcohol, polyvinyl alcohols having a hydrolysis degree of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

Also, known modified polyvinyl alcohol can be preferably used. For instance, polyvinyl alcohols of various polymerization degrees having at random a various kind of hydrophilic modified cites, for example, an anion-modified cite modified with an anion, e.g., a carboxyl group or a sulfo group, a cation-modified cite modified with a cation, e.g., an amino group or an ammonium group, a silanol-modified cite or a thiol-modified cite, and polyvinyl alcohols of various polymerization degrees having at the terminal of the polymer chain a various kind of modified cites, for example, the above-described anion-modified cite, cation modified cite, silanol-modified cite or thiol-modified cite, an alkoxy-modified cite, a sulfide-modified cite, an ester modified cite of vinyl alcohol with a various kind of organic acids, an ester modified cite of the above-described anion-modified cite with an alcohol or an epoxy-modified cite are exemplified.

As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

The components of the protective layer (selection of PVA and use of additives) and the coating amount are determined taking into consideration fog-preventing property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the polymer compound, for example, polyvinyl alcohol (PVA) is ordinarily from 2,000 to 10,000,000, preferably from 20,000 to 3,000,000.

As other composition of the protective layer, glycerin, dipropylene glycol or the like can be added in an amount of several % by weight of the polymer compound to provide flexibility. Further, an anionic surfactant, for example, sodium alkylsulfate or sodium alkylsulfonate, an amphoteric surfactant, for example, alkylaminocarboxylate or alkylaminodicarboxylate, or a nonionic surfactant, for example, polyoxyethylene alkyl phenyl ether can be added in an amount of several % by weight of the polymer compound.

The adhesion property of the protective layer to the photosensitive layer and scratch resistance are also extremely important in view of handling of the lithographic printing plate precursor. Specifically, when a hydrophilic layer comprising a water-soluble polymer is laminated on the oleophilic photosensitive layer, layer peeling due to an insufficient adhesion property is liable to occur, and the peeled portion causes such a defect as failure in curing of the photosensitive layer due to polymerization inhibition by oxygen. Various proposals have been made for improving the adhesion property between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on a photosensitive layer. Any of these known techniques can be applied to the protective layer according to the invention. Coating methods of the protective layer are described in detail, for example, in U.S. Patent 3,458,311 and JP-B-55-49729.

Further, it is also preferred to incorporate an inorganic stratiform compound into the protective layer of the lithographic printing plate precursor according to the invention for the purpose of improving the oxygen-blocking property and property for protecting the surface of photosensitive layer.

The inorganic stratiform compound used here is a particle having a thin tabular shape and includes, for instance,

mica, for example, natural mica represented by the following formula: A (B, C)$_{2-5}$ $D_4$ $O_{10}$ (OH, F, O)$_2$, (wherein A represents any one of K, Na and Ca, B and C each represents any one of Fe (II), Fe(III), Mn, Al, Mg and V, and D represents Si or Al) or synthetic mica, talc represented by the following formula: $3MgO \cdot 4SiO \cdot H_2O$, teniolite, montmorillonite, saponite, hectoliter, and zirconium phosphate.

Of the micas, examples of the natural mica include muscovite, paragonite, phlogopite, biotite and lepidolite. Examples of the synthetic mica include non-swellable mica, for example, fluorphlogopite $KMg_3(AlSi_3O_{10})F_2$ or potassium tetrasilic mica $KMg_{2.5}(Si_4O_{10})F_2$, and swellable mica, for example, Na tetrasilic mica $NaMg_{2.5}(Si_4O_{10})F_2$, Na or Li teniolite (Na, Li)$Mg_2Li(Si_4O_{10})F_2$, or montmorillonite based Na or Li hectolite (Na, Li)$_{1/8}Mg_{2/5}Li_{1/8}(Si_4O_{10})F_2$. Synthetic smectite is also useful.

Of the inorganic stratiform compounds, fluorine based swellable mica, which is a synthetic inorganic stratiform compound, is particularly useful in the invention. Specifically, the swellable synthetic mica and an swellable clay mineral, for example, montmorillonite, saponite, hectolite or bentonite have a stratiform structure comprising a unit crystal lattice layer having thickness of approximately 10 to 15 angstroms, and metallic atom substitution in the lattices thereof is remarkably large in comparison with other clay minerals. As a result, the lattice layer results in lack of positive charge and in order to compensate it, a cation, for example, $Na^+$, $Ca^{2+}$ or $Mg^{2+}$ is adsorbed between the lattice layers. The cation existing between the lattice layers is referred to as an exchangeable cation and is exchangeable with various cations. In particular, in the case where the cation between the lattice layers is Li+ or $Na^+$, because of a small ionic radius, a bond between the stratiform crystal lattices is week, and the inorganic stratiform compound greatly swells upon contact with water. When share is applied under such conditions, the stratiform crystal lattices are easily cleaved to form a stable sol in water. The bentnite and swellable synthetic mica have strongly such tendency and are useful in the invention. Particularly, the swellable synthetic mica is preferably used.

With respect to the shape of the inorganic stratiform compound for use in the invention, the thinner the thickness or the larger the plain size as long as smoothness of coated surface and transmission of actinic radiation are not damaged, the better from the standpoint of control of diffusion. Therefore, an aspect ratio of the inorganic stratiform compound is ordinarily 20 or more, preferably 100 or more, particularly preferably 200 or more. The aspect ratio is a ratio of thickness to major axis of particle and can be determined, for example, from a projection drawing of particle by a microphotography. The larger the aspect ratio, the greater the effect obtained.

As for the particle size of the inorganic stratiform compound used in the invention, an average major axis is ordinarily from 0.3 to 20 $\mu$m, preferably from 0.5 to 10 $\mu$m, particularly preferably from 1 to 5 $\mu$m. An average thickness of the particle is ordinarily 0.1 $\mu$m or less, preferably 0.05 $\mu$m or less, particularly preferably 0.01 $\mu$m or less. For example, in the swellable synthetic mica that is the representative compound of the inorganic stratiform compounds, thickness is approximately from 1 to 50 nm and plain size is approximately from 1 to 20 $\mu$m.

When such an inorganic stratiform compound particle having a large aspect ratio is incorporated into the protective layer, strength of coated layer increases and penetration of oxygen or moisture can be effectively inhibited so that the protective layer can be prevented from deterioration due to deformation, and even when the lithographic printing plate precursor is preserved for a long period of time under a high humidity condition, it is prevented from decrease in the image-forming property thereof due to the change of humidity and exhibits excellent preservation stability.

The content of the inorganic stratiform compound in the protective layer is preferably from 5/1 to 1/100 in terms of weight ratio to the amount of binder used in the protective layer. When a plurality of inorganic stratiform compounds is used in combination, it is also preferred that the total amount of the inorganic stratiform compounds fulfills the above-described weight ratio.

An example of common dispersing method for the inorganic stratiform compound used in the protective layer is described below. Specifically, from 5 to 10 parts by weight of a swellable stratiform compound that is exemplified as a preferable inorganic stratiform compound is added to 100 parts by weight of water to adapt the compound to water and to be swollen, followed by dispersing using a dispersing machine. The dispersing machine used include, for example, a variety of mills conducting dispersion by directly applying mechanical power, a high-speed agitation type dispersing machine providing a large shear force and a dispersion machine providing ultrasonic energy of high intensity. Specific examples thereof include a ball mill, a sand grinder mill, a visco mill, a colloid mill, a homogenizer, a dissolver, a polytron, a homomixer, a homoblender, a keddy mill, a jet agitor, a capillary type emulsifying device, a liquid siren, an electromagnetic strain type ultrasonic generator and an emulsifying device having a Polman whistle. A dispersion containing from 5 to 10% by weight of the inorganic stratiform compound thus prepared is highly viscous or gelled and exhibits extremely good preservation stability. In the formation of a coating solution for protective layer using the dispersion, it is preferred that the dispersion is diluted with water, sufficiently stirred and then mixed with a binder solution.

To the coating solution for protective layer can be added a known additive, for example, a surfactant for improving coating property or a water-soluble plasticizer for improving physical property of coated layer in addition to the inorganic stratiform compound. Examples of the water-soluble plasticizer include propionamide, cyclohexanediol, glycerin or sorbitol. Also, a water-soluble (meth)acrylic polymer can be added. Further, to the coating solution may be added a known additive for increasing adhesion property to the photosensitive layer or for improving preservation stability

of the coating solution.

The coating solution for protective layer thus-prepared is coated on the photosensitive layer and dried to form a protective layer. The coating solvent may be appropriately selected in view of the binder used, and when a water-soluble polymer is used, distilled water or purified water is preferably used as the solvent. A coating method of the protective layer is not particularly limited, and known methods, for example, methods described in U.S. Patent 3,458,311 and JP-B-55-49729 can be utilized. Specific examples of the coating method for the protective layer include a blade coating method, an air knife coating method, a gravure coating method, a roll coating method, a spray coating method, a dip coating method and a bar coating method.

The coating amount of the protective layer is preferably in a range of 0.05 to 10 g/m$^2$ in terms of the coating amount after drying. When the protective layer contains the inorganic stratiform compound, it is more preferably in a range of 0.1 to 0.5 g/m$^2$, and when the protective layer does not contain the inorganic stratiform compound, it is more preferably in a range of 0.5 to 5 g/m$^2$.

(Image exposure)

The lithographic printing plate precursor according to the invention is preferably exposed imagewise with a laser having an oscillation wavelength of 350 to 1,200 nm.

As for the available laser light source of 350 to 450 nm, the followings can be used.

A gas laser, for example, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); a solid laser, for example, a combination of Nd:YAG ($YVO_4$) with SHG crystalsxtwice (355 nm, 5 mW to 1 W) and a combination of Cr:LiSAF with SHG crystal (430 nm, 10 mW); a semiconductor laser system, for example, a $KNbO_3$ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW), and AlGaInN (350 nm to 450 nm, 5 mW to 30 mW); a pulse laser, for example, $N_2$ laser (337 nm, pulse 0.1 to 10 mJ) and XeF (351 nm, pulse 10 to 250 mJ) can be used. Among the light sources, the AlGaInN semiconductor laser (commercially available InGaN semiconductor laser, 400 to 410 nm, 5 to 30 mW) is particularly preferable in view of the wavelength characteristics and cost.

As for the exposure apparatus of scanning exposure system for the lithographic printing plate precursor, the exposure mechanism includes an internal drum system, an external drum system and a flat bed system. As the light source, among the light sources described above, those capable of conducting continuous oscillation can be preferably utilized. In practice, the exposure apparatuses described below are particularly preferable in view of the relationship between the sensitivity of lithographic printing plate precursor (hereinafter, also referred to as a "photosensitive material") and the time for plate making.

·A single beam to triple beam exposure apparatus of internal drum system, using one or more gas or solid laser light sources so as to provide a semiconductor laser having a total output of 20 mW or more

·A multi-beam (from 1 to 10 beams) exposure apparatus of flat bed system, using one or more semiconductor, gas or solid lasers so as to provide a total output of 20 mW or more

·A multi-beam (from 1 to 9 beams) exposure apparatus of external drum system, using one or more semiconductor, gas or solid lasers so as to provide a total output of 20 mW or more

·A multi-beam (10 or more beams) exposure apparatus of external drum system, using one or more semiconductor or solid lasers so as to provide a total output of 20 mW or more

As for the laser direct drawing-type lithographic printing plate precursor, the following equation (eq 1) is ordinarily established among the sensitivity X (J/cm$^2$) of photosensitive material, the exposure area S (cm$^2$) of photosensitive material, the power q (W) of one laser light source, the number n of lasers and the total exposure time t (s):

$$X \cdot S = n \cdot q \cdot t \qquad \text{(eq 1)}$$

i) In the case of the internal drum (single beam) system

The following equation (eq 2) is ordinarily established among the laser revolution number f (radian/s), the sub-scanning length Lx (cm) of photosensitive material, the resolution Z (dot/cm) and the total exposure time t (s):

$$f \cdot Z \cdot t = Lx \qquad \text{(eq 2)}$$

ii) In the case of the external drum (multi-beam) system

The following equation (eq 3) is ordinarily established among the drum revolution number F (radian/s), the sub-scanning length Lx (cm) of photosensitive material, the resolution Z (dot/cm), the total exposure time t (s) and the number (n) of beams:

$$F \cdot Z \cdot n \cdot t = Lx \qquad \text{(eq 3)}$$

iii) In the case of the flat bed (multi-beam) system

The following equation (eq 4) is ordinarily established among the revolution number H (radian/s) of polygon mirror, the sub-scanning length Lx (cm) of photosensitive material, the resolution Z (dot/cm), the total exposure time t (s) and the number (n) of beams:

$$H \cdot Z \cdot n \cdot t = Lx \qquad \text{(eq 4)}$$

When the resolution (2,560 dpi) required for a practical lithographic printing plate precursor, the plate size (A1/B1, sub-scanning length: 42 inch), the exposure condition of about 20 sheets/hour and the photosensitive characteristics (photosensitive wavelength, sensitivity: about 0.1 mJ/cm$^2$) of the lithographic printing plate precursor according to the invention are substituted for the above equations, it can be understood that the lithographic printing plate precursor according to the invention is particularly preferably combined with a multi-beam exposure system using a laser having a total output of 20 mW or more, and on taking account of operability, cost and the like, it is most preferably combined with an external drum system semiconductor laser multi-beam (10 or more beams) exposure apparatus.

The imagewise exposure of the lithographic printing plate precursor can also conducted with an infrared laser. The infrared laser for use in the invention is not particularly restricted and, for example, a solid laser or semiconductor laser emitting an infrared ray having a wavelength of 760 to 1,200 nm is preferably exemplified. The output of the infrared laser is preferably 100 mW or more. Further, in order to shorten the exposure time, it is preferred to use a multibeam laser device. The exposure time per pixel is preferably within 20 microseconds, and the irradiation energy amount is preferably from 10 to 300 mJ/cm$^2$.

Other examples of the exposure light source which can be used in the invention include an ultra-high pressure mercury lamp, a high pressure mercury lamp, a medium pressure mercury lamp, a low pressure mercury lamp, a chemical lamp, a carbon arc lamp, a xenon lamp, a metal halide lamp, various visible or ultraviolet laser lamps, a fluorescent lamp, a tungsten lamp and sunlight.

(Heating)

The lithographic printing plate precursor according to the invention may be heated its entire surface, if desired, before or during the exposure or between the exposure and the development. By the heating, the image-forming reaction in the photosensitive layer is accelerated and advantages, for example, improvement in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150˚C or lower. When the temperature is too high, a problem may arise sometimes in that the non-image area is also fogged. On the other hand, the heating after the development can be performed using very strong conditions. Ordinarily, the heat treatment is carried out in a temperature range of 200 to 500˚C. When the temperature is too low, a sufficient effect of strengthening the image may not be obtained, whereas when it is excessively high, problems of deterioration of the support and thermal decomposition of the image area may occur sometimes.

In the invention, although the development processing can be carried out just after the exposure step, the heat treatment step may intervene between the exposure step and the development step as described above. The heat treatment is effective for increasing the printing durability and improving uniformity of the image curing degree in the entire surface of printing plate precursor. The conditions of the heat treatment can be appropriately determined in a range for providing such effects. Examples of the heating means include a conventional convection oven, an IR irradiation apparatus, an IR laser, a microwave apparatus or a Wisconsin oven. Specifically, the heat treatment can be conducted by maintaining the lithographic printing plate precursor at a plate surface temperature ranging from 70 to 150˚C for a period of one second to 5 minutes, preferably at 80 to 140˚C for 5 seconds to one minute, more preferably at 90 to

130˚C for 10 to 30 seconds. In the above-described range, the effects described above are efficiently achieved and an adverse affect, for example, change in shape of the lithographic printing plate precursor due to the heat can be preferably avoided.

According to the invention, the development processing step is conducted after the exposure step, preferably after the exposure step and the heat treatment step, to prepare a lithographic printing plate. It is preferable that a plate setter used in the exposure step, a heat treatment means used in the heat treatment step and a development apparatus used in the development processing step are connected with each other and the lithographic printing plate precursor is subjected to automatically continuous processing. Specifically, a plate making line wherein the plate setter and the development apparatus are connected with each other by transport means, for example, a conveyer is illustrated. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferable that the plate making line is blinded by a filter, a cover or the like.

After the image formation, the entire surface of lithographic printing plate may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams are exemplified. In order to obtain sufficient printing durability, the amount of the entire surface exposure is preferably 10 $mJ/cm^2$ or more, more preferably 100 $mJ/cm^2$ or more.

Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150˚C, more preferably from 35 to 130˚C, still more preferably from 40 to 120˚C.

(Plate making)

The lithographic printing plate precursor according to the invention is exposed imagewise with a semiconductor laser or a solid laser as described above, if desired, heated the entire surface of the exposed lithographic printing plate precursor as described above, and then subjected to printing by supplying oily ink and an aqueous component without undergoing any development processing step. Specifically, for example, a method wherein the lithographic printing plate precursor is exposed with a laser, optionally heated the entire surface thereof in an oven and then mounted on a printing machine to conduct printing without undergoing the development processing step and a method wherein the lithographic printing plate precursor is mounted on a printing machine, exposed it with a laser on the printing machine, optionally heated the entire surface thereof on the printing machine and then subjected to printing without undergoing the development processing step are exemplified.

For instance, according to one embodiment of the plate making method of a negative-working lithographic printing plate precursor of on-press development type, after the imagewise exposure of the lithographic printing plate precursor with a laser, when an aqueous component and oily ink are supplied to conduct printing without undergoing the development processing step, for example, a wet development processing step, in the exposed area of the photosensitive layer, the photosensitive layer cured by the exposure forms the oily ink receptive area having the oleophilic surface. On the other hand, in the unexposed area, the uncured photosensitive layer is removed by dissolution or dispersion with the aqueous component and/or oily ink supplied to reveal the surface of support in the area. As a result, the aqueous component adheres on the revealed surface of support and the oily ink adheres to the exposed area of the photosensitive layer, whereby printing is initiated. While either the aqueous component or oily ink may be supplied at first on the surface of lithographic printing plate precursor, it is preferred to supply the oily ink at first in view of preventing the aqueous component from contamination with the unexposed area of the photosensitive layer. For the aqueous component and oily ink, dampening water and printing ink for conventional lithographic printing are used respectively.

Thus, the lithographic printing plate precursor is subjected to the on-press development on the printing machine and used as it is for printing a large number of sheets.

In accordance with another embodiment of the plate making method of the lithographic printing plate precursor according to the invention, the lithographic printing plate precursor is exposed imagewise with a laser, if desired, heated the entire surface of the exposed lithographic printing plate precursor as described above, and then rubbed a surface of the exposed lithographic printing plate precursor with a rubbing member in the presence of a developer having pH of 2 to 10 in an automatic processor equipped with the rubbing member to remove the unexposed area of the photosensitive layer, thereby preparing a lithographic printing plate.

The developer for use in the invention is preferably, for example, water alone or an aqueous solution containing water as a main component (containing 60% by weight or more of water). Particularly, an aqueous solution having the composition similar to that of conventionally known dampening water, an aqueous solution containing a surfactant (for example, an anionic, nonionic, cationic or amphoteric surfactant) and an aqueous solution containing a water-soluble

polymer compound are preferable. An aqueous solution containing both the surfactant and the water-soluble polymer compound is especially preferable. The pH of the developer is more preferably from 3 to 8, and still more preferably from 4 to 7.

The anionic surfactant for use in the invention includes, for example, fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxypolyoxy ethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenyl ether phosphate ester salts, partially saponified products of styrene-maleic anhydride copolymer, partially saponified products of olefin-maleic anhydride copolymer and naphthalene sulfonate formalin condensates. Of the compounds, dialkylsulfosuccinic acid salts, alkyl sulfate ester salts and alkylnaphthalenesulfonic acid salts are particularly preferably used.

The cationic surfactant for use in the invention is not particularly limited and conventionally known cationic surfactants can be used. Examples of the cationic surfactant include alkylamine salts, quaternary ammonium salts, polyoxyethylene alkyl amine salts and polyethylene polyamine derivatives.

The nonionic surfactant for use in the invention includes, for example, polyethylene glycol type higher alcohol ethylene oxide addacts, alkylphenol ethylene oxide addacts, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols and fatty acid amides of alkanolamines.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferable.

Further, from the standpoint of stable solubility in water or opacity, with respect to the nonionic surfactant used in the developer according to the invention, the HLB (hydrophile-lipophile balance) value thereof is preferably 6 or more, more preferably 8 or more.

Furthermore, an oxyethylene adduct of acetylene glycol type or acetylene alcohol type or a surfactant, for example, a fluorine-based surfactant or a silicon-based surfactant can also be used.

The amphoteric surfactant for use in the invention includes, for example, 2-alkylimidazoline derivatives, alkyl aminoacetates, alkyl iminodiacetates, alkyl aminopropionates, alkyl iminodipropionates, alkyl dimethyl ammonio acetates, alkylamidopropyl dimethyl ammonio acetates, alkyl sulfobetaines, alkyl diaminoethyl glycine salts and alkyl phosphobetaines. In the invention, alkyl aminoacetates, alkyl iminodiacetates, alkyl aminopropionates, alkyl iminodipropionates, alkyl dimethyl ammonio acetates and alkylamidopropyl dimethyl ammonio acetates are preferable, and alkyl dimethyl ammonio acetates and alkylamidopropyl dimethyl ammonio acetates are more preferable.

Of the surfactants used in the developer according to the invention, the nonionic surfactant, anionic surfactant and amphoteric surfactant are preferable, and the nonionic surfactant and amphoteric surfactant are particularly preferable.

The surfactants may be used individually or as a mixture of two or more thereof. The content of the surfactant in the developer is preferably from 0.01 to 10% by weight, more preferably from 0.01 to 5% by weight.

The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, those known can be used. For example, as a commercial product, Soyafive (trade name, produced by Fuji Oil Co., Ltd.) is available and various grade products can be used. The soybean polysaccharide preferably used has viscosity in a range from 10 to 100 mPa/sec in a 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound in the developer is preferably from 0.1 to 20% by weight, more preferably from 0.5 to 10%

by weight.

The developer according to the invention may contain an organic solvent. The organic solvent that can be contained in the developer include, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (e.g., methylene dichloride, ethylene dichloride, trichlene or monochlorobenzene) and a polar solvent.

Examples of the polar solvent include an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methyl amyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains the organic solvent, the concentration of the organic solvent is desirably less than 40% by weight in view of safety and inflammability.

Into the developer according to the invention, an antiseptic agent, a chelating agent, a defoaming agent, an organic acid, an inorganic acid, an inorganic salt or the like can be incorporated in addition to the above components.

As the antiseptic agent, for example, phenol or a derivative thereof, formalin, an imidazole derivative, sodium dehydroacetate, a 4-isothiazolin-3-one derivative, benzisotiazolin-3-one, a benzotriazole derivative, an amidine guanidine derivative, a quaternary ammonium salt, a pyridine derivative, a quinoline derivative, a guanidine derivative, diazine, a triazole derivative, oxazole, an oxazine derivative and a nitro bromo alcohol, e.g., 2-bromo-2-nitropropane-1,3-diol, 1,1-dibromo-1-nitro-2-ethanol or 1,1-dibromo-1-nitro-2-propanol are preferably used.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; organic phosphonic acids, for example, 1-hydroxyethane-1,1-diphosphonic acid, potassium salt thereof, sodium salt thereof; aminotri(methylenephosphonic acid), potassium salt thereof, sodium salt thereof; and phophonoalkanetricarboxylic acids are illustrated. A salt of an organic amine is also effectively used in place of the sodium salt or potassium salt in the chelating agents described above.

As the defoaming agent, for example, a conventional silicone-based self-emulsifying type or emulsifying type defoaming agent and a nonionic surfactant having HLB of 5 or less are used. The silicone defoaming agent is preferably used. Any of emulsifying dispersing type and solubilizing type can be used.

As the organic acid, for example, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and an organic phosphonic acid are illustrated. The organic acid can also be used in the form of an alkali metal salt or an ammonium salt.

As the inorganic acid and inorganic salt, for example, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate and nickel sulfate are illustrated.

The developer described above can be used as a developer and a development replenisher for the exposed lithographic printing plate precursor and it is preferably applied to an automatic processor described hereinafter. In the case of conducting the development processing using the automatic processor, the developer becomes fatigued in accordance with the processing amount, and hence the processing ability may be restored using a replenisher or a fresh developer. Such a replenishment system can be preferably applied to the plate making method of the lithographic printing plate precursor according to the invention.

The development processing using the aqueous solution having pH of 2 to 10 according to the invention is preferably performed by an automatic processor equipped with a supplying means for a developer and a rubbing member. As the automatic processor, there are illustrated an automatic processor in which a lithographic printing plate precursor after image exposure is subjected to a rubbing treatment while it is transporting described in JP-A-2-220061 and JP-A-60-59351, and an automatic processor in which a lithographic printing plate precursor after image exposure placed on a cylinder is subjected to a rubbing treatment while rotating the cylinder described in U.S. Patents 5,148,746 and 5,568,768 and British Patent 2,297,719. Among them, an automatic processor using a rotating brush roll as the rubbing

member is particularly preferred.

The rotating brush roller which can be preferably used in the invention can be appropriately selected by taking account, for example, of scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is closely radially wound around a plastic or metal roller acting as a core, can be used.

As the brush material, a plastic fiber (for example, a polyester-based synthetic fiber, e.g., polyethylene terephthalate or polybutylene terephthalate; a polyamide-based synthetic fiber, e.g., nylon 6.6 or nylon 6.10; a polyacrylic synthetic fiber, e.g., polyacrylonitrile or polyalkyl (meth)acrylate; and a polyolefin-based synthetic fiber, e.g., polypropylene or polystyrene) can be used. For instance, a brush material having a fiber bristle diameter of 20 to 400 μm and a bristle length of 5 to 30 mm can be preferably used. The outer diameter of the rotating brush roller is preferably from 30 to 200 mm, and the peripheral velocity at the tip of the brush rubbing the plate surface is preferably from 0.1 to 5 m/sec. It is preferred to use a plurality, that is, two or more of the rotating brush rollers.

The rotary direction of the rotating brush roller for use in the invention may be the same direction or the opposite direction with respect to the transporting direction of the lithographic printing plate precursor according to the invention, but when two or more rotating brush rollers are used in an automatic processor as shown in Fig. 4, it is preferred that at least one rotating brush roller rotates in the same direction and at least one rotating brush roller rotates in the opposite direction with respect to the transporting direction. By such an arrangement, the photosensitive layer in the non-image area can be more steadily removed. Further, a technique of rocking the rotating brush roller in the rotation axis direction of the brush roller is also effective.

The developer can be used at an appropriate temperature, and is preferably used at 10 to 50˚C. In the invention, the lithographic printing plate after the treatment described above may be subsequently subjected to water washing, a drying treatment and an oil-desensitization treatment, if desired. In the oil-desensitization treatment, a known oil-desensitizing solution can be used.

## EXAMPLES

The present invention will be described in more detail with reference to the following examples, but the invention should not be construed as being limited thereto.

### Examples 1 to 4 and Comparative Examples 1 to 2

(Preparation of Aluminum support 1)

An aluminum plate (material: JIS A1050) having a thickness of 0.3 mm was subjected to a degrease treatment with an aqueous 10% by weight sodium aluminate solution at 50˚C for 30 seconds in order to remove rolling oil on the surface thereof Thereafter, the aluminum plate surface was grained using three nylon brushes implanted with bundled bristles having a diameter of 0.3 mm and an aqueous suspension (specific gravity: 1.1 g/cm$^3$) of pumice having a median diameter of 25 μm, and then thoroughly washed with water. The plate was etched by dipping it in an aqueous 25% by weight sodium hydroxide solution at 45˚C for 9 seconds and after washing with water, dipped in an aqueous 20% by weight nitric acid solution at 60˚C for 20 seconds, followed by washing with water. The etching amount of the grained surface was about 3 g/m$^2$.

Subsequently, the aluminum plate was subjected to a continuous electrochemical surface roughening treatment using alternate current voltage of 60 Hz. The electrolytic solution used was an aqueous 1% by weight nitric acid solution (containing 0.5% by weight of aluminum ion) at a liquid temperature of 50˚C. The electrochemical surface roughening treatment was performed using a rectangular wave alternate current having a trapezoidal waveform such that the time TP necessary for the current value to reach the peak from zero was 0.8 msec and the duty ratio was 1:1, and disposing a carbon electrode as the counter electrode. The auxiliary anode used was a ferrite. The current density was 30 A/dm$^2$ in terms of the peak value of current, and 5% of the current flowing from the power source was divided to the auxiliary anode. The quantity of electricity at the nitric acid electrolysis was 175 C/dm$^2$ when the aluminum plate was serving as the anode. Then, the aluminum plate was washed with water by spraying.

Then, the aluminum plate was subjected to an electrochemical surface roughening treatment in the same manner as in the nitric acid electrolysis above using, as the electrolytic solution, an aqueous 0.5% by weight hydrochloric acid solution (containing 0.5% by weight of aluminum ion) at a liquid temperature of 50˚C under the conditions that the quantity of electricity was 50 C/dm$^2$ when the aluminum plate was serving as the anode, and then washed with water by spraying. The plate was then treated in an aqueous 15% by weight sulfuric acid solution (containing 0.5% by weight

of aluminum ion) as the electrolytic solution at a current density of 15 A/$dm^2$ to provide a direct current anodic oxide film of 2.5 g/$m^2$, thereafter washed with water and dried, thereby preparing Aluminum support 1.

The center line average roughness (Ra) of the thus-obtained aluminum support was measured using a stylus having a diameter of 2 μm and found to be 0.51 μm.

<Preparation of Lithographic printing plate precursors 1 to 6>

Coating solution 1 for undercoat layer having the composition shown below was coated on Aluminum support 1 obtained above and dried at 100˚C for 3 minutes. The coating amount of the undercoat layer formed was 10 mg/$m^2$.

| (Coating solution 1 for undercoat layer) | |
|---|---|
| 20% by weight NMP solution of polymer compound shown in Table A below | 2.5 g |
| N-Methylpyrrolidone | 49.0 g |
| Methanol | 450.0 g |
| - Water | 1.5 g |

Coating solution 1 for image-forming layer having the composition shown below was coated on the undercoat layer obtained above and dried at 80˚C for one minute. The coating amount of the image-forming layer formed was 1.2 g/$m^2$.

| (Coating solution 1 for image-forming layer) | |
|---|---|
| Binder Polymer (1) shown below | 0.54 g |
| Polymerizable Compound (1) | 0.48 g |
| Isocyanuric acid EO-modified triacrylate (Aronics M-315, produced by Toa Gosei Co., Ltd.) | |
| Sensitizing Dye (1) shown below | 0.06 g |
| Polymerization Initiator (1) shown below | 0.10 g |
| Co-sensitizer (1) shown below | 0.07 g |
| Dispersion of ε-phthalocyanine pigment | 0.40 g |
| [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/ 20 parts by weight/40 parts by weight)] | |
| Methyl ethyl ketone | 4.80 g |
| Dimethylsulfoxide | 4.80 g |

Binder Polymer (1):

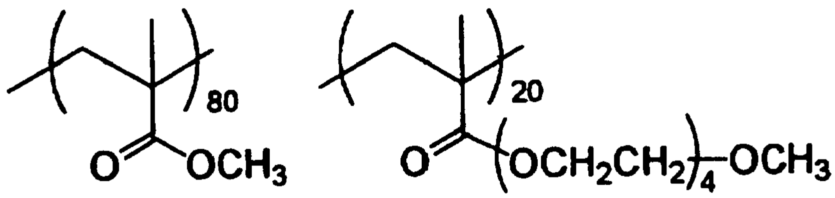

Sensitizing Dye (1):

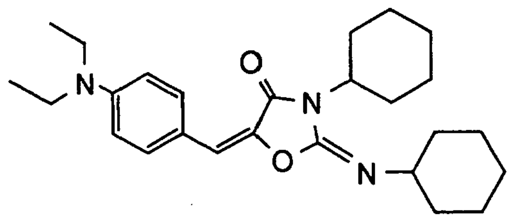

Polymerization Initiator (1):

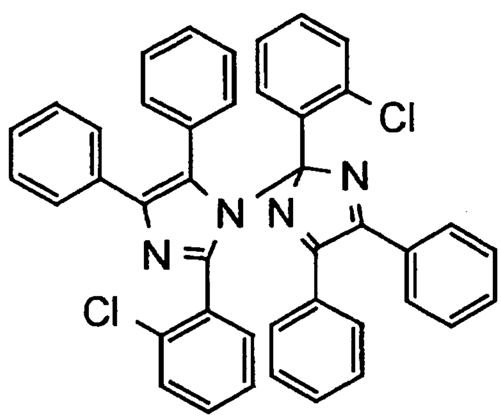

Co-sensitizer (1):

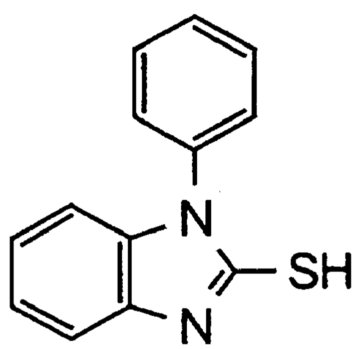

Coating solution 1 for protective layer having the composition shown below was coated on the image-forming layer using a bar and dried at 125˚C for 70 seconds to form a protective layer having a coating amount of 0.50 g/$m^2$, thereby preparing Lithographic printing plate precursors 1 to 6, respectively.

(Coating solution 1 for protective layer)

| | |
|---|---|
| Polyvinyl alcohol (saponification degree: 98% by mole; polymerization degree: 500) | 40 g |
| Polyvinyl pyrrolidone (molecular weight: 50,000) | 5 g |
| Vinyl pyrrolidone/vinyl acetate (1/1) copolymer (molecular weight: 70,000) | 0.5 g |
| Surfactant (Emalex 710, produced by Nihon-Emulsion Co., Ltd.) | 0.5 g |
| Water | 950 g |

<Exposure, Development and Printing>

Each of Lithographic printing plate precursors 1 to 6 was subjected to imagewise exposure using a semiconductor laser of 405 nm having an output of 100 mW with varying energy density.

Then, development processing was performed in an automatic development processor having a structure shown in Fig. 1 using Aqueous solution A (pH: 7) shown below to prepare a lithographic printing plate (without heating). The automatic development processor had two rotating brush rollers. The first brush roller was a brush roller having an outer diameter of 90 mm and being implanted with fiber of polybutylene terephthalate (bristle diameter: 200 μm, bristle length: 17 mm), and the brush roller was rotated at 200 rpm (peripheral velocity at the tip of brush: 0.94 m/sec) in the same direction as the transporting direction. The second brush roller was a brush roller having an outer diameter of 60 mm and being implanted with fiber of polybutylene terephthalate (bristle diameter: 200μm, bristle length: 17 mm), and the brush roller was rotated at 200 rpm (peripheral velocity at the tip of brush: 0.63 m/sec) in the opposite direction to the transporting direction. The transportation of the lithographic printing plate precursor was performed at transporting speed of 100 cm/min.

Aqueous solution A was supplied on the surface of the lithographic printing plate precursor by showering from a spray pipe using a circulation pump. The tank volume for Aqueous solution A was 10 liters.

(Aqueous solution A)

| | |
|---|---|
| Water | 100.00 g |
| Benzyl alcohol | 1.00 g |
| Polyoxyethylene naphthyl ether (average number of oxyethylene: n = 13) | 1.00 g |
| Sodium salt of dioctylsulfosuccinic acid ester | 0.50 g |
| Ethylene glycol | 0.50 g |
| Ammonium primary phosphate | 0.05 g |
| Citric acid | 0.05 g |

On the other hand, within 30 seconds after the laser imagewise exposure, the exposed lithographic printing plate precursor was put in an oven and heated the entire surface of the lithographic printing plate precursor by blowing hot air to maintain at 110˚C for 15 seconds and then the development processing was performed within 30 seconds in the same manner as described above to prepare a lithographic printing plate (with heating).

Further, each of Lithographic printing plate precursors 1 to 6 was packed with aluminum kraft paper and allowed to stand in an oven at 60˚C for 3 days. Then, the lithographic printing plate precursor was subjected to the imagewise exposure with laser and development processing in the same manner as described above to prepare a lithographic printing plate (forced preservation).

Then, each of the lithographic printing plate (without heating), the lithographic printing plate (with heating) and the lithographic printing plate (forced preservation) was mounted on a printing machine (SOR-M, produced by Heidelberg) and printing was performed at a printing speed of 6,000 sheets per hour using dampening water (EU-3 (etching solution,

produced by Fuji Film Co., Ltd.))/water/isopropyl alcohol = 1/89/10 (by volume ratio)) and TRANS-G (N) black ink (produced by Dainippon Ink & Chemicals, Inc.).

<Evaluation>

With respect to the lithographic printing plates prepared above, the printing durability and stain resistance were evaluated in the following manner. The results obtained are shown in Table A.

<Printing durability>

As increase in the number of printing sheets according to the printing as described above, the image-forming layer was gradually abraded to cause decrease in the ink receptivity, resulting in decrease of ink density on a printed material. With respect to the lithographic printing plate obtained by the exposure in the same exposure amount (energy density), a number of printed materials obtained until the ink density (reflection density) decreased by 0.1 from that at the initiation of printing was determined to relatively evaluate the printing durability. Specifically, the printing durability was calculated according to the formula shown below using Comparative Example 1 as the criterion (100). As the value increases, the printing durability becomes higher.

Printing durability = (Number of printed materials of subject lithographic printing plate)/(Number of printed materials of criterion lithographic printing plate) x 100

<Stain resistance>

The 500th sheet of the printed material from the initiation of printing was picked up and the density of ink adhered on the non-image area was measured to relatively evaluate the stain resistance. Specifically, the stain resistance was calculated according to the formula shown below using Comparative Example 1 as the criterion (100). As the value increases, the density of ink adhered on the non-image area decreases, that is, the stain resistance becomes better.

Stain resistance = (Ink density of non-image area on printed material of criterion lithographic printing plate)/(Ink density of non-image area on printed material of subject lithographic printing plate) x 100

TABLE A

| | Lithographic Printing Plate Precursor | Polymer Compound | Printing Durability | | | Stain Resistance | | |
|---|---|---|---|---|---|---|---|---|
| | | | Without Heating | With Heating | Forced Preservation | Without Heating | With Heating | Forced Preservation |
| Example 1 | 1 | (A-1) | 150 | 160 | 150 | 100 | 100 | 100 |
| Example 2 | 2 | (G-1) | 160 | 170 | 160 | 100 | 100 | 100 |
| Example 3 | 3 | (B-2) | 140 | 150 | 140 | 100 | 100 | 100 |
| Example 4 | 4 | (E-2) | 130 | 150 | 130 | 100 | 100 | 100 |
| Comparative Example 1 | 5 | (1) | 100 | 100 | 100 | 100 | 100 | 100 |
| Comparative Example 2 | 6 | (10) | 160 | 180 | 160 | 100 | 90 | 60 |

Polymer Compound (A-1):

A solution prepared by adding 2.66 g of Basic radical polymerizable compound (A) to 10 g of an NMP solution (concentration: 25% by weight) of Polymer compound (1) (weight average molecular weight: 100,000) and the concentration was adjusted to 20% by weight with NMP.

Polymer Compound (G-1):

A solution prepared by adding 7.28 g of Basic radical polymerizable compound (G) to 10 g of an NMP solution (concentration: 25% by weight) of Polymer compound (1) (weight average molecular weight: 100,000) and the concentration was adjusted to 20% by weight with NMP.

Polymer Compound (B-2):

A solution prepared by adding 5.00 g of Basic radical polymerizable compound (B) to 10 g of an NMP solution (concentration: 20% by weight) of Polymer compound (2) (weight average molecular weight: 150,000) and the concentration was adjusted to 20% by weight with NMP. Polymer Compound (E-2):

A solution prepared by adding 1.12 g of Basic radical polymerizable compound (E) to 10 g of an NMP solution (concentration: 20% by weight) of Polymer compound (2) (weight average molecular weight: 150,000) and the concentration was adjusted to 20% by weight with NMP.

Polymer Compound (10) (weight average molecular weight: 100,000):

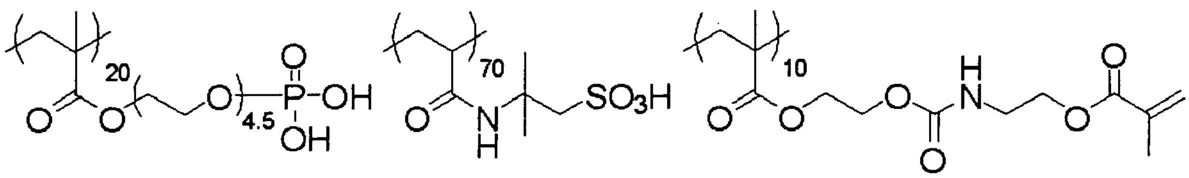

As can be seen from the results shown in Table A, the case of using the polymer compound neutralized with the basic radical polymerizable compound according to the invention can increase the printing durability while maintaining the stain resistance in comparison with the case (Comparative Example 1) of using the polymer compound which is not neutralized. Also, in comparison with the case of using Polymer Compound (10) in the prior art, the stain resistance after the forced preservation is remarkably improved while maintaining the nearly equivalent printing durability.

<u>Example 5 and Comparative Example 3</u>

<Preparation of Lithographic printing plate precursors 7 to 8>

Lithographic printing plate precursors 7 to 8 were prepared in the same manner as in Lithographic printing plate precursors 1 and 5 except for changing Coating solution 1 for image-forming layer to Coating solution 2 for image-forming layer shown below and changing Coating solution 1 for protective layer to Coating solution 2 for protective layer shown below, respectively.

(Coating solution 2 for image-forming layer)

| | |
|---|---|
| Binder Polymer (2) shown below | 0.54 g |
| Polymerizable Compound (2) shown below | 0.48 g |
| Sensitizing Dye (1) shown above | 0.06 g |

(continued)

(Coating solution 2 for image-forming layer)

| | |
|---|---|
| Polymerization Initiator (1) shown above | 0.18 g |
| Co-sensitizer (1) shown above | 0.07 g |
| Dispersion of ε-phthalocyanine pigment | 0.40 g |
| [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | 0.01 g |
| N-nitrosophenylhydroxylamine aluminum salt | |
| Fluorine-Based Surfactant (1) shown below | 0.001 g |
| Polyoxyethylene-polyoxypropylene condensate | 0.04 g |
| (Pluronic L44, produced by ADEKA Corp.) | |
| Tetraethylamine hydrochloride | 0.01 g |
| 1-Methoxy-2-propanol | 3.5 g |
| Methyl ethyl ketone | 8.0 g |

Polymerizable Compound (2):

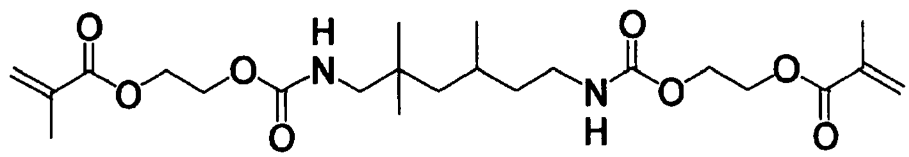

Binder Polymer (2):

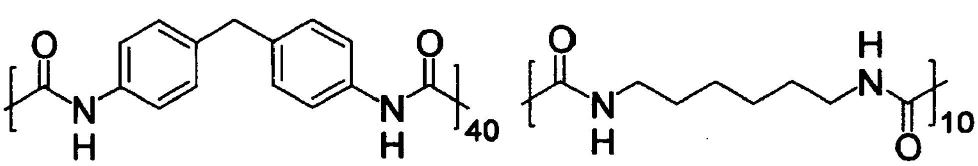

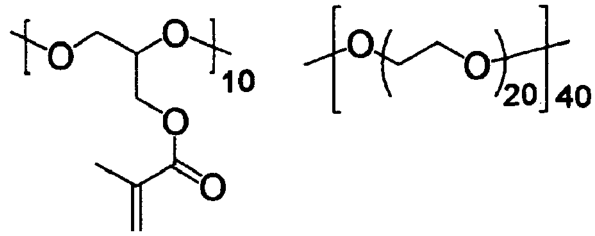

Fluorine-Based Surfactant (1):

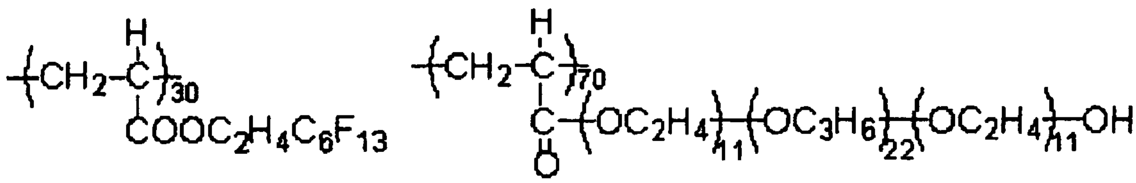

| | |
|---|---|
| (Coating solution 2 for protective layer) | |
| Dispersion of Mica (1) shown below | 13.00 g |
| Polyvinyl alcohol (saponification degree: 98% by mole; polymerization degree: 500) | 1.30 g |
| Sodium 2-ethylhexylsulfosuccinate | 0.20 g |
| Vinyl pyrrolidone/vinyl acetate (1/1) copolymer (molecular weight: 70,000) | 0.05 g |
| Surfactant (Emalex 710, produced by Nihon-Emulsion Co., Ltd.) | 0.05 g |
| Water - | 133.00 g |

(Preparation of Dispersion of Mica (1))

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 μm to obtain Dispersion of Mica (1).

Lithographic printing plate precursors 7 to 8 thus-obtained were subjected to the exposure, development and printing in the same manner as in Example 1 and evaluated in the same manner as in Example 1. The results obtained are shown in Table B. As the criterion (100) for the relative evaluation, Comparative Example 3 was used.

TABLE B

| | Lithographic Printing Plate Precursor | Polymer Compound | Printing Durability | | | Stain Resistance | | |
|---|---|---|---|---|---|---|---|---|
| | | | Without Heating | With Heating | Forced Preservation | Without Heating | With Heating | Forced Preservation |
| Example 5 | 7 | (A-1) | 160 | 165 | 160 | 100 | 100 | 100 |
| Comparative Example 3 | 8 | (1) | 100 | 100 | 100 | 100 | 100 | 100 |

Examples 6 to 7 and Comparative Examples 4 to 5

(Preparation of Aluminum support 2)

An aluminum plate (material: JIS A1050) having a thickness of 0.3 mm was subjected to surface treatment by performing processes (a) to (k) shown below in this order.

(a) Mechanical surface roughening treatment
Mechanical surface roughening of the aluminum plate was conducted by means of rotating roller-form nylon brushes while supplying a suspension (having specific gravity of 1.12) of an abrasive (silica sand) in water as an abrasion slurry solution to the surface of the aluminum plate. The average particle size of the abrasive was 8 μm and the maximum particle size was 50 μm. The material of the nylon brush was 6·10 nylon, and the brush has a bristle length of 50 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) provided under the brush rollers were spaced 300 mm. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushes was 200 rpm.
(b) Alkali etching treatment
Etching treatment of the aluminum plate was conducted by spraying an aqueous sodium hydroxide solution (sodium hydroxide concentration: 26% by weight, aluminum ion concentration: 6.5% by weight) having temperature of 70˚C to dissolve the aluminum plate in an amount of 6 g/$m^2$, followed by washing by spraying well water.
(c) Desmut treatment
Desmut treatment of the aluminum plate was conducted by spraying an aqueous 1% by weight nitric acid solution (containing 0.5% by weight of aluminum ion) having temperature of 30˚C, followed by washing with water by spraying. The aqueous nitric acid solution used for the desmut treatment was a waste solution of the electrolytic solution from the process of (d) described below.
(d) Electrochemical surface roughening treatment
Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion) and the solution temperature was 50˚C. The electrochemical surface roughening treatment was conducted using an alternating current source, which provided a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/$dm^2$ at the peak current, and the electric amount was 220 C/$dm^2$ in terms of the total electric quantity during the aluminum plate functioning as an anode. To the auxiliary anode, 5% of the current from the electric source was divided. Subsequently, the plate was washed by spraying well water.
(e) Alkali etching treatment
Etching treatment of the aluminum plate was conducted at 32˚C by spraying an aqueous solution having a sodium hydroxide concentration of 26% by weight and an aluminum ion concentration of 6.5% by weight to dissolve the aluminum plate in an amount of 0.20 g/$m^2$. Thus, the smut component mainly comprising aluminum hydroxide formed in the precedent process of (d) was removed and an edge portion of the pit formed was dissolved to smoothen the edge portion. Subsequently, the plate was washed by spraying well water.
(f) Desmut treatment
Desmut treatment of the aluminum plate was conducted by spraying an aqueous 15% by weight nitric acid solution (containing 4.5% by weight of aluminum ion) having temperature of 30˚C, followed by washing by spraying well water. The aqueous nitric acid solution used for the desmut treatment was a waste solution of the electrolytic solution from the process of (d) described above.
(g) Electrochemical surface roughening treatment
Electrochemical surface roughening treatment of the aluminum plate was continuously conducted by applying 60 Hz alternating current voltage. The electrolytic solution used was an aqueous solution containing 7.5 g/liter of hydrochloric acid (containing 5 g/liter of aluminum ion) and the solution temperature was 35˚C. The electrochemical surface roughening treatment was conducted using an alternating current source which provided a rectangular wave alternating current and using a carbon electrode as a counter electrode. A ferrite was used as an auxiliary anode. The electrolytic cell used was a radial cell type. The current density was 25 A/$dm^2$ at the peak current, and the electric amount was 50 C/$dm^2$ in terms of the total electric quantity during the aluminum plate functioning as an

anode. Subsequently, the plate was washed by spraying well water.

(h) Alkali etching treatment

Etching treatment of the aluminum plate was conducted at 32˚C by spraying an aqueous solution having a sodium hydroxide concentration of 26% by weight and an aluminum ion concentration of 6.5% by weight to dissolve the aluminum plate in an amount of 0.10 g/$m^2$. Thus, the smut component mainly comprising aluminum hydroxide formed in the precedent process of (g) was removed and an edge portion of the pit formed was dissolved to smoothen the edge portion. Subsequently, the plate was washed by spraying well water.

(i) Desmut treatment

Desmut treatment of the aluminum plate was conducted by spraying an aqueous 25% by weight sulfuric acid solution (containing 0.5% by weight of aluminum ion) having temperature of 60˚C, followed by washing by spraying well water.

(j) Anodizing treatment

Anodizing treatment of the aluminum plate was conducted using as an electrolytic solution, an aqueous solution having sulfuric acid concentration of 170 g/liter (containing 0.5% by weight of aluminum ion) at 43˚C. The current density was about 30 A/$dm^2$. Subsequently, the plate was washed by spraying well water. The amount of the final anodic oxide film was 2.7 g /$m^2$.

(k) Alkali metal silicate treatment

Alkali metal silicate treatment (silicate treatment) of the aluminum plate was conducted by immersing the aluminum plate in an aqueous 1% by weight sodium silicate No. 3 solution having temperature of 30˚C for 10 seconds. Subsequently, the plate was washed by spraying well water, whereby Aluminum support 2 was prepared. The adhesion amount of the silicate was 3.6 mg/$m^2$.

<Preparation of Lithographic printing plate precursors 9 to 12>

Coating solution 2 for undercoat layer having the composition shown below was coated on Aluminum support 2 obtained above and dried at 100˚C for 3 minutes. The coating amount of the undercoat layer formed was 7 mg/$m^2$. -

(Coating solution 2 for undercoat layer)

| | |
|---|---|
| 20% by weight NMP solution of polymer compound shown in Table C below | 2.5 g |
| N-Methylpyrrolidone | 50.0 g |
| Methanol | 450.0 g |

Coating solution 3 for image-forming layer having the composition shown below was coated on the undercoat layer obtained above using a bar and dried in an oven at 70˚C for 60 seconds to form an image-forming layer having a dry coating amount of 1.1 g/$m^2$.

Coating solution 3 for image-forming layer was prepared by mixing Photosensitive Solution (1) shown below with Microcapsule Solution (1) shown below just before coating.

<Photosensitive Solution (1)>

| | |
|---|---|
| Binder Polymer (3) shown below | 0.162 g |
| Polymerization Initiator (2) shown below | 0.160 g |
| Polymerization Initiator (3) shown below | 0.180 g |
| Infrared Absorbing Agent (1) shown below | 0.020 g |
| Polymerizable compound (Aronics M-215, produced by Toa Gosei Co., Ltd.) | 0.385 g |
| Fluorine-Based Surfactant (1) shown above | 0.044 g |

(continued)

| | |
|---|---|
| <Photosensitive Solution (1)> | |
| Methyl ethyl ketone | 1.091 g |
| 1-Methoxy-2-propanol | 8.210 g |

Binder Polymer (3):

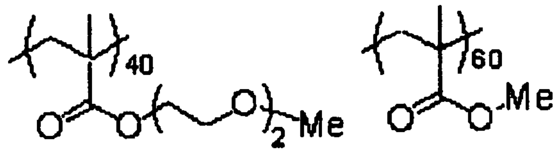

Polymerization Initiator (3):

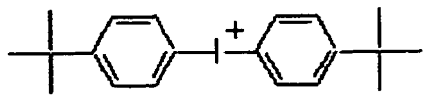

$C_4F_9-SO_3^-$

Polymerization Initiator (2):

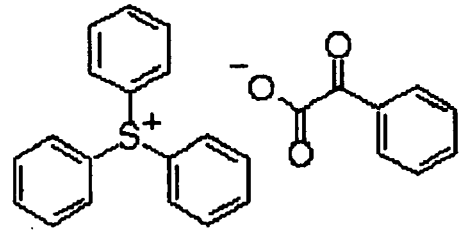

Infrared Absorbing Agent (1):

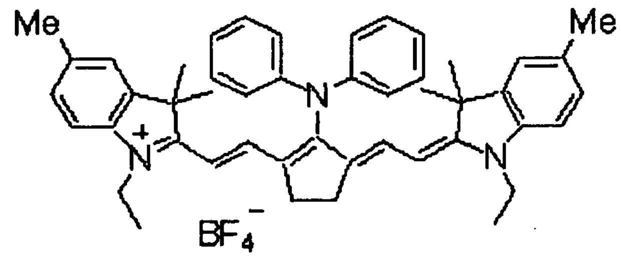

<Microcapsule Solution (1)>

| | |
|---|---|
| Microcapsule (1) prepared as shown below | 2.640 g |
| Water | 2.425 g |

Preparation of Microcapsule (1)

As an oil phase component, 10 g of adduct of trimethylolpropane and xylene diisocyanate (Takenate D-110N, produced by Mitsui Takeda Chemicals, Inc., 75% by weight ethyl acetate solution), 6.00 g of Aronics SR-399 (produced by Toa Gosei Co., Ltd.) and 0.12 g of Pionin A-41C (produced by Takemoto Oil & Fat Co., Ltd.) were dissolved in 16.67 g of ethyl acetate. As an aqueous phase component, 37.5 g of an aqueous 4% by weight PVA-205 solution was prepared. The oil phase component and the aqueous phase component were mixed and emulsified using a homogenizer at 12,000 rpm for 10 minutes. The resulting emulsion was added to 25 g of distilled water and the mixture was stirred at room temperature for 30 minutes and then stirred at 40˚C for 2 hours. The thus-obtained microcapsule solution was diluted with distilled water to have a solid content concentration of 15% by weight to prepare Microcapsule (1). The average particle size of the microcapsule was 0.2 μm.

Coating solution 3 for protective layer having the composition shown below was coated on the image-forming layer using a bar and dried in an oven at 125˚C for 75 seconds to form a protective layer having a dry coating amount of 0.15 g /$m^2$, thereby preparing Lithographic printing plate precursors 9 to 12, respectively.

(Coating solution 3 for protective layer)

| | |
|---|---|
| Polyvinyl alcohol (aqueous 6% by weight solution) (PVA 105, produced by Kuraray Co., Ltd., saponification degree: 98.5% by mole; polymerization degree: 500) | 2.24 g |
| Polyvinyl pyrrolidone (K 30) | 0.0053 g |
| Surfactant (aqueous 1% by weight solution) (Emalex 710, produced by Kao Corp.) | 2.15 g |
| Scale-like synthetic mica (aqueous 3.4% by weight dispersion)(MEB 3L, produced by UNICOO Co., Ltd., average particle size: 1 to 5 μm) | 3.75 g |
| Distilled water | 10.60 g |

(1) Exposure, Development and Printing

Each of Lithographic printing plate precursors 9 to 12 was exposed by Trendsetter 3244VX, produced by Creo Co., equipped with a water-cooled 40 W infrared semiconductor laser under the conditions of output of 9W, a rotational number of an outer surface drum of 210 rpm and resolution of 2,400 dpi.

Then, the development processing was performed using Aqueous solution B (pH: 7) shown below in the same manner as in Example 1 to prepare a lithographic printing plate (without heating).

(Aqueous solution B)

| | |
|---|---|
| Water | 100.00 g |
| Polyoxyethylene naphthyl ether (average number of oxyethylene: n = 13) | 0.50 g |
| Sodium salt of dioctylsulfosuccinic acid ester | 0.50 g |

(continued)

| | |
|---|---|
| Ammonium primary phosphate | 0.05 g |
| Citric acid | 0.05 g |

On the other hand, within 30 seconds after the laser imagewise exposure, the exposed lithographic printing plate precursor was put in an oven and heated the entire surface of the lithographic printing plate precursor by blowing hot air to maintain at 110˚C for 15 seconds and then the development processing was performed within 30 seconds in the same manner as described above to prepare a lithographic printing plate (with heating).

Further, each of Lithographic printing plate precursors 9 to 12 was packed with aluminum kraft paper and allowed to stand in an oven at 60˚C for 3 days. Then, the lithographic printing plate precursor was subjected to the imagewise exposure with laser and development processing in the same manner as described above to prepare a lithographic printing plate (forced preservation).

Then, using each of the lithographic printing plate (without heating), the lithographic printing plate (with heating) and the lithographic printing plate (forced preservation), the printing durability and stain resistance were evaluated in the same manner as in Example 1. The results obtained are shown in Table C. As the criterion (100) for the relative evaluation, Comparative Example 4 was used.

TABLE C

| | Lithographic Printing Plate Precursor | Polymer Compound | Printing Durability | | | Stain Resistance | | |
|---|---|---|---|---|---|---|---|---|
| | | | Without Heating | With Heating | Forced Preservation | Without Heating | With Heating | Forced Preservation |
| Example 6 | 9 | (A-1) | 700 | 800 | 700 | 100 | 100 | 100 |
| Example 7 | 10 | (G-1) | 800 | 900 | 800 | 100 | 100 | 100 |
| Comparative Example 4 | 11 | (1) | 100 | 100 | 100 | 100 | 100 | 100 |
| Comparative Example 5 | 12 | (10) | 1,000 | 1,100 | 1,000 | 100 | 90 | 60 |

Examples 8 to 9 and Comparative Examples 6 to 7

Each of Lithographic printing plate precursors 9 to 12 and those subjected to the forced preservation was exposed by Trendsetter 3244VX, produced by Creo Co., equipped with a water-cooled 40 W infrared semiconductor laser under the conditions of output of 9W, a rotational number of an outer surface drum of 210 rpm and resolution of 2,400 dpi. The exposed lithographic printing plate precursor was mounted without undergoing development processing on a cylinder of a printing machine (SOR-M, produced by Heidelberg Co.). After supplying each of Dampening water (1) having the composition shown below and TRANS-G (N) black ink (produced by Dainippon Ink & Chemicals, Inc.), printing was performed at a printing speed of 6,000 sheets per hour. The printing durability and stain resistance were evaluated in the same manner as in Example 1. The results obtained are shown in Table D. As the criterion (100) for the relative evaluation, Comparative Example 6 was used.

<Dampening water (1) >

| | |
|---|---|
| EU-3 (etching solution, produced by Fuji Film Co., Ltd.) | 1 part by weight |
| Water | 89 parts by weight |
| Isopropyl alcohol | 7 parts by weight |

TABLE D

| | Lithographic Printing Plate Precursor | Polymer Compound | Printing Durability | | Stain Resistance | |
|---|---|---|---|---|---|---|
| | | | Without Heating | Forced Preservation | Without Heating | Forced Preservation |
| Example 8 | 9 | (A-1) | 700 | 700 | 100 | 100 |
| Example 9 | 10 | (G-1) | 800 | 800 | 100 | 100 |
| Comparative Example 6 | 11 | (1) | 100 | 100 | 100 | 100 |
| Comparative Example 7 | 12 | (10) | 1,000 | 1,000 | 100 | 60 |

Example 10 and Comparative Example 8

<Preparation of Lithographic printing plate precursors 13 to 14>

Lithographic printing plate precursors 13 to 14 were prepared in the same manner as in Lithographic printing plate precursors 7 and 8 except for changing Coating solution 2 for image-forming layer to Coating solution 4 for image-forming layer shown below, respectively.

(Coating solution 4 for image-forming layer)

| | |
|---|---|
| Binder Polymer (4) shown below | 0.54 g |
| Polymerizable Compound (2) shown above | 0.48 g |
| Sensitizing Dye (1) shown above | 0.06 g |
| Polymerization Initiator (1) shown above | 0.18 g |
| Co-sensitizer (1) shown above | 0.07 g |

(continued)

| | |
|---|---|
| (Coating solution 4 for image-forming layer) | |
| Dispersion of ε-phthalocyanine pigment | 0.40 g |
| [pigment: 15 parts by weight; dispersing agent (allyl methacrylate/methacrylic acid (80/20) copolymer): 10 parts by weight; solvent (cyclohexanone/methoxypropyl acetate/1-methoxy-2-propanol = 15 parts by weight/20 parts by weight/40 parts by weight)] | |
| Thermal polymerization inhibitor | 0.01 g |
| N-nitrosophenylhydroxylamine aluminum salt | |
| Fluorine-Based Surfactant (1) shown above | 0.001 g |
| Polyoxyethylene-polyoxypropylene condensate (Pluronic L44, produced by ADEKA Corp.) | 0.04 g |
| Tetraethylamine hydrochloride | 0.01 g |
| 1-Methoxy-2-propanol | 3.5 g |
| Methyl ethyl ketone | 8.0 g |

Binder Polymer (4):

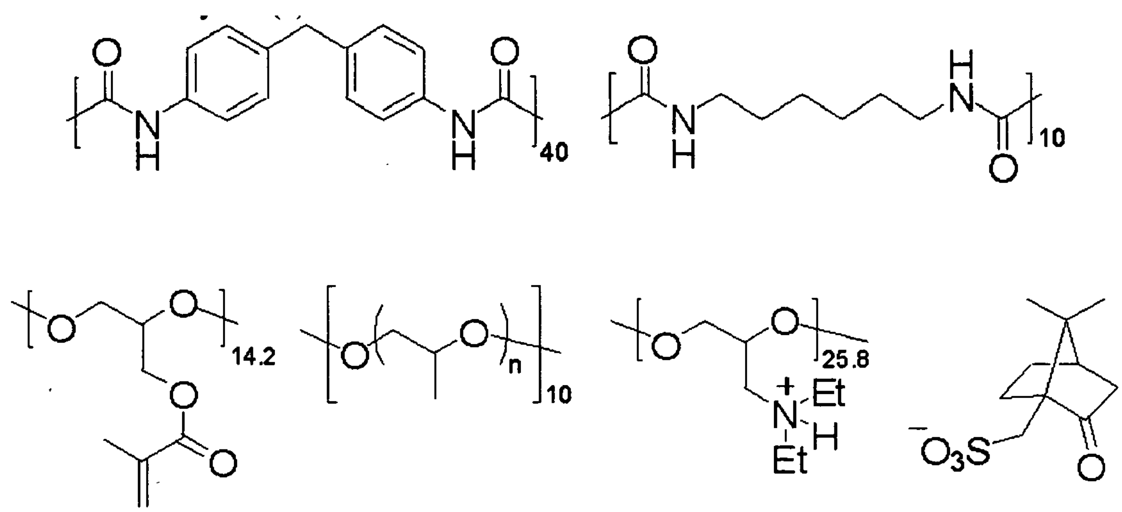

Lithographic printing plate precursors 13 to 14 thus-obtained were subjected to the exposure, development and printing in the same manner as in Example 5 except for changing Aqueous solution A to Aqueous solution C shown below and evaluated in the same manner as in Example 5. The results obtained are shown in Table E. As the criterion (100) for the relative evaluation, Comparative Example 8 was used.

| | |
|---|---|
| (Aqueous solution C) | |
| Water | 100.00 g |
| N-Lauryl dimethyl betaine | 10.00 g |

(continued)

| | |
|---|---|
| (Aqueous solution C) | |
| (Pionin C157K, produced by Takemoto Oil & Fat Co., Ltd.) | |
| Sodium dodecylbenzenesulfonate | 1.00 g |
| Ammonium primary phosphate | 0.05 g |
| Citric acid | 0.05 g |
| Tetrasodium ethylenediaminetetraacetate (pH was adjusted to 4.5 with phosphoric acid) | 0.05 g |

TABLE E

| | Lithographic Printing Plate Precursor | Polymer Compound | Printing Durability | | | Stain Resistance | | |
|---|---|---|---|---|---|---|---|---|
| | | | Without Heating | With Heating | Forced Preservation | Without Heating | With Heating | Forced Preservation |
| Example 10 | 13 | (A-1) | 160 | 165 | 160 | 100 | 100 | 100 |
| Comparative Example 8 | 14 | (1) | 100 | 100 | 100 | 100 | 100 | 100 |

Example 11 and Comparative Example 9

<Preparation of Lithographic printing plate precursors 15 to 16>

An aluminum plate (material: JIS A1050, thermal refining: H16) having a thickness of 0.24 mm was immersed in an aqueous 5% by weight sodium hydroxide solution maintained at 65˚C for one minute to conduct a degrease treatment and washed with water. The degreased aluminum plate was immersed in an aqueous 10% by weight hydrochloric acid solution maintained at 25˚C for one minute to neutralize and washed with water. The aluminum plate was subjected to electrolytic surface roughening with alternate current in an aqueous 0.3% by weight hydrochloric acid solution under conditions of 25˚C and current density of 100A/$dm^2$ for 60 seconds and then subjected to a desmut treatment in an aqueous 5% by weight sodium hydroxide solution maintained at 60˚C for 10 seconds. Further, the aluminum plate was subjected to an anodizing treatment in an aqueous 15% by weight sulfuric acid solution under conditions of 25˚C, current density of 10A/$dm^2$ and voltage of 15 V for one minute to prepare a support. Coating solution 3 for undercoat layer having the composition shown below was coated on the support and dried at 100˚C for 3 minutes. The coating amount of the undercoat layer was 10 mg/$m^2$. Coating solution 4 for image-forming layer described above was coated on the undercoat layer and dried at 80˚C for one minute. The coating amount of the image-forming layer was 1.2 g/$m^2$. Then, Coating solution 2 for protective layer described above was coated on the image-forming layer and dried at 125˚C for 70 seconds to form a protective layer having a coating amount of 0.75 g/$m^2$, thereby preparing Lithographic printing plate precursors 15 to 16, respectively.

(Coating solution 3 for undercoat layer)

| | |
|---|---|
| 20% by weight NMP solution of polymer compound shown in Table F below | 2.5 g |
| N-Methylpyrrolidone | 50.0 g |
| Methanol | 450.0 g |

Lithographic printing plate precursors 15 to 16 thus-obtained were subjected to the exposure, development and printing in the same manner as in Example 5 except for changing Aqueous solution A to Aqueous solution C shown above and evaluated in the same manner as in Example 5. The results obtained are shown in Table F. As the criterion (100) for the relative evaluation, Comparative Example 9 was used.

TABLE F

| | Lithographic Printing Plate Precursor | Polymer Compound | Printing Durability | | | Stain Resistance | | |
|---|---|---|---|---|---|---|---|---|
| | | | Without Heating | With Heating | Forced Preservation | Without Heating | With Heating | Forced Preservation |
| Example 11 | 15 | (A-1) | 160 | 165 | 160 | 100 | 100 | 100 |
| Comparative Example 9 | 16 | (1) | 100 | 100 | 100 | 100 | 100 | 100 |

As can be seen from the results shown in Tables B to F, the lithographic printing plate precursor according to the invention has high preservation stability and is excellent in balance between the printing durability and the stain resistance.

## Claims

1. A lithographic printing plate precursor comprising, in the folloiwng order: a support; an undercoat layer; and an image-forming layer, wherein the undercoat layer comprises a polymer compound having a support-adsorbing group and an acid group, and at least a part of the acid groups is neutralized with a radical polymerizable compound having at least one member selected from the group consisting of a secondary amino group, a tertiary amino group and a heterocyclic group having a basic nitrogen atom.

2. The lithographic printing plate precursor as claimed in Claim 1, wherein the acid group is a group selected from a sulfonic acid group, a carboxylic acid group, a phosphoric acid group, a phosphonic acid group and a sulfuric acid group.

3. The lithographic printing plate precursor as claimed in Claim 1, wherein the support-adsorbing group is a group selected from a phosphoric acid group, a phosphate group, a phosphonic acid group, a phosphonate group, an ammonium group, a siloxane group, a β-dicarbonyl group, a carboxylic acid group and a carboxylate group.

4. The lithographic printing plate precursor as claimed in any one of Claims 1 to 3, wherein the radical polymerizable compound is a compound having at least one functional group selected from radical polymerizable functional groups represented by the following formulae (1) to (3):

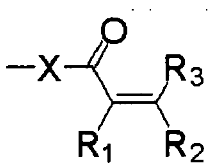 (1) 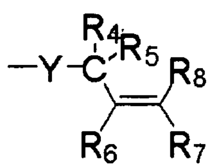 (2) 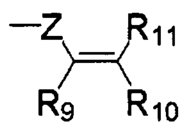 (3)

wherein $R_1$ to $R_{11}$ each independently represents a hydrogen atom, a halogen atom, an alkyl group, an aryl group, an alkynyl group, an alkenyl group, a cyano group, a nitro group, $-OR_{12}$, $-OCOR_{12}$, $-OCOOR_{12}$, $-OCONR_{12}R_{13}$, $-OSO_2R_{12}$, $-OSO_3R_{12}$, $-OSO_2NR_{12}R_{13}$, $-OPO(OR_{12})(OR_{13})$, $-OPO(OR_{12})(R_{13})$, $-OSiR_{12}R_{13}R_{14}$, $-SR_{12}$, $-SOR_{12}$, $-SO_2R_{12}$, $-SO_3R_{12}$, $-SO_2NR_{12}R_{13}$, $-NR_{12}R_{13}$, $-NR_{12}COR_{13}$, $-NR_{12}COOR_{13}$, $-NR_{12}CONR_{13}R_{14}$, $-N(COR_{12})COR_{13}$, $-NR_{12}SO_2R_{13}$, $-N(SO_2R_{12})(SO_2R_{13})$, $-COR_{12}$, $-COOR_{12}$, $-CONR_{12}R_{13}$ or $-PO(OR_{12})(OR_{13})$. X represents an oxygen atom, a sulfur atom or an $-N(R_{12})-$ group, Y represents an oxygen atom, a sulfur atom or an $-N(R_{12})-$ group, Z represents an oxygen atom, a sulfur atom, an $-N(R_{12})-$group or a phenylene group, and $R_{12}$ to $R_{14}$ each independently represents a hydrogen atom, an alkyl group, an aryl group, an alkynyl group or an alkyeyl group.

5. The lithographic printing plate precursor as claimed in any one of Claims 1 to 4, wherein the image-forming layer comprises a radical polymerizable compound, a binder, a sensitizing dye and a radical polymerization initiator.

6. The lithographic printing plate precursor as claimed in Claim 5, wherein the sensitizing dye is a compound which absorbs light of from 350 to 1,200 nm.

7. The lithographic printing plate precursor as claimed in Claim 5, wherein the binder has a hydrophilic functional group.

8. The lithographic printing plate precursor as claimed in Claim 7, wherein the hydrophilic functional group is selected from an alkylene oxide group, a carboxylate group, a sulfonic acid group, a sulfonate group, an amino group, an ammonium group, a hydroxy group, a sulfuric acid group, a sulfate group, an amido group and a sulfonamido group.

9. A method for preparing a lithographic printing plate comprising:

   exposing imagewise the lithographic printing plate precursor as claimed in any one of Claims 1 to 8; and developing the exposed lithographic printing plate precursor with an aqueous solution having pH of from 2 to 10 to remove an unexposed area of the image-forming layer.

**10.** The method for preparing a lithographic printing plate as claimed in Claim 9, wherein the exposed lithographic printing plate precursor is subjected to heat treatment between the imagewise exposing and the developing.

**11.** A lithographic printing method comprising:

exposing imagewise the lithographic printing plate precursor as claimed in any one of Claims 1 to 8;
mounting the exposed lithographic printing plate precursor on a printing machine without undergoing any treatment; and
performing printing with printing ink and dampening water.

FIG. 1

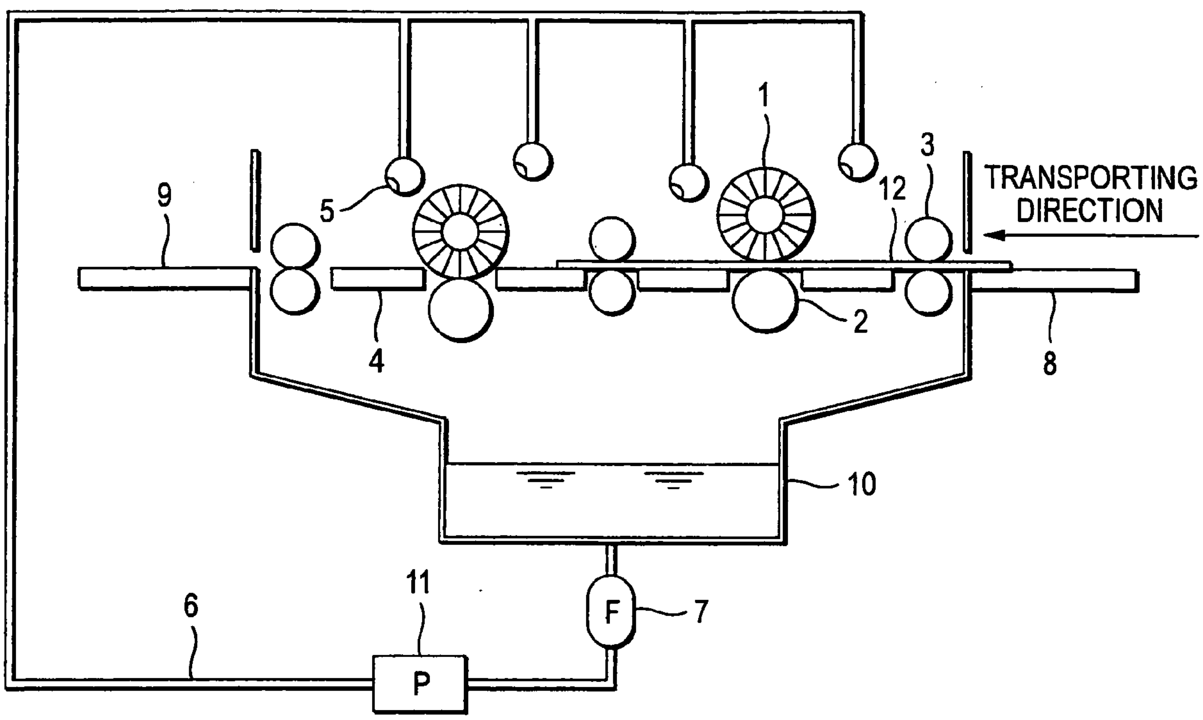

Europäisches Patentamt
European Patent Office
Office européen des brevets

# EUROPEAN SEARCH REPORT

Application Number
EP 09 00 0224

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| P,X | EP 1 892 572 A (FUJIFILM CORP [JP]) 27 February 2008 (2008-02-27) * pages 66-69, printing plate precursor (1) * ----- | 1-9 | INV. G03F7/11 B41C1/10 |
| X | EP 1 767 352 A (FUJIFILM CORP [JP]) 28 March 2007 (2007-03-28) * page 55, paragraph 275 - paragraph 276 * * page 58; example 1; table 1 * ----- | 1-11 | |

TECHNICAL FIELDS SEARCHED (IPC)
G03F
B41C

The present search report has been drawn up for all claims

2

| Place of search | Date of completion of the search | Examiner |
|---|---|---|
| The Hague | 15 April 2009 | Dupart, Jean-Marc |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 09 00 0224

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2009

| Patent document cited in search report | Publication date | Patent family member(s) | Publication date |
|---|---|---|---|
| EP 1892572 A | 27-02-2008 | US 2008070158 A1 | 20-03-2008 |
| EP 1767352 A | 28-03-2007 | US 2007072116 A1 | 29-03-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002365789 A
- US 20040013968 A
- JP 2006078999 A
- JP 2006039468 A
- WO 2005111727 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 58125246 A
- JP 59084356 A
- JP 60078787 A
- JP 58173696 A
- JP 58181690 A
- JP 58194595 A
- JP 58112793 A
- JP 58224793 A
- JP 59048187 A
- JP 59073996 A
- JP 60052940 A
- JP 60063744 A
- JP 58112792 A
- GB 434875 A
- US 5156938 A
- US 3881924 A
- JP 57142645 A
- US 4327169 A
- JP 58181051 A
- JP 58220143 A
- JP 59041363 A
- JP 59084248 A
- JP 59084249 A
- JP 59146063 A
- JP 59146061 A
- JP 59216146 A
- US 4283475 A
- JP 5013514 B
- JP 5019702 B
- US 4756993 A
- JP 2002278057 A
- JP 2001133969 A
- JP 3296759 A
- JP 59028329 B
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B

- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2002328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 9236913 A
- JP 62170950 A
- JP 62226143 A
- JP 60168144 A
- JP 62293247 A
- JP 2002287334 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 B
- GB 930422 A
- US 3111407 A
- GB 952807 A
- GB 967074 A
- JP 54063902 A
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- JP 2001199175 A
- JP 2002079772 A
- JP 5045885 A
- JP 6035174 A
- US 3458311 A
- JP 55049729 B
- US 292501 A
- US 44563 A
- JP 2220061 A
- JP 60059351 A
- US 5148746 A
- US 5568768 A
- GB 2297719 A
- JP 58159533 A
- JP 3100554 A
- JP 62167253 B

**Non-patent literature cited in the description**


- *Nippon Secchaku Kyokaishi,* 1984, vol. 20 (7), 300-308
- Senryo Binran. 1970
- Colour Index (C.I.), Saishin Ganryo Binran. 1977
- Saishin Ganryo Oyou Giiutsu. CMC Publishing Co., Ltd, 1986
- Insatsu Ink Gijutsu. CMC Publishing Co., Ltd, 1984
- Kinzoku Sekken no Seishitsu to Oyo. Saiwai Shobo
- Saishin Ganryo Oyo Gijutsu. CMC Publishing Co., Ltd, 1986
- **L.G. Brooker et al.** *J. Am. Chem. Soc.,* 1951, vol. 73, 5326-5358

- **Wakabayashi et al.** *Bull. Chem. Soc. Japan,* 1969, vol. 42, 2924
- **M. P. Hutt.** *Journal of Heterocyclic Chemistry,* 1970, vol. 1 (3
- **Martin Kunz.** *Rad Tech '98, Proceeding,* 19 April 1998
- *J. C. S. Perkin II,* 1979, 1653-1660
- *J. C. S. Perkin II,* 1979, 156-162
- *Journal of Photopolymer Science and Technology,* 1995, 202-232
- **S. I. Schlesinger.** *Photogr. Sci. Eng.,* 1974, vol. 18, 387
- **T. S. Bal et al.** *Polymer,* 1980, vol. 21, 423
- **J.V. Crivello et al.** *Macromolecules,* 1977, vol. 10 (6), 1307
- **J.V. Crivello et al.** *J. Polymer Sci., Polymer Chem. Ed.,* 1979, vol. 17, 1047
- **C.S. Wen et al.** *Teh, Proc. Conf. Rad. Curing ASIA,* October 1988, 478